# EUROPEAN PATENT APPLICATION

(11) **EP 2 897 166 A1**
(43) Date of publication of application: **22.07.2015**
(21) Application number: 12884473.5
(22) Date of filing: 14.09.2012
(51) Int. Cl.: H01L 25/065, H01L 21/60, H01L 25/07, H01L 25/18

(54) **METHOD FOR MANUFACTURING SEMICONDUCTOR DEVICE**

(71) Applicant: Renesas Electronics Corporation, Nakahara-ku Kawasaki-shi Kanagawa 211-8668 (JP)
(72) Inventor: KONNO, Jumpei, Kawasaki-shi, Kanagawa 211-8668 (JP); NISHITA, Takafumi, Kawasaki-shi, Kanagawa 211-8668 (JP); SAKATA, Kenji, Kawasaki-shi, Kanagawa 211-8668 (JP); KINOSHITA, Nobuhiro, Kawasaki-shi, Kanagawa 211-8668 (JP); SUGIYAMA, Michiaki, Kawasaki-shi, Kanagawa 211-8668 (JP); KIDA, Tsuyoshi, Kawasaki-shi, Kanagawa 211-8668 (JP); ONO, Yoshihiro, Kawasaki-shi, Kanagawa 211-8668 (JP)
(74) Representative: Moore, Graeme Patrick
(86) International application number: PCT/JP2012/073666
(87) International publication number: WO 2014/041684

(57) **Abstract**

In a method of manufacturing a semiconductor device obtained by laminating a first semiconductor chip and a second semiconductor chip with different planar sizes when seen in a plan view on a wiring board via an adhesive material, the second semiconductor chip with a relatively larger planar size is mounted on the first semiconductor chip with a relatively smaller planar size. Also, after the first and second semiconductor chips are mounted, the first and second semiconductor chips are sealed with resin. Here, before sealing with the resin, a gap between the second semiconductor chip and the wiring board is previously sealed with the adhesive material used when the first and second semiconductor chips are mounted.

## Description

### TECHNICAL FIELD

The present invention relates to a semiconductor device and a technique of manufacturing the semiconductor device, and, for example, relates to a technique effectively applied to a semiconductor device obtained by laminating a plurality of semiconductor chips having different planar sizes from each other.

### BACKGROUND ART

Japanese Patent Application Laid-Open Publication No. 2005-191053 (Patent Document 1) describes a method of manufacturing a semiconductor device having semiconductor chips mounted on a package board by a flip-chip connecting method. Patent Document 1 describes the connection of the semiconductor chips with the package board by arranging the semiconductor chips on the package board via NCP (Non-Conductive Paste), and then, pressing back surfaces of the chips.

Also, Japanese Patent Application Laid-Open Publication No. 2010-251408 (Patent Document 2) and Japanese Patent Application Laid-Open Publication No. 2011-187574 (Patent Document 3) describe a semiconductor device in which a through electrode is formed in each of a plurality of laminated semiconductor chips and the plurality of semiconductor chips are electrically connected with each other via the through electrode.

Furthermore, Japanese Patent Application Laid-Open Publication No. 2000-299431 (Patent Document 4) and Japanese Patent Application Laid-Open Publication No. 2002-26236 (Patent Document 5) describe the following contents. When a first semiconductor chip (first semiconductor element) is mounted on a circuit board (substrate) via an anisotropic conductive adhesive material (underfill material), the anisotropic conductive adhesive material is partially protruded outside the first semiconductor chip. Then, on a support part which is the protruded resin and on the first semiconductor chip, a second semiconductor chip (second semiconductor element) is mounted via an adhesive material (die-bonding adhesive material).

### Prior Art Documents

### Patent Documents

Patent Document 1: Japanese Patent Application Laid-Open Publication No. 2005-191053
Patent Document 2: Japanese Patent Application Laid-Open Publication No. 2010-251408
Patent Document 3: Japanese Patent Application Laid-Open Publication No. 2011-187574
Patent Document 4: Japanese Patent Application Laid-Open Publication No. 2000-299431
Patent Document 5: Japanese Patent Application Laid-Open Publication No. 2002-26236

### SUMMARY OF THE INVENTION

### PROBLEMS TO BE SOLVED BY THE INVENTION

The inventors of the present application have studied a technique for improving a performance of a semiconductor device obtained by laminating a plurality of semiconductor chips having different planar sizes (outer dimensions) from each other on a wiring board. As part of this study, in order to improve a transmission speed between the semiconductor chips, the inventors have studied a technique of forming a through electrode in a semiconductor chip arranged on a lower stage side among the plurality of semiconductor chips and of electrically connecting the plurality of semiconductor chips with each other via the through electrode. As a result, the inventors of the present application have found that a problem arises in reliability of the semiconductor device when the planar size of the semiconductor chip on the lower stage side is smaller than a planar size of a semiconductor chip on an upper stage side.

Other preferred aims and novel characteristics will be apparent from the description of the present specification and the accompanying drawings.

### MEANS FOR SOLVING THE PROBLEMS

A method of manufacturing a semiconductor device according to one embodiment includes a process of arranging a first adhesive material on a wiring board, and then, mounting a first semiconductor chip on the wiring board. Also, the method of manufacturing the semiconductor device also includes a process of arranging a second adhesive material on a first back surface of the semiconductor chip and on an exposed surface of the first adhesive material exposed from the first semiconductor chip, and then, mounting a second semiconductor chip on the first back surface of the first semiconductor chip. Furthermore, the method of manufacturing the semiconductor device includes a process of sealing the first semiconductor chip and the second semiconductor chip with resin.

Here, the first semiconductor chip has: a first front surface; a plurality of first front-surface electrodes formed on the first front surface; a first back surface opposite to the first front surface; a plurality of first back-surface electrodes formed on the first back surface; and a plurality of through electrodes each formed so as to penetrate from one of the first front surface and the first back surface toward the other. Also, the second semiconductor chip has a planar size larger than a planar size of the first semiconductor chip. Furthermore, the above-described sealing with the resin is performed in a state in which a space between the second semiconductor chip and the wiring board is closed by the first and second adhesive materials.

### EFFECTS OF THE INVENTION

According to the one embodiment described above, reliability of the semiconductor device can be improved.

### BRIEF DESCRIPTIONS OF THE DRAWINGS

FIG. 1 is a perspective view of a semiconductor device of one embodiment;
FIG. 2 is a lower surface view of the semiconductor device illustrated in FIG. 1;
FIG. 3 is a perspective plan view illustrating an inner structure of the semiconductor device on a wiring board in a state of removal of a sealing body illustrated in FIG. 1;
FIG. 4 is a cross-sectional view taken along a line A-A of FIG. 1;
FIG. 5 is an enlarged cross-sectional view of an A part illustrated in FIG. 4;
FIG. 6 is a plan view illustrating a front surface side of a memory chip illustrated in FIG. 4;
FIG. 7 is a plan view illustrating an example of a back surface side of the memory chip illustrated in FIG. 6;
FIG. 8 is a plan view illustrating a front surface side of a logic chip illustrated in FIG. 4;
FIG. 9 is a plan view illustrating an example of a back surface side of the logic chip illustrated in FIG. 8;
FIG. 10 is an enlarged cross-sectional view of a B part illustrated in FIG. 4;
FIG. 11 is an explanatory diagram illustrating general outlines of a process of manufacturing the semiconductor device described by using FIG. 1 to FIG. 10;
FIG. 12 is a plan view illustrating an entire structure of the wiring board prepared in a board preparing process illustrated in FIG. 11;
FIG. 13 is an enlarged plan view of one device region illustrated in FIG. 12;
FIG. 14 is an enlarged cross-sectional view taken along a line A-A of FIG. 13;
FIG. 15 is an enlarged plan view illustrating a surface opposite to that of FIG. 13;
FIG. 16 is an enlarged plan view illustrating a state in which an adhesive material is arranged in a chip mount region illustrated in FIG. 13;
FIG. 17 is an enlarged cross-sectional view taken along a line A-A of FIG. 16;
FIG. 18 is an explanatory diagram schematically illustrating general outlines of a of manufacturing a semiconductor chip including through electrodes illustrated in FIG. 7;
FIG. 19 is an explanatory diagram schematically illustrating the general outlines of the process of manufacturing the semiconductor chip continued from FIG. 18;
FIG. 20 is an enlarged plan view illustrating a state in which a logic chip LC is mounted on the chip mount region of the wiring board illustrated in FIG. 16;
FIG. 21 is an enlarged cross-sectional view taken along a line A-A of FIG. 20;
FIG. 22 is an explanatory diagram illustrating a detailed flow of a first chip mounting process illustrated in FIG. 11, which schematically illustrates a state in which the semiconductor chip is mounted on the chip mount region;
FIG. 23 is an explanatory diagram illustrating a detailed flow of the first chip mounting process illustrated in FIG. 11, which illustrates a state in which a transportation jig illustrated in FIG. 22 is removed and a heating jig is pressed onto a back surface side of the semiconductor chip;
FIG. 24 is an explanatory diagram illustrating a detailed flow of the first chip mounting process illustrated in FIG. 11, which illustrates a state in which the semiconductor chip is heated and electrically connected with the wiring board;
FIG. 25 is an enlarged plan view illustrating a state in which an adhesive material is arranged on the back surface of the semiconductor chip illustrated in FIG. 20 and a periphery of the back surface;
FIG. 26 is an enlarged cross-sectional view taken along a line A-A of FIG. 25;
FIG. 27 is an explanatory diagram schematically illustrating general outlines of an assembly process of a laminated body of memory chips illustrated in FIG. 4;
FIG. 28 is an explanatory diagram schematically illustrating general outlines of the assembly process of the laminated body of memory chips continued from FIG. 27;
FIG. 29 is an enlarged plan view illustrating a state in which the laminated body of the memory chips is mounted on a back surface of a logic chip illustrated in FIG. 25;
FIG. 30 is an enlarged cross-sectional view taken along a line A-A of FIG. 29;
FIG. 31 is an explanatory diagram illustrating a detailed flow of a second chip mounting process illustrated in FIG. 11, which schematically illustrates a state in which the laminated body of the memory chips is mounted on a logic chip;
FIG. 32 is an explanatory diagram illustrating a detailed flow of the second chip mounting process illustrated in FIG. 11, which illustrates a state in which a transportation jig illustrated in FIG. 31 is removed and a heating jig is pressed onto a back surface side of the laminated body;
FIG. 33 is an explanatory diagram illustrating a detailed flow of the second chip mounting process illustrated in FIG. 11, which illustrates a state in which the laminated body is tilted when a holding jig illustrated in FIG. 31 is removed;
FIG. 34 is an explanatory diagram illustrating a detailed flow of the second chip mounting process illustrated in FIG. 11, which illustrates a state in which the laminated body is heated and electrically connected with the logic chip;
FIG. 35 is an enlarged cross-sectional view illustrating a state in which a sealing body is formed on a wiring board illustrated in FIG. 30 to seal a plurality of laminated semiconductor chips;
FIG. 36 is a plan view illustrating an entire structure of the sealing body illustrated in FIG. 35;
FIG. 37 is a cross-sectional view of a principal part illustrating a state in which a wiring board illustrated in FIG. 30 is arranged in a forming mold for molding the sealing body;
FIG. 38 is a cross-sectional view of a principal part illustrating a state in which resin is supplied into the forming mold illustrated in FIG. 37;
FIG. 39 is a cross-sectional view of a principal part illustrating a state in which the forming mold illustrated in FIG. 37 is filled with the resin;
FIG. 40 is a cross-sectional view of a principal part illustrating a state in which the wiring board illustrated in FIG. 39 is taken out of the forming mold;
FIG. 41 is an enlarged cross-sectional view illustrating a state in which solder balls are bonded to a plurality of lands of the wiring board illustrated in FIG. 35;
FIG. 42 is a cross-sectional view illustrating a state in which a multiple-piece-out wiring board illustrated in FIG. 41 is singulated;
FIG. 43 is a cross-sectional view of a principal part illustrating general outlines of a modification example of the semiconductor device illustrated in FIG. 4;
FIG. 44 is a cross-sectional view of a principal part illustrating general outlines of another modification example of the semiconductor device illustrated in FIG. 4;
FIG. 45 is a cross-sectional view of a principal part illustrating general outlines of a modification example of the semiconductor device illustrated in FIG. 44;
FIG. 46 is an enlarged cross-sectional view of an A part of FIG. 45;
FIG. 47 is a cross-sectional view of a principal part illustrating general outlines of another modification example of the semiconductor device illustrated in FIG. 4;
FIG. 48 is an enlarged cross-sectional view of an A part of FIG. 47;

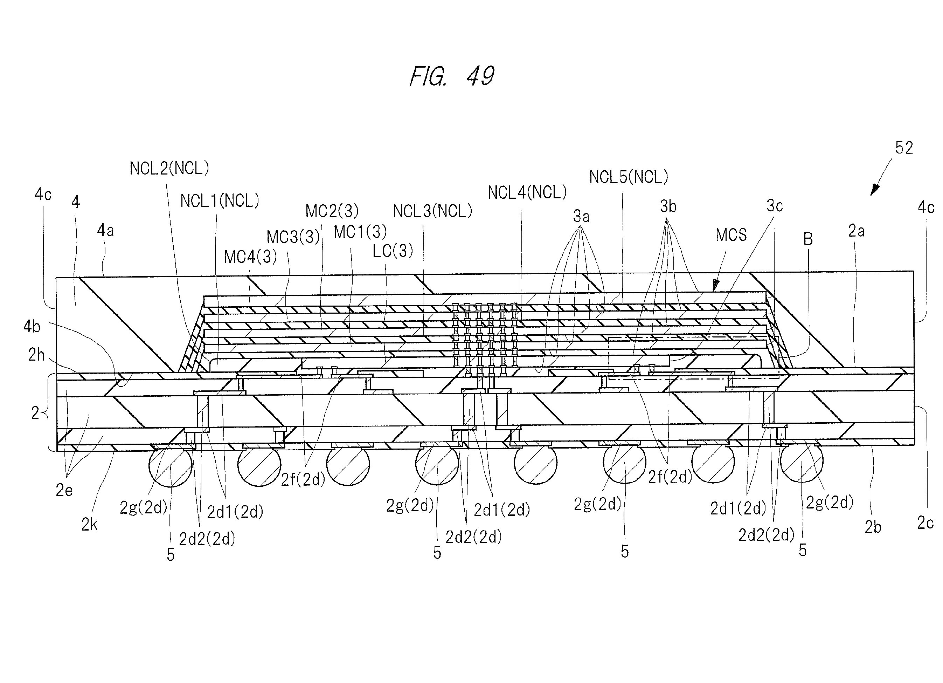

FIG. 49 is a cross-sectional view of a principal part illustrating another modification example of the semiconductor device illustrated in FIG. 4;
FIG. 50 is an explanatory diagram illustrating a state in which the laminated body is tilted in a study example different from those of FIGs. 31 to 34; and
FIG. 51 is a cross-sectional view of a principal part of a study example of FIG. 39.

### DESCRIPTIONS OF THE PREFERRED EMBODIMENTS

### (Explanation of Description Form, Basic Word and Method in Present Application)

In the present application, the invention will be described in a plurality of sections or embodiments when required as a matter of convenience. However, these sections or embodiments are not irrelevant to each other unless otherwise stated, and the one relates to the entire or a part of the other as a modification example, details, or a supplementary explanation thereof, regardless of before and after the description. Also, in principle, the repetitive description of the same part is omitted. Further, each component in the embodiment is not indispensable unless otherwise described to be particularly so, logically limited to the number, and described to be clearly so from the contexts.

Similarly, when "X made of A" or others is described for materials, compositions, and others in the description of the embodiment and others, the one containing other components than A is not eliminated unless otherwise specified to be only the component and clearly to be so from the contexts. For example, the component means "X containing A as a main component" or others. For example, it is needless to say that a "silicon material" and others includes not only pure silicon but also SiGe (silicon germanium) or other multicomponent alloy containing silicon as a main component, or a member containing other additives or others. Also, gold plating, a Cu layer, nickel plating, and others include not only pure material but also members containing gold, Cu, nickel, and others as a main component, respectively unless otherwise specified to be so.

Further, even when a specific numerical value and numerical amount are mentioned, they may be numerical values that excess the specific numerical values or smaller than the specific numerical values unless otherwise specified to be so, logically limited to the number, and clearly described to be so

Still further, in each drawing of the embodiment, the same or similar parts are denoted by the same or similar symbol or reference number, and the description thereof is not repeated.

Also, in the attached drawings, hatching or others is omitted even in a cross-sectional view in a conversely complicated case or a case in which a space is clearly distinguished therefrom. In respect to this, in a case in which it is clear from the description or others, a profile of the background is omitted even in a hole which is closed in a planar view. Further, hatching or a dot pattern is added to the drawings even in the cross-sectional view in order to explicitly illustrate so as not to be the space or explicitly illustrate a boundary between regions.

### (Embodiment)

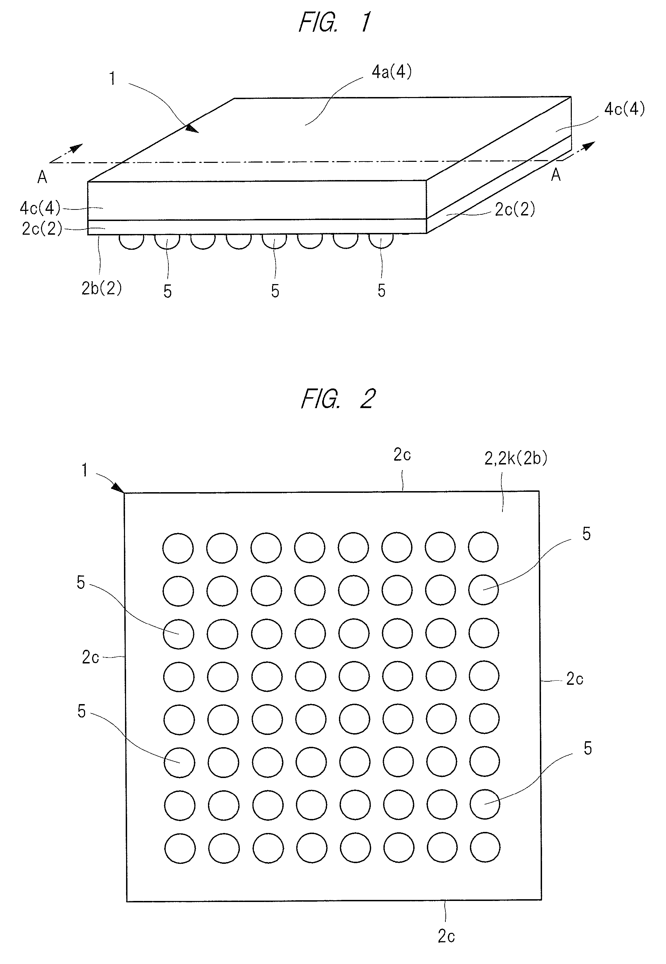

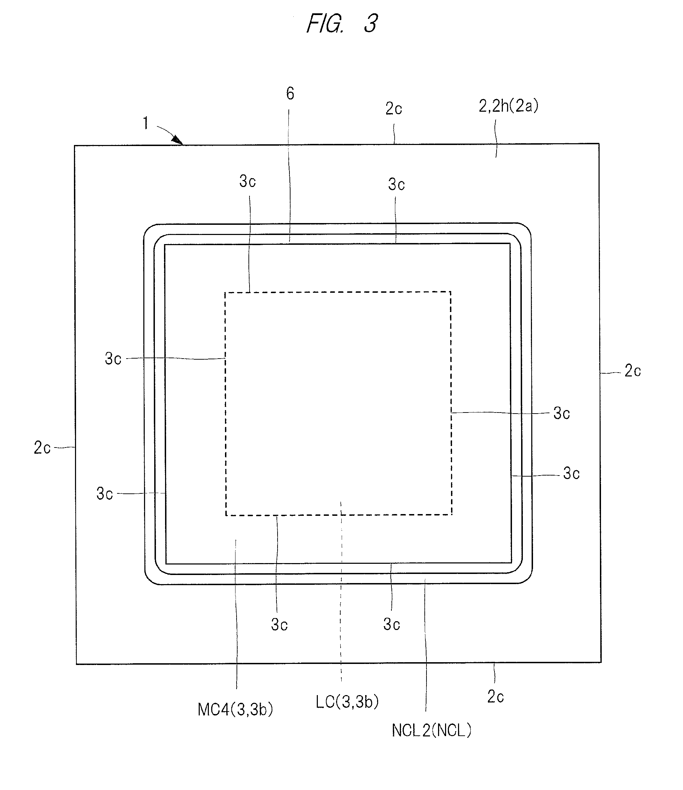

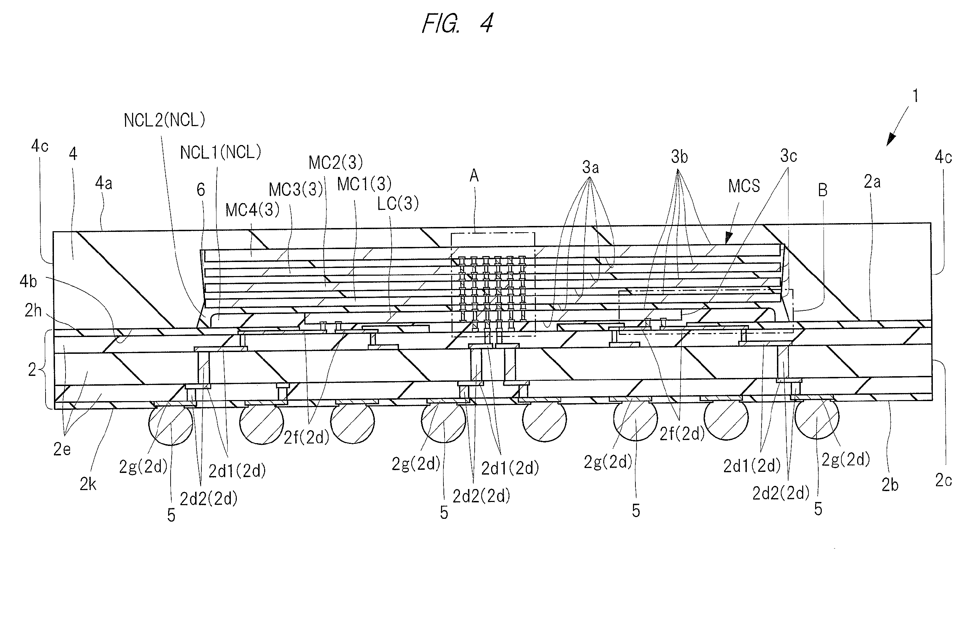

In the present embodiment, as an example of a semiconductor device obtained by laminating a plurality of semiconductor chips thereon, explanation will be made by citing an aspect of lamination of a plurality of semiconductor chips having a memory circuit formed on a semiconductor chip with a computation processing circuit formed thereon. FIG. 1 is a perspective view of a semiconductor device of the present embodiment, and FIG. 2 is a lower surface view of the semiconductor device illustrated in FIG. 1. Also, FIG. 3 is a perspective plan view illustrating an inner structure of the semiconductor device on a wiring board in a state of removal of a sealing body illustrated in FIG. 1. Furthermore, FIG. 4 is a cross-sectional view taken along a line A-A of FIG. 1. Note that the number of terminals is decreased in FIG. 1 to FIG. 4 for ease of viewing. However, the number of terminals (bonding leads 2f, lands 2g, and solder balls 5) is not limited to aspects illustrated in FIG. 1 to FIG. 4. Also in FIG. 3, a profile of a logic chip LC is illustrated with a dotted line for ease of viewing of a positional relation and a difference in a planar size between the logic chip LC and a memory chip MC4 when seen in a plan view.

### <Semiconductor Device>

First, general outlines of the structure of a semiconductor device 1 of the present embodiment are described by using FIG. 1 to FIG. 4. The semiconductor device 1 of the present embodiment includes: a wiring board 2; a plurality of semiconductor chips 3 (see FIG. 4) mounted on the wiring board 2; and a sealing body (resin body) 4 which seals the plurality of semiconductor chips 3.

As illustrated in FIG. 4, the wiring board 2 has: an upper surface (surface, a main surface, or a chip mount surface) 2a having a plurality of semiconductor chips 3 mounted thereon; a lower surface (surface, a main surface, or a mount surface) 2b opposite to the upper surface 2a; and side surfaces 2c arranged between the upper surface 2a and the lower surface 2b, and has a quadrangular outer shape when seen in a plan view as illustrated in FIG. 2 and FIG. 3. In the example illustrated in FIG. 2 and FIG. 3, as a planar size (dimension when seen in a plan view, dimensions of the upper surface 2a and the lower surface 2b, or an outer size) of the wiring board 2, for example, a square having a length of one side of about 14 mm is formed. Also, a thickness (height) of the wiring board 2, that is, a distance from the upper surface 2a to the lower surface 2b illustrated in FIG. 4 is, for example, about 0.3 mm to 0.5 mm.

The wiring board 2 is an interposer for electrically connecting the semiconductor chip 3 mounted on an upper surface 2a side with a mount board not illustrated, and has a plurality of wiring layers (four layers in the example illustrated in FIG. 4) which electrically connect the upper surface 2a side with the lower surface 2b side. In each wiring layer, a plurality of wires 2d and insulating layers (core layers) 2e which insulate between the plurality of wires 2d and between adjacent wiring layers are formed. Also, the wire 2d includes a wire 2d1 formed on an upper surface or lower surface of the insulating layer 2e and a via wire 2d2 which is an interlayer conductive path formed so as to penetrate through the insulating layer 2e in a thickness direction.

Also, on the upper surface 2a of the wiring board 2, a plurality of bonding leads (terminals, chip-mount-surface terminals, or electrodes) 2f which are terminals electrically connected with the semiconductor chips 3 are formed. On the other hand, a plurality of lands 2g are formed on the lower surface 2b of the wiring board 2, the lands 2g being terminals for electrical connection with the mount board not illustrated, that is, external connection terminals of the semiconductor device 1 to which a plurality of solder bolls 5 are bonded. The plurality of bonding leads 2f and the plurality of lands 2g are electrically connected with each other via the plurality of wires 2d, respectively. Note that the wire 2d connected with the bonding lead 2f and the land 2g is integrally formed with the bonding lead 2f and the land 2g, and therefore, the bonding lead 2f and the land 2g are illustrated as a part of the wire 2d in FIG. 4.

Also, the upper surface 2a and the lower surface 2b of the wiring board 2 are covered with insulating films (solder resist films) 2h and 2k. The wire 2d formed on the upper surface 2a of the wiring board 2 is covered with the insulating film 2h. Openings are formed in the insulating film 2h, and at least a part of the plurality of bonding leads 2f (a bonding portion to the semiconductor chips 3, a bonding region) is exposed from the insulating film 2h in these openings. Also, the wires 2d formed on the lower surface 2b of the wiring board 2 are covered with the insulating film 2k. Openings are formed in the insulating film 2k, and at least a part of the plurality of lands 2g (a bonding portion to the solder balls 5) is exposed from the insulating film 2k in these openings.

Furthermore, as illustrated in FIG. 4, the plurality of solder balls (external terminals, electrodes, or outer electrodes) 5 bonded to the plurality of lands 2g on the lower surface 2b of the wiring board 2 are arranged in a matrix form (an array form or a matrix form) as illustrated in FIG. 2. Also, although not illustrated in FIG. 2, the plurality of lands 2g (see Fig. 4) to which the plurality of solder balls 5 are bonded are arranged also in a matrix form (matrix form). As described above, a semiconductor device having a plurality of external terminals (the solder balls 5 and the lands 2g) arranged in a matrix form on a mount surface side of the wiring board 2 is referred to as an area-array-type semiconductor device. In the area-array-type semiconductor device, the mount surface (lower surface 2b) side of the wiring board 2 can be effectively utilized as an arrangement space for external terminals, and therefore, the area-array-type semiconductor device is preferable in that increase in a mount area of the semiconductor device can be suppressed even in increase in the number of external terminals. That is, the semiconductor device having the number of external terminals increased with enhancement in functionality and integration can be mounted so as to conserve a space.

Still further, the semiconductor device 1 includes the plurality of semiconductor chips 3 mounted on the wiring board 2. The plurality of semiconductor chips 3 are laminated on the upper surface 2a of the wiring board 2. Still further, each of the plurality of the semiconductor chips 3 has: a front surface (a main surface or an upper surface) 3a; a back surface (a main surface or a lower surface) 3b opposite to the front surface 3a; and side surfaces 3c positioned between the front surface 3a and the back surface 3b, and has a quadrangular outer shape when seen in a plan view as illustrated in FIG. 3. In this manner, by laminating the plurality of semiconductor chips, the mount area can be reduced even if the functionality of the semiconductor device 1 is enhanced.

In the example illustrated in FIG. 3 and FIG. 4, the semiconductor chip 3 mounted on the lowermost stage (a position closest to the wiring board 2) is a logic chip (a semiconductor chip) LC where a computation processing circuit is formed. On the other hand, the semiconductor chips 3 mounted on upper stages of the logic chip are memory chips (semiconductor chips) MC1, MC2, MC3, and MC4 each having a main storage circuit (memory circuit) which stores data communicated with the logic chip LC formed thereon. Note that the logic chip LC has not only the computation processing circuit described above but also a control circuit formed thereon, which controls the operation of the main storage circuits of the memory chips MC1, MC2, MC3, and MC4. Also, in the logic chip LC, a storage circuit such as a cache memory with a capacity smaller than that of the above-described main storage circuit is formed. Furthermore, in the logic chip LC, an external interface circuit which performs input/output of signals from/to an external device not illustrated is formed. Still further, in the logic chip LC, an internal interface circuit which performs input/outputs of signals from/to an internal device (for example, the memory chips MC1, MC2, MC3, and MC4) is formed.

As the logic chip LC, a system having circuits required for operations of a device or system collectively formed in one semiconductor chip 3 is referred to as a SoC (System on a Chip). Also, as the semiconductor device 1, a system having circuits required for operations of a device or system collectively formed in one semiconductor device 1 is referred to as a SIP (System In Package).

Here, the required capacity of the main storage circuit is changed depending on the device and system to be operated. Therefore, in the example illustrated in FIG. 4, the memory chips MC1, MC2, MC3, and MC4 each including the main storage circuit are mounted separately from the logic chip LC as a SoC, and the logic chip LC and the memory chips MC1, MC2, MC3, and MC4 are electrically connected with each other. In this manner, versatility of the logic chip LC and the memory chips MC1, MC2, MC3, and MC4 can be improved. Note that FIG. 4 illustrates the example of the lamination of the four memory chips MC1, MC2, MC3, and MC4 on one logic chip LC. However, there are various modification examples regarding the number of lamination of the semiconductor chips 3. Although not illustrated, the invention can be applied to, for example, mounting of one memory chip MC1 on one logic chip LC as a minimum structure. Also, a method of electrically connecting the logic chip LC with the memory chips MC1, MC2, MC3, and MC4 will be described in detail further below.

As described above, in view of improving the versatility of the logic chip LC and the memory chips MC1, MC2, MC3, and MC4, each of the logic chip LC and the memory chips MC1, MC2, MC3, and MC4 preferably has a planar size (dimension when seen in a plan view, dimensions of the front surface 3a and the back surface 3b, or an outer size) minimized within a range in which the function of each semiconductor chip 3 can be achieved. The planar size of the logic chip LC can be reduced by improving the degree of integration of circuit elements. On the other hand, since the capacity of the main storage circuit and a transmission speed (for example, a data transfer amount depending on a width of a data bus) is changed depending on the planar size, miniaturization of the planar size has a limitation.

Therefore, in the example illustrated in FIG. 4, the planar size of the memory chip MC4 is larger than the planar size of the logic chip LC. For example, while the memory chip MC4 has a planar size of a quadrangle having a one-side length of about 8 mm to 10 mm, the logic chip LC has a planar size of a quadrangle having one-side length of about 5 mm to 6. Also, although not illustrated, each of the memory chips MC1, MC2, and MC3 illustrated in FIG. 4 has a planar size equal to the planar size of the memory chip MC4.

Also, as described above, since the external interface circuit which performs the input/output of signals from/to the external device not illustrated is formed in the logic chip LC, the logic chip LC is preferably mounted on the lowermost stage, that is, at a position closest to the wiring board 2 as the order of lamination of the plurality of semiconductor chips 3 in view of reducing the transmission distance with the external device. That is, as in the semiconductor device 1, the semiconductor chips 3 (memory chips MC1, MC2, MC3, and MC4) each having the large planar size are laminated on the semiconductor chip 3(the logic chip LC) having the small planar size. Therefore, as illustrated in FIG. 4, a gap occurs between the semiconductor chip 3 on the upper stage side (the memory chip MC1) and the upper surface 2a of the wiring board 2 in a region outside an outer edge part of the semiconductor chip 3 on the lowermost stage (the logic chip LC).

In the present embodiment, an adhesive material (insulating adhesive material) NCL is arranged between the semiconductor chip 3 on the upper stage side (the memory chip MC1) and the upper surface 2a of the wiring board 2 so as to fill this gap. In other words, the gap between the semiconductor chip 3 on the upper stage side (the memory chip MC1) and the upper surface 2a of the wiring board 2 is closed by the adhesive material NCL. This adhesive material NCL includes an adhesive material (insulating adhesive material) NCL1 for bonding and fixing the logic chip LC on the wiring board 2 and an adhesive material (insulating adhesive material) NCL2 for bonding and fixing the memory chip MC1 on the logic chip LC.

In the present embodiment, as illustrated in FIG. 4, an outer edge part of the adhesive material NCL1, in particular, a side surface (a surface lined with a side surface of the logic chip LC), is covered with the adhesive material NCL2. And, as illustrated in FIG. 4, a fillet is formed in the adhesive material NCL2 so as to cover the side surface of the memory chip (at least the memory chip MC1). Furthermore, a part of the fillet of this adhesive material NCL2 is formed outside of the outer edge part (side surface) of the memory chip (in a direction away from the logic chip LC). Also, each of the adhesive materials NCL1 and NCL2 is made of an insulating (non-conductive) material (for example, resin material). Therefore, bonding parts adjacent to each other (bonding parts of the logic chip LC and the wiring board 2 or bonding parts of the logic chip LC and the memory chip MC1) can be electrically insulated from each other. A detailed method and effect of closing the gap between the memory chip MC1 and the upper surface 2a of the wiring board 2 by the adhesive material NCL will be described in detail when a method of manufacturing the semiconductor device is described further below.

Also, in the example illustrated in FIG. 4, a sealing body (a sealing body for a chip laminated body or a resin body for the chip laminated body) 6 different from the sealing body 4 is arranged between the plurality of memory chips MC1, MC2, MC3, and MC4, and a laminated body MCS formed of the memory chips MC1, MC2, MC3, and MC4 is sealed with the sealing body 6. The sealing body 6 is buried so as to be brought in close contact with the front surface 3a and the back surface 3b of each of the plurality of memory chips MC1, MC2, MC3, and MC4, and the laminated body MCS formed of the memory chips MC1, MC2, MC3, and MC4 is integrated by the bonding part and the sealing body 6 between the semiconductor chips 3. Also, the sealing body 6 is made of an insulating (non-conductive) material (for example, resin material). By arranging the sealing body 6 at each bonding part of the memory chips MC1, MC2, MC3, and MC4, the plurality of electrodes provided to the respective bonding parts can be electrically insulated from each other. However, as illustrated in FIG. 4, the front surface 4a of the memory chip MC1 mounted on the lowermost stage (a position closest to the logic chip LC) of the laminated body MCS formed of the memory chips MC1, MC2, MC3, and MC4 is exposed from the sealing body 6. Also, as illustrated in FIG. 3 and FIG. 4, the back surface 4b of the memory chip MC4 arranged on the uppermost stage of the laminated body MCS formed of the memory chips MC1, MC2, MC3, and MC4 is exposed from the sealing body 6.

Furthermore, the semiconductor device 1 includes the sealing body 4 which seals the plurality of semiconductor chips 3. The sealing body 4 has: an upper surface (a surface or a front surface) 4a; a lower surface (a surface or a back surface) 4b (see FIG. 4) positioned to be opposite to the upper surface 4a; and side surfaces 4c positioned between the upper surface 4a and the lower surface 4b, and has a quadrangular outer shape when seen in a plan view. In the example illustrated in FIG. 1, the planar size of the sealing body 4 (dimension when seen in a plan view from the upper surface 4a side or an outer size of the upper surface 4a) is equal to the planar size of the wiring board 2, and each side surface 4c of the sealing body 4 is continuous to the side surface 2c of the wiring board 2. Also in the example illustrated in FIG. 1, the planar dimension (dimension when seen in a planar view) of the sealing body 4 is formed into, for example, a square having a length of one side of about 14.

The sealing body 4 is a resin body for protecting the plurality of semiconductor chips 3. By forming the sealing body 4 so as to be brought in close contact with a portion between the plurality of semiconductor chips 3 and with the semiconductor chip 3 and the wiring board 2, damage to a thin semiconductor chip 3 can be suppressed. Also, the sealing body 4 is made of, for example, the following material in view of improving a function as a protective member. For the sealing body 4, easiness of close contact with the semiconductor chips 3 and the wiring board 2 and a certain degree of hardness after the sealing are required, and therefore, it is preferred to contain, for example, a thermosetting resin such as an epoxy-based resin. Furthermore, in order to improve the function of the sealing body 4 after curing, filler particles such as silica (silicon dioxide; SiO₂) particles are preferably mixed in the resin material. For example, in view of suppressing the damage to the semiconductor chip 3 due to heat deformation after formation of the sealing body 4, it is preferable to adjust a mixture ratio of the filler particles to bring linear expansion coefficients of the semiconductor chip 3 and the sealing body 4 to be close to each other.

### <Details on Semiconductor Chip>

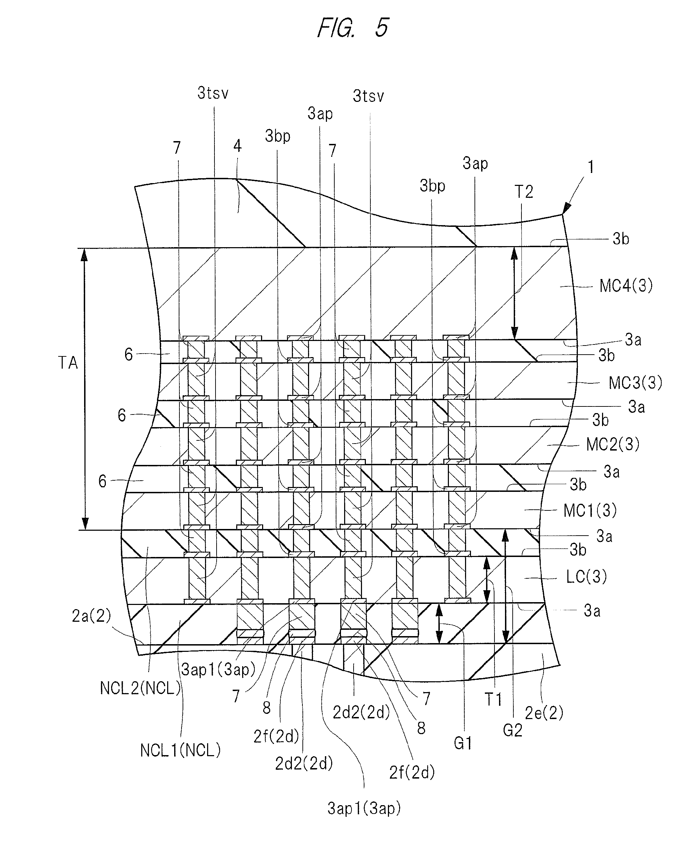

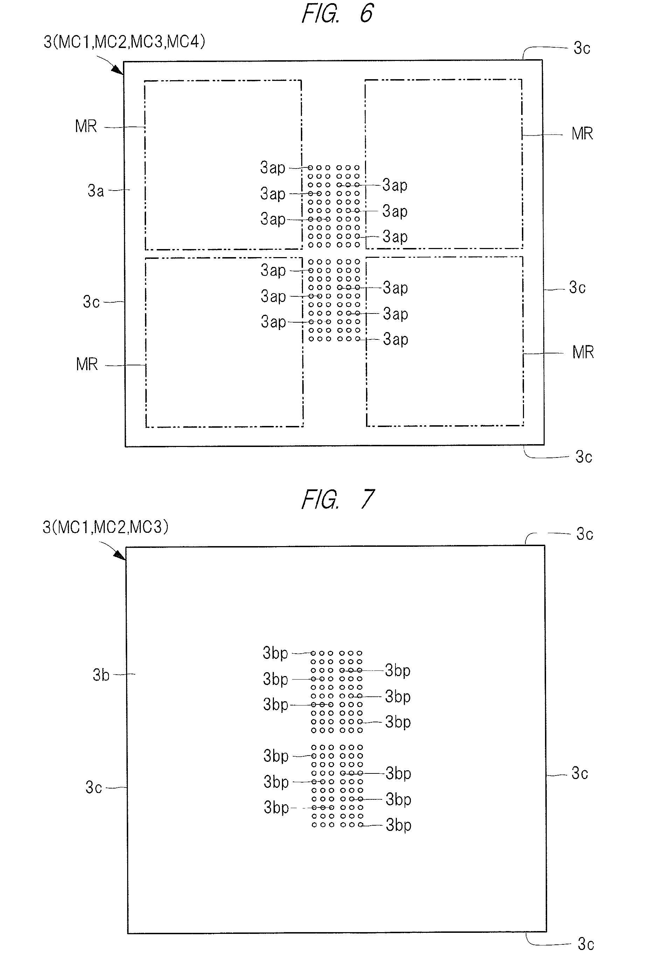

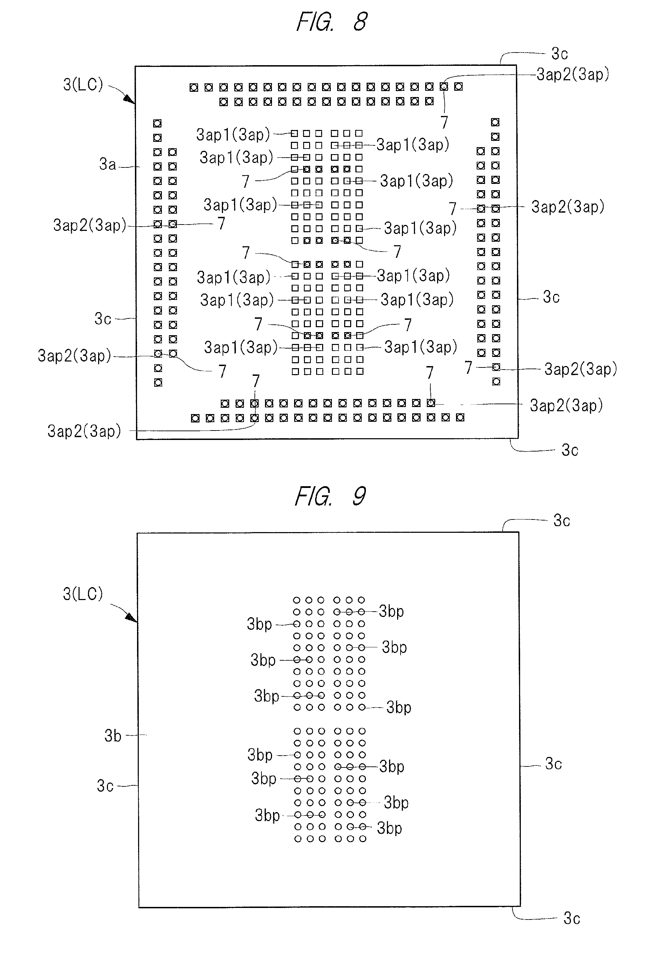

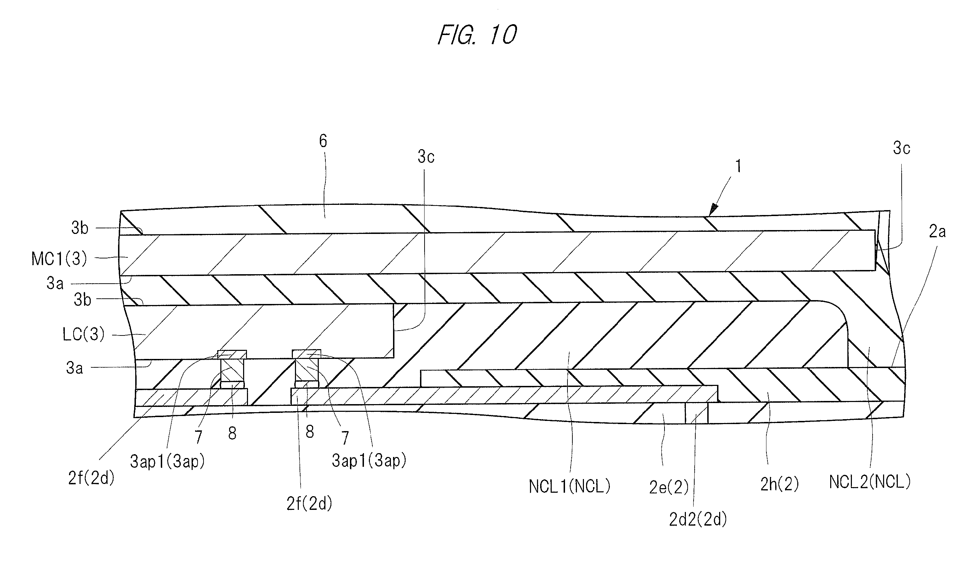

Next, details on the logic chip LC and the memory chips MC1, MC2, MC3, and MC4 illustrated in FIG. 3 and FIG. 4 and a method of electrically connecting the respective semiconductor chips 3 are described. FIG. 5 is an enlarged cross-sectional view of an A part illustrated in FIG. 4. Also, FIG. 6 is a plan view illustrating a front surface side of the memory chip illustrated in FIG. 4, and FIG. 7 is a plan view illustrating 563a back surface side of the memory chip illustrated in FIG. 6. Also, FIG. 8 is a plan view illustrating a front surface side of the logic chip illustrated in FIG. 4, and FIG. 9 is a plan view illustrating an example of a back surface side of the logic chip illustrated in FIG. 6. Furthermore, FIG. 10 is an enlarged cross-sectional view of a B part of FIG. 4. Note that the number of electrodes is decreased for ease of viewing in FIG. 5 to FIG. 9. However, the number of electrodes (front-surface electrode 3ap, back-surface electrode 3bp, and through electrode 3tsv) is not limited to the aspects illustrated in FIG. 5 to FIG. 9. Still further, while FIG. 7 illustrates the back-surface views of the memory chips MC1, MC2, and MC3, FIG. 3 illustrates the structure of the back surface of the memory chip MC4 (see FIG. 4) where the back surface electrode 3bp is not formed, and therefore, is not illustrated herein.

The inventors of the present application have studied a technique for improving a performance of an SIP-type semiconductor device. As a part of this study, a technique of improving the signal transmission speed between the plurality of semiconductor chips mounted on the SIP to be, for example, 12 Gbps (12 gigabits per second) or higher has been studied. As a method of improving the transmission speed between the plurality of semiconductor chips mounted on the SIP, there is a method of increasing the transmitted data amount per one transmission by increasing the width of the data bus of the internal interface (hereinafter described as bus width expansion). Also, as another method, there is a method of increasing the number of times of transmission per unit time (hereinafter described as clock increase). Furthermore, there is a method of combining the above-described bus width expansion method and clock count increase method. The semiconductor device 1 described by using FIG. 1 to FIG. 4 is a semiconductor device having the transmission speed of the internal interface improved to 12 Gbps or higher by applying the combination of the bus width expansion and the clock increase.

For example, each of the memory chips MC1, MC2, MC3, and MC4 illustrated in FIG. 4 is a so-called wide I/O memory having a data bus width of 512 bits. More specifically, each of the memory chips MC1, MC2, MC3, and MC4 has four channels each having a data bus width of 128 bits, and the bus widths of these four channels are totally 512 bits. Also, in the number of times of transmission per unit time of each channel, the increase in clock is achieved, and each of the number is, for example, 3 Gbps or higher.

In this manner, in the application of the combination of the clock increase and bus width expansion, many data lines are required to be operated at a high speed, and therefore, it is required to reduce the data transmission distance in view of reducing the influence of noise. Thus, as illustrated in FIG. 4, the logic chip LC and the memory chip MC1 are electrically connected with each other via a conductive member arranged between the logic chip LC and the memory chip MC1. Also, the plurality of memory chips MC1, MC2, MC3, and MC4 are electrically connected with each other via a conductive member arranged between the plurality of memory chips MC1, MC2, MC3, and MC4. In other words, in the semiconductor device 1, a transmission path between the logic chip LC and the memory chip MC1 does not include the wiring board 2 and a wire (bonding wire) not illustrated. Also, in the semiconductor device 1, a transmission path between the plurality of memory chips MC1, MC2, MC3, and MC4 does not include the wiring board 2 and a wire (bonding wire) not illustrated.

In the present embodiment, a technique is applied as a method of directly connecting the plurality of semiconductor chips 3 with each other, the technique connecting the laminated semiconductor chips 3 with each other via through electrodes formed so as to penetrate through the semiconductor chips 3 in a thickness direction. More specifically, the logic chip LC has a plurality of front-surface electrodes (electrodes or pads) 3ap formed on the front surface 3a and a plurality of back-surface electrodes (electrodes or pads) 3bp formed on the back surface 3b. Also, the logic chip LC has a plurality of through electrodes 3tsv formed so as to penetrate from one of the front surface 3a and the back surface 3b toward the other and so as to electrically connect the plurality of front-surface electrodes 3ap with the plurality of back-surface electrodes 3bp.

Each circuit included in the semiconductor chip 3 is formed on the front surface 3a side of the semiconductor chip 3. More specifically, the semiconductor chip 3 includes a semiconductor board (omitted in the drawings) made of, for example, silicon (Si), and a plurality of semiconductor elements (illustration is omitted) such as transistors are formed on a main surface (element formation surface) of the semiconductor board. On the main surface (the front surface 3a side) of the semiconductor board, wiring layers including a plurality of wires and insulating films each of which insulates between the plurality of wires (illustration is omitted) are laminated. The plurality of wires of the wiring layers are electrically connected with the plurality of semiconductor elements to configure a circuit, respectively. The plurality of front-surface electrodes 3ap formed on the front surface 3a (see FIG. 3) of the semiconductor chip 3 are electrically connected with the semiconductor elements via the wiring layers provided between the semiconductor board and the front surface 3a to configure a part of the circuit.

Therefore, as illustrated in FIG. 5, by forming the through electrodes 3tsv penetrating through the semiconductor chips 3 in the thickness direction so as to electrically connect the front-surface electrodes 3ap with the back-surface electrodes 3bp via the through electrodes 3tsv, the back-surface electrode 3bp and the circuit of the semiconductor chip 3 formed on the front surface 3 side can be electrically connected with each other. That is, as illustrated in FIG. 5, if the front-surface electrodes 3ap of the memory chip MC1 and the back-surface electrode 3bp of the logic chip LC are electrically connected with each other via a conductive member such as protruding electrodes (conductive members or protruding electrodes) 7, the circuit of the memory chip MC1 and the circuit of the logic chip LC are electrically connected with each other via the through electrodes 3tsv.

In the present embodiment, the logic chip LC mounted between the memory chip MC1 and the wiring board 2 has the plurality of through electrodes 3tsv. Therefore, by electrically connecting the memory chip MC1 with the logic hip LC via the through electrodes 3tsv, the wiring board 2 and the wire (bonding wire) not illustrated can be excluded from the transmission path between the logic chip LC and the memory chip MC1. As a result, an impedance component in the transmission path between the logic chip LC and the memory chip MC1 can be reduced, and the influence of the noise due to the clock increase can be reduced. In other words, transmission reliability can be improved even when the signal transmission speed between the logic chip LC and the memory chip MC1 is improved.

Also, in the example illustrated in FIG. 5, since the plurality of memory chips MC1, MC2, MC3, and MC4 are laminated on the logic chip LC, the signal transmission speed can be preferably improved also among the plurality of these memory chips MC1, MC2, MC3, and MC4. Thus, the semiconductor chip 3 is arranged above and below each of the plurality of memory chips MC1, MC2, MC3, and MC4. As similar to the logic chip LC, the memory chips MC1, MC2, and MC3 have a plurality of through electrodes 3tsv. More specifically, each of the memory chips MC1, MC2, and MC3 has the plurality of front-surface electrodes (electrodes or pads) 3ap formed on the front surface 3a and the plurality of back-surface electrodes (electrodes or pads) 3bp formed on the back surface 3b. Also, each of the memory chips MC1, MC2, and MC3 also has the plurality of through electrodes 3tsv formed so as to penetrate from one of the front surface 3a and the back surface 3b toward the other and so as to electrically connect the plurality of front-surface electrodes 3ap with the plurality of back-surface electrodes 3bp.

Therefore, as similar to the case of the logic chip LC described above, if the front-surface electrodes 3ap of the semiconductor chip 3 on an upper stage side and the back-surface electrodes 3bp of the semiconductor chip 3 on a lower stage side of the memory chips MC1, MC2, MC3, and MC4 are electrically connected with each other via a conductive member such as protruding electrodes (conductive members or protruding electrodes) 7, the circuits of the plurality of laminated semiconductor chips 3 can be electrically connected with each other via the through electrodes 3tsv.

Therefore, the wiring board 2 and the wire (bonding wire) not illustrated can be excluded from the transmission path among the memory chips MC1, MC2, MC3, and MC4. As a result, an impedance component in the transmission paths among the plurality of laminated memory chips MC1, MC2, MC3, and MC4 can be reduced, and the influence of the noise due to the clock increase can be reduced. In other words, transmission reliability can be improved even when the signal transmission speed among the plurality of memory chips MC1, MC2, MC3, and MC4 is improved.

In the example illustrated in FIG. 5, note that the plurality of front-surface electrodes 3ap are formed but the plurality of back-surface electrodes 3bp and the plurality of through electrodes 3tsv are not formed since it is only required to connect the memory chip MC4 mounted on the uppermost stage with the memory chip MC3. In this manner, by adopting the structure without the plurality of back-surface electrodes 3bp and the plurality of through electrodes 3tsv for the memory chip MC4 mounted on the uppermost stage, the process of manufacturing the memory chip MC4 can be simplified. However, although not illustrated, for the memory chip MC4, the structure with the plurality of back-surface electrodes 3bp and the plurality of through electrodes 3tsv as similar to the memory chips MC1, MC2, and MC3 can be also adopted as a modification example. In this case, by forming the plurality of laminated memory chips MC1, MC2, MC3, and MC4 so as to have the same structure as each other, manufacturing efficiency can be improved.

Also, for the protruding electrode 7 which is arranged between the laminated semiconductor chips 3 and which electrically connects the front-surface electrode 3ap of the semiconductor chip 3 on the upper stage side with the back-surface electrode 3bp of the semiconductor chip 3 on the lower stage side, for example, the following material is used in the example illustrated in FIG. 5. That is, the protruding electrode 7 is a metal member obtained by laminating a nickel (Ni) film and a solder (for example, SnAg) film at a tip containing a pillar-shaped (for example, a columnar-shaped) copper (Cu) as a main component, and is electrically connected by bonding the solder film at the tip to the back-surface electrode 3bp. However, to the material configuring the protruding electrode 7, various modification examples can be applied within a range satisfying requirements in the electrical characteristics or requirements in the bonding strength. For example, a solder member can be bonded to the exposed surface of the front-surface electrode 3ap, and this solder member can be used as the protruding electrode 7.

Furthermore, as similar to the logic chip LC and the memory chips MC1, MC2, and MC3 illustrated in FIG. 5, the semiconductor chip 3 including the through electrodes 3tsv preferably has a thin (small) thickness, that is, a thin (small) separated distance between the front surface 3a and the back surface 3b. If the thickness of the semiconductor chip 3 is made thinner, the transmission distance of the through electrode 3tsv is reduced, and therefore, this is preferable in view of reducing the impedance component. Still further, when an opening (including a through hole and a not-penetrating hole) is formed in a thickness direction of the semiconductor board, processing accuracy is smaller as a depth of the hole is deeper. In other words, if the thickness of the semiconductor chip 3 is made thinner, the processing accuracy of the opening for forming the through electrodes 3tsv can be improved. Therefore, diameters (a length or width in a direction orthogonal to the thickness direction of the semiconductor chip 3) of the plurality of through electrodes 3tsv can be made uniform, and thus, the impedance components of the plurality of transmission paths can be easily controlled.

In the example illustrated in FIG. 5, a thickness T1 of the logic chip LC is thinner than a thickness TA of the laminated body MCS (see FIG. 4) formed of the plurality of memory chips MC1, MC2, MC3, and MC4 arranged on the logic chip LC. Also, the thickness T1 of the logic chip LC is thinner than a thickness T2 of the memory chip MC4 mounted on the uppermost stage and not having the through electrodes 3tsv formed among the plurality of memory chips MC1, MC2, MC3, and MC4. For example, the thickness T1 of the logic chip LC is 50 µm. On the other hand, the thickness of the memory chip MC4 is about 80 µm to 100 µm. Also, the thickness TA of the laminated body MCS (see FIG. 4) formed of the plurality of memory chips MC1, MC2, MC3, and MC4 is about 260 µm.

As described above, when the semiconductor chip 3 is made thinner, there is concern about damage to the semiconductor chip 3 in the exposure state of the semiconductor chip 3. According to the present embodiment, as illustrated in FIG. 4, the sealing body 4 is brought in close contact with the plurality of semiconductor chips 3 for sealing. Therefore, the sealing body 4 can be functioned as a protective member such that the damage to the semiconductor chips 3 can be suppressed. That is, according to the present embodiment, by sealing the plurality of semiconductor chips 3 with resin, the reliability (durability) of the semiconductor device 1 can be improved.

Also, in the case of the semiconductor device 1 having the semiconductor chips 3 including the through electrodes 3tsv laminated thereon, it is preferable to narrow a gap between the semiconductor chips 3 and the board 2 in view of reduction in the transmission distance. For example, in the example illustrated in FIG. 5, a gap G1 between the front surface 3a of the logic chip LC and the upper surface 2a of the wiring board 2 is, for example, about 10 µm to 20 µm. Furthermore, a gap G2 between the front surface 3a of the memory chip MC1 and the upper surface 2a of the wiring board 2 is, for example, about 70 µm to 100 µm. In this manner, in the semiconductor device 1 having the semiconductor chips 3 including the through electrodes 3tsv laminated thereon, it is preferable to reduce the transmission distance by decreasing the thicknesses and the separated distances of the semiconductor chips 3.

Still further, in the present embodiment, in a layout of the front-surface electrodes 3ap and the back-surface electrodes 3bp when seen in a plan view, the structure allowing the reduction in the transmission distance between the memory chips MC1, MC2, MC3, and MC4 and the logic chip LC is applied.

As illustrated in FIG. 6, the plurality of front-surface electrodes 3ap included in the memory chips MC1, MC2, MC3, and MC4 are collectively arranged at a center part on the front surface 3a. As illustrated in FIG. 7, the plurality of front-surface electrodes 3ap included in the memory chips MC1, MC2, and MC3 are collectively arranged at a center part on the front surface 3a. As illustrated in FIG. 5, the plurality of front-surface electrodes 3ap of the memory chips MC1, MC2, MC3, and MC4 and the plurality of back-surface electrodes 3bp of the memory chips MC1, MC2, and MC3 are arranged at positions where they are overlapped with each other in the thickness direction.

Also, as illustrated in FIG. 8, some (a plurality of front-surface electrodes 3ap1) of the plurality of front-surface electrodes 3ap included in the logic chip LC are collectively arranged at a center part of the front surface 3a. Furthermore, some (a plurality of front-surface electrodes 3ap2) of the plurality of front-surface electrodes 3ap included in the logic chip LC are arranged at an outer edge part of the front surface 3a along a side (side surface 3c) of the front surface 3a. The plurality of front-surface electrodes 3ap1 arranged at the center part of the front surface 3a among the plurality of front-surface electrodes 3ap illustrated in FIG. 8 are electrically connected with the back-surface electrodes 3bp via the through electrodes 3tcv illustrated in FIG. 5. That is, the plurality of front-surface electrodes 3ap1 are internal-interface electrodes. On the other hand, the plurality of front-surface electrodes 3ap2 arranged at the outer edge part of the front surface 3a among the plurality of front-surface electrodes 3ap illustrated in FIG. 8 are electrically connected with an external device not illustrated via the wiring board 2 illustrated in FIG. 4. More specifically, as illustrated in FIG. 10, the front-surface electrodes 3ap2 are electrically bonded to the bonding leads 2f via the protruding electrodes 7 and the bonding material 8 such as the solder. That is, the plurality of front-surface electrodes 3ap2 are external-interface electrodes.

In view of the reduction in the transmission distance between the plurality of semiconductor chips 3, a method of arranging the internal-interface front-surface electrodes 3ap and the back-surface electrodes 3bp at positions at which they are overlapped with each other in the thickness direction as illustrated in FIG. 5 for the connection via the protruding electrodes 7 is particularly preferable.

Furthermore, as described above, the planar size of the logic chip LC is smaller than the planar sizes of the memory chips MC1, MC2, MC3, and MC4. Still further, in the semiconductor device 1 as illustrated in FIG. 3, a center part (center region) of the back surface 3b of the logic chip LC is arranged so as to be overlapped with a center part (center region) of the memory chip MC4 when seen in a plan view. That is, when seen in a plan view, four side surfaces 3c of the memory chip MC4 are arranged outside of four side surfaces 3c of the logic chip LC. In other words, the plurality of semiconductor chip 3 are mounted and laminated on the wiring board 2 such that the four side surfaces 3c of the memory chip MC4 are positioned between the four side surfaces 3c of the logic chip LC and the four side surfaces 2c of the wiring board 2. Also, the memory chips MC1, MC2, and MC3 illustrated in FIG. 4 are arranged at positions overlapping the memory chip MC4 (the same position) when seen in a plan view.

Therefore, when seen in a plan view, the outer edge parts of the memory chips MC1, MC2, MC3, and MC4 (outer edge parts of the front surface 3a and the back surface 3b) are arranged at positions overlapping a peripheral region outside the logic chip LC. In other words, the logic chip LC does not exist between the wiring board 2 and the outer edge parts of the memory chips MC1, MC2, MC3, and MC4 (for example, see FIG. 10).

Thus, in order to arrange the internal-interface front-surface electrodes 3ap and back-surface electrodes 3bp of each semiconductor chip 3 illustrated in FIG. 5 at the positions at which they are overlapped with each other in the thickness direction, at least the internal-interface front-surface electrodes 3ap and back-surface electrodes 3bp are preferably arranged at positions overlapping the logic chip LC in the thickness direction. Also, as illustrated in FIG. 8, the plurality of external-interface front-surface electrodes 3ap2 are arranged at the outer edge part of the logic chip LC. Therefore, on the front surface 3a of the logic chip LC, the plurality of internal-interface front-surface electrodes 3ap1 are preferably collectively arranged at the center part of the front surface 3 a.

Still further, as illustrated in FIG. 6, a plurality of memory regions (storage circuit element arrangement region) MR are formed on the front surface 3a side of each of the memory chips MC1, MC2, MC3, and MC4 (more specifically, on the main surface of the semiconductor board). In the example illustrated in FIG. 6, four memory regions MR corresponding to the four channels described above are formed. In each memory region MR, a plurality of memory cells (storage circuit elements) are arranged in an array form. Here, as illustrated in FIG. 6, if the plurality of front-surface electrodes 3ap are collectively arranged at the center part of the front surface 3a, the memory regions MR for four channels can be arranged so as to surround a region where a group of the front-surface electrodes is arranged. As a result, a distance from each memory region MR to the front-surface electrode 3ap can be equalized. That is, the transmission distances of the plurality of channels can be equalized, and therefore, this arrangement is preferable in that an error in the transmission speed for each channel can be reduced.

Incidentally, when the front-surface electrodes 3ap1 collectively arranged on the center part of the front surface 3a of the logic chip LC illustrated in FIG. 8 are used as electrodes dedicated to an internal interface, the front-surface electrodes 3ap1 can be functioned even if they are not electrically connected with the wiring board 2 illustrated in FIG. 5. However, when some of the front-surface electrodes 3ap1 are electrically connected with the bonding lead 2f of the wiring board 2 as illustrated in FIG. 5, this arrangement is preferable in that some of the front-surface electrodes 3ap1 can be used as the external-interface electrodes.

For example, a not-illustrated driving circuit for driving a not-illustrated memory circuit is formed in each of the memory chips MC1, MC2, MC3, and MC4, and usage of some of the front-surface electrodes 3ap1 can be considered as a terminal which supplies a power supply potential (first reference potential) and a reference potential (second reference potential such as a ground potential different from the first reference potential) to this driving circuit. When the signal transmission speed can be improved by the clock increase, it is preferable to shorten the transmission distance between a power supply source and a circuit consuming power in view of suppressing operational instability due to an instantaneous drop in voltage or others. Thus, supply of the power supply potential or the reference potential to some of the front-surface electrodes 3ap1 of the logic chip LC is preferable in that the distance to the driving circuit of each of the memory chips MC1, MC2, MC3, and MC4 where the circuit consuming power is formed can be reduced.

### <Method of Manufacturing Semiconductor Device>

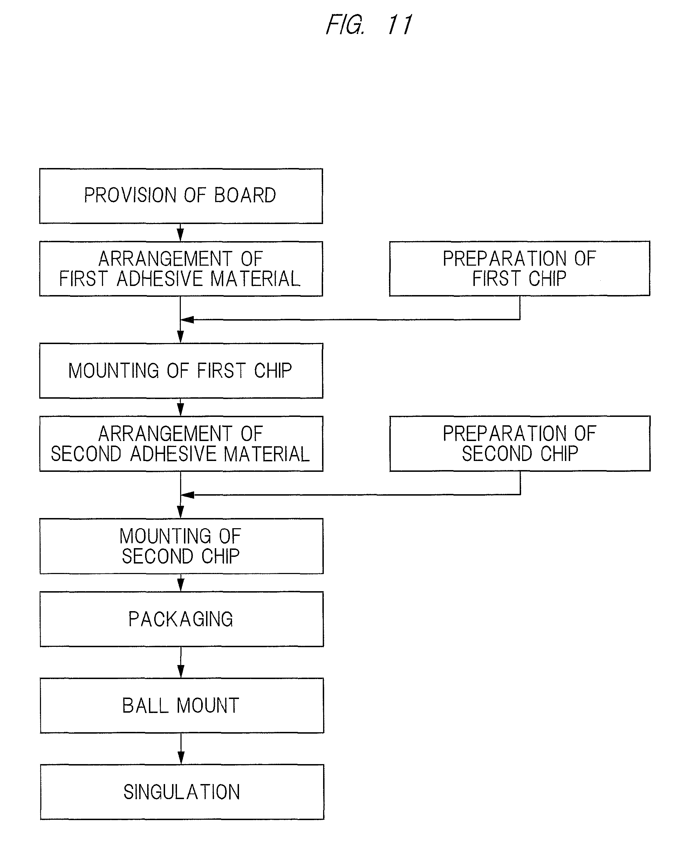

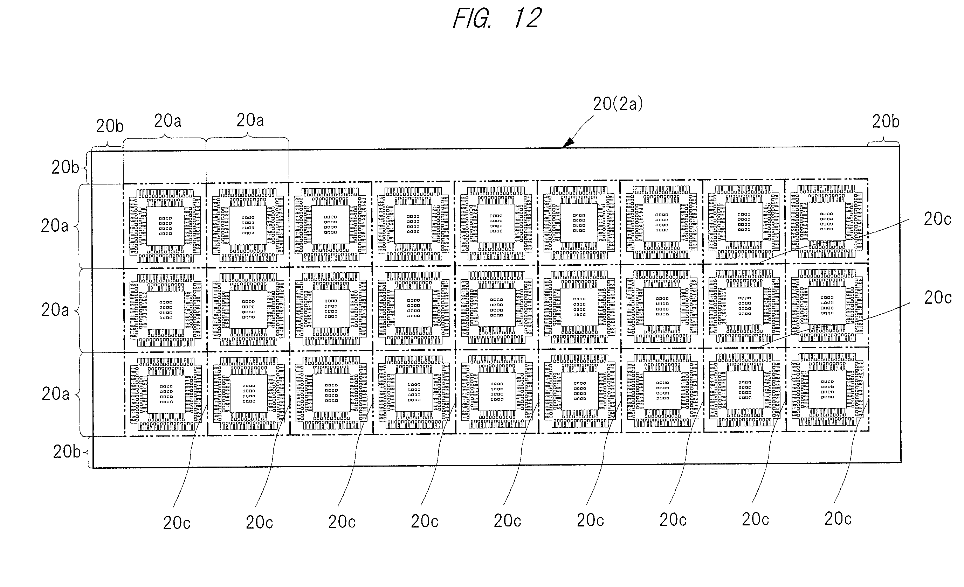

Next, a process of manufacturing the semiconductor device 1 described by using FIG. 1 to FIG. 10 will be described. The semiconductor device 1 is manufactured along a flow illustrated in FIG. 11. FIG. 11 is an explanatory diagram illustrating general outlines of the process of manufacturing the semiconductor device described by using FIG. 1 to FIG. 10. Details on each process are described below by using FIG. 12 to FIG. 42.

### <Board Preparing Process>

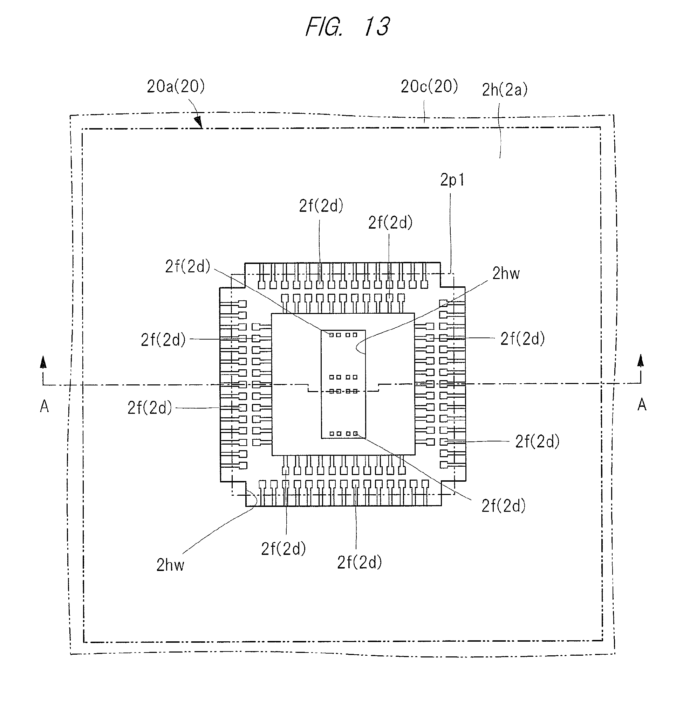

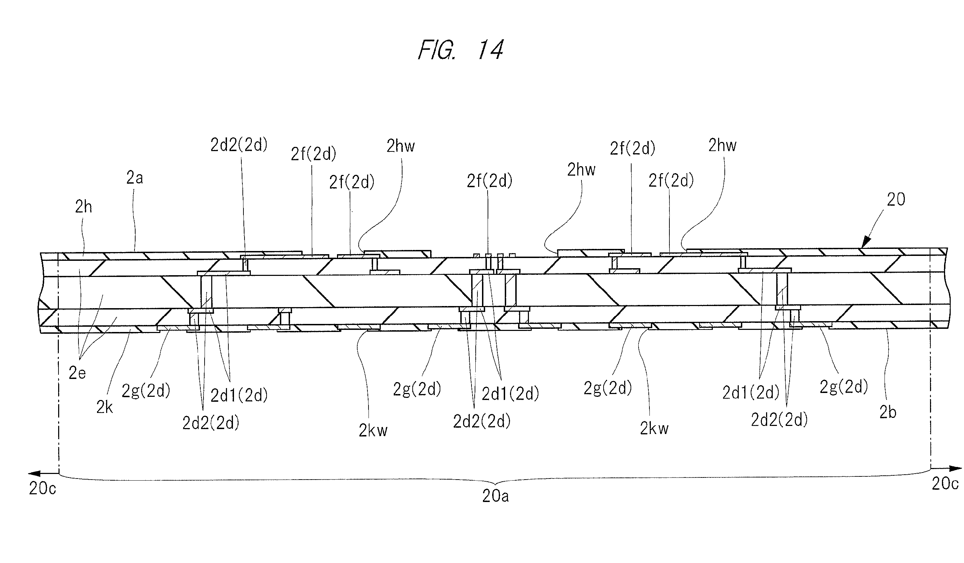

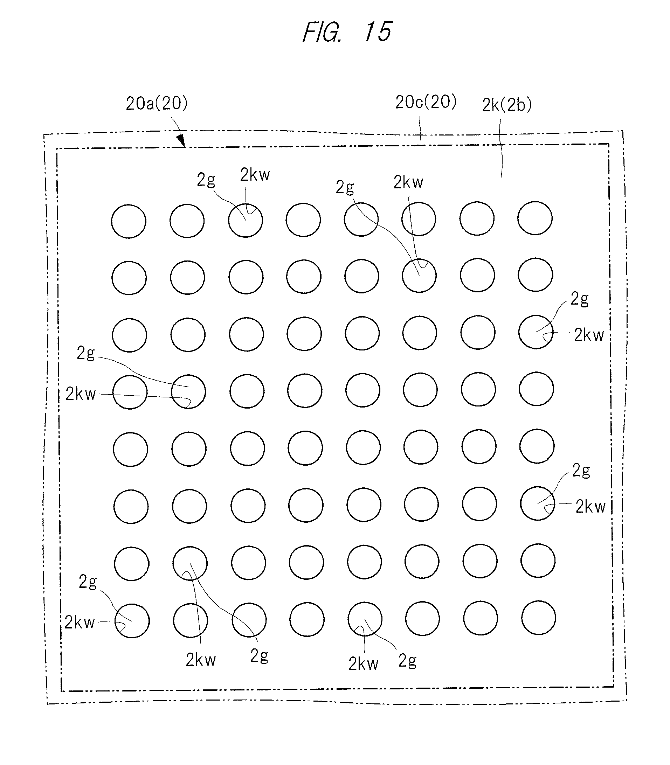

First, in a board preparing process illustrated in FIG. 11, a wiring board 20 illustrated in FIG. 12 to FIG. 15 is prepared. FIG. 12 is a plan view illustrating an entire structure of the wiring board prepared in the board preparing process illustrated in FIG. 11, and FIG. 13 is an enlarged plan view of one device region illustrated in FIG. 12. Also, FIG. 14 is an enlarged cross-sectional view along a line A-A of FIG. 13. Furthermore, FIG. 15 is an enlarged plan view illustrating a surface opposite to that of FIG. 13. Note that the number of terminals is decreased in FIG. 12 to FIG. 15 for ease of viewing. However, the number of terminals (the bonding leads 2f and the lands 2g) is not limited to aspects illustrated in FIG. 12 to FIG. 15.

As illustrated in FIG. 12, the wiring board 20 to be prepared in the present process includes a plurality of device regions 20a inside a frame part (outer frame) 20b. More specifically, the plurality of (twenty seven in FIG. 12) device regions 20a are arranged in a matrix form. Each of the plurality of device regions 20a corresponds to the wiring board 2 illustrated in FIG. 1 to FIG. 4. The wiring board 20 is a so-called multiple-piece-out wiring board having the plurality of device regions 20a and a dicing line (dicing region) 20c between the device regions 20a. In this manner, by using the multiple-piece-out wiring board including the plurality of device regions 20a, manufacturing efficiency can be improved.

Also, as illustrated in FIG. 13 and FIG. 14, each component member of the wiring board 2 described by using FIG. 4 is formed in each device region 20a. The wiring board 20 has the upper surface 2a, the lower surface 2b opposite to the upper surface 2a, and the plurality of wiring layers (four layers in the example illustrated in FIG. 4) electrically connecting the upper surface 2a side with the lower surface 2b side. In each wiring layer, the insulating layer (core layer) 2e insulating between the plurality of wires 2d and the plurality of wires 2d and between adjacent wiring layers is formed. Also, the wire 2d includes the wire 2d1 formed on the upper surface or the lower surface of the insulating layer 2e and the via wire 2d2 which is an interlayer conductive path formed so as to penetrate through the insulating layer 2e in the thickness direction.

Furthermore, as illustrated in FIG. 13, the upper surface 2a of the wiring board 20 includes a chip mount region (chip mount part) 2p 1 which is a region where the logic chip LC illustrated in FIG. 8 is scheduled to be mounted in a first chip mounting process illustrated in FIG. 11. The chip mount region 2p1 exists at a center part of the device region 20a on the upper surface 2a. Note that FIG. 13 illustrates the contour of the chip mount region by using a two-dot-chain line in order to indicate the position of the chip mount region 2p1. However, a practically-visible boundary line is not required because the chip mount region 2p 1 is a region where the logic chip LC is scheduled to be mounted as described above.

Also, the plurality of bonding leads (terminals, chip-mount-surface-side terminals, or electrodes) 2f are formed on the upper surface 2a of the wiring board 20. The bonding leads 2f are terminals electrically connected with the plurality of front-surface electrodes 3ap formed on the front surface 3a of the logic chip LC illustrated in FIG. 8 in the first chip mounting process illustrated in FIG. 11. In the present embodiment, the logic chip LC is mounted by a so-called facedown mounting method in which the front surface 3a side of the logic chip LC faces the upper surface 2a of the wiring board 20, and therefore, bonding parts of the plurality of bonding leads 2f are formed inside the chip mount region 2p1.

Furthermore, the upper surface 2a of the wiring board 20 is covered with the insulating film (solder resist film) 2h. In the insulating film 2h, an opening 2hw is formed. In this opening 2hw, at least a part of the plurality of bonding leads 2f (a portion bonded to the semiconductor chip or a bonding region) is exposed from the insulating film 2h.

On the other hand, as illustrated in FIG. 15, the plurality of lands 2g are formed on the lower surface 2b of the wiring board 20. The lower surface 2b of the wiring board 20 is covered with the insulating film (solder resist film) 2k. Openings 2kw are formed in the insulating film 2k. In these openings 2kw, at least a part of the plurality of lands 2g (a portion bonded to the solder balls 5) is exposed from the insulating film 2k.

Also, as illustrated in FIG. 14, the plurality of bonding leads 2f and the plurality of lands 2g are electrically connected with each other via the plurality of wires 2d. A conductor pattern of these plurality of wires 2d, plurality of bonding leads 2f, plurality of lands 2g, and others is made of a metal material containing, for example, copper (Cu) as a main component. Also, the plurality of wires 2d, the plurality of bonding leads 2f, and the plurality of lands 2g can be formed by, for example, electroplating. Furthermore, as illustrated in FIG. 14, the wiring board 20 having four or more wiring layers (four layers in FIG. 14) can be formed by, for example, a build-up construction method.

### <First Adhesive-Material Arranging Process>

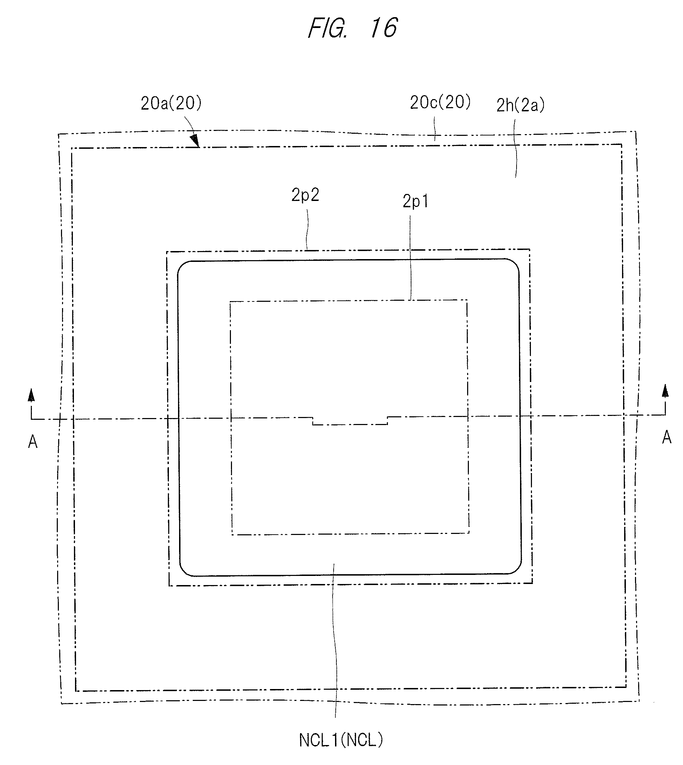

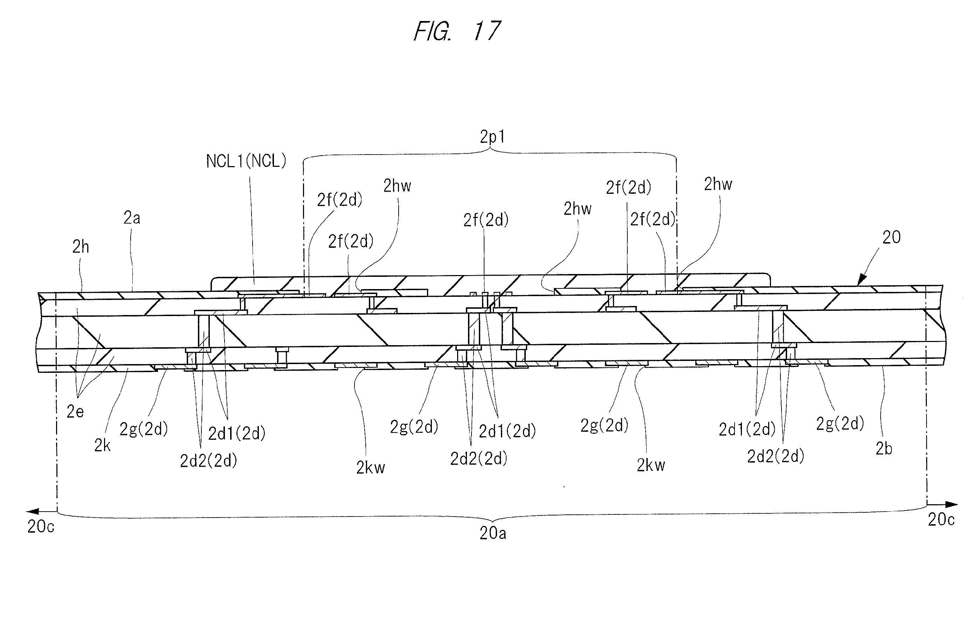

Next, in a first adhesive-material arranging process illustrated in FIG. 11, as illustrated in FIG. 16 and FIG. 17, the adhesive material NCL1 is arranged on the chip mount region 2p1 of the upper surface 2a of the wiring board 20. FIG. 16 is an enlarged plan view illustrating the state in which an adhesive material is arranged in the chip mount region illustrated in FIG. 13, and FIG. 17 is an enlarged cross-sectional view taken along a line A-A of FIG. 16. Note that FIG. 16 illustrates each contour of the chip mount regions 2p1 and 2p2 by using a two-dot-chain line in order to indicate each position of the chip mount region 2p1 and the chip mount region 2p2. However, a practically-visible boundary line is not required because the chip mount regions 2p1 and 2p2 are regions where the logic chip LC and the laminated body MCS are scheduled to be mounted, respectively. Note that, when the chip mount regions 2p1 and 2p2 are illustrated below, a practically-visible boundary line is not required.

Generally, when a semiconductor chip is mounted on a wiring board by a facedown mounting method (flip-chip connection method), a method (post injection method) is performed, the method electrically connecting the semiconductor chip with the wiring board, and then, sealing the connected portion with resin. In this case, the resin is supplied from a nozzle arranged in vicinity of a gap between the semiconductor chip and the wiring board, and the resin is buried in the gap by using the capillary action.

On the other hand, in the present embodiment, the logic chip LC is mounted by a method (pre-coating method) in which the adhesive material NCL1 is arranged in the chip mount region 2p1 before the logic chip LC (see FIG. 8) is mounted on the wiring board 20 in the first chip mounting process described later, and the logic chip LC is pressed from above the adhesive material NCL1 to be electrically connected with the wiring board 20.

In the case of the post injection method described above, since resin is buried in the gap by using the capillary action, the processing time for one device region 20a (resin injection time) is long. On the other hand, in the case of the pre-coating method described above, the adhesive material NCL1 has been already buried between the wiring board 20 and the logic chip LC at the moment when a bonding part between the tip of the logic chip LC (for example, a solder material formed at a tip of the protruding electrode 7 illustrated in FIG. 5 and FIG. 7) and the bonding leads 2f are in contact with each other. Therefore, compared with the post injection method described above, the pre-coating method is preferable in that the processing time for one device region 20a can be reduced to improve manufacturing efficiency.

Also, as described above, the adhesive material NCL1 used in the pre-coating method is made of an insulating (non-conductive) material (for example, resin material).

Furthermore, the adhesive material NCL1 is made of resin material whose rigidity (hardness) is hardened (increased) by application of energy, and contains, for example, a thermosetting resin in the present embodiment. Still further, the adhesive material NCL1 before the curing is softer than the protruding electrodes 7 illustrated in FIG. 5 and FIG. 10, and is deformed by the logic chip LC being pressed thereto.

Furthermore, the adhesive material NCL1 before the curing is roughly categorized into the following two types based on a difference in a handling method. One of the types is a method in which the adhesive material is made of a paste-like resin (insulator paste) called a NCP (Non-Conductive Paste), and is applied on the chip mount region 2p1 from a nozzle not illustrated. The other of the types is a method in which the adhesive material is made of resin previously molded in a film shape called a NCF (Non-Conductive Film), and is transported and pasted to the chip mount region 2p1 as in the film state. When the insulator paste (NCP) is used, a pasting process as performed in the insulator film (NCF) is not required, and therefore, stress applied to the semiconductor chip and others can be smaller than that in the case of using the insulator film. On the other hand, when the insulator film (NCF) is used, shape retention property is higher than that of the insulator paste (NCP), and therefore, a range where the adhesive material NCL1 is arranged and the thickness thereof can be easily controlled.

Although details will be described further below, it is preferred to control the arrangement range and thickness of the adhesive material NCL1, and therefore, the insulator film (NCF) previously formed in the film shape is preferably used. In the example illustrated in FIG. 16 and FIG. 17, the adhesive material NCL1 which is the insulator film (NCF) is arranged and pasted on the chip mount region 2p1 so as to be in closely contact with the upper surface 2a of the wiring board 20. However, although not illustrated, an insulator paste (NCP) can also be used as a modification example.

The adhesive material NCL1 has a fixing material function of bonding and fixing the logic chip LC (see FIG. 4) and the wiring board 20 together in a first chip bonding process illustrated in FIG. 11. Also, the adhesive material NCL1 also has a sealer function of protecting the bonding part between the logic chip LC and the wiring board 2 by sealing the bonding part. Note that the above-described sealing function includes a stress relaxing function of protecting the bonding part between the logic chip LC and the wiring board 2 by dispersing and relaxing stress transmitted to the bonding part therebetween.

In view of satisfying the above-described sealer function, it is only required to arrange the adhesive material NCL1 so as to surround the periphery of the bonding part between the logic chip LC and the wiring board 2, and therefore, it is only required to arrange the adhesive material NCL1 only in a region overlapping the chip mount region 2p1. Also, in view of improving the above-described fixing material function, a part of the adhesive material NC1 is more preferably brought into closely contact with the side surface 3c of the logic chip LC illustrated in FIG. 10. However, it is not required to arrange the adhesive material so as to expand wider than an outside of the chip mount region 2p 1 as illustrated in FIG. 16.

However, in the example illustrated in FIG. 16 and FIG. 17, the adhesive material NCL1 is arranged so as to cover a wider range than the chip mount region 2p1. The chip mount region 2p2 illustrated in FIG. 16 is a region where the laminated body MCS (see FIG. 4) formed of the memory chips MC1, MC2, MC3, and MC4 (see FIG. 4) are scheduled to be mounted in a second chip mounting process illustrated in FIG. 11, and the region includes the chip mount region 2p1 and is larger than the chip mount region 2p1 in a planar size. In the example illustrated in FIG. 16, an outer edge part of the adhesive material NCL1 is arranged at a position between an outer edge part of the chip mount region 2p1 and an outer region of the chip mount region 2p2, the position being close to the outer edge part of the chip mount region 2p2. In other words, the adhesive material NCL1 is arranged so as to cover a portion in vicinity of the outer edge part of the chip mount region 2p2. More specifically, in the example illustrated in FIG. 16, the adhesive material NCL1 is almost the same as the chip mount region NCL1 in a planar size.

Effects obtained by arranging the adhesive material NCL1 so as to cover the wider range than the chip mount region 2p1 as described above will be described in detail in the second chip mounting process and a sealing process described later.

### <First Chip Preparing Process>

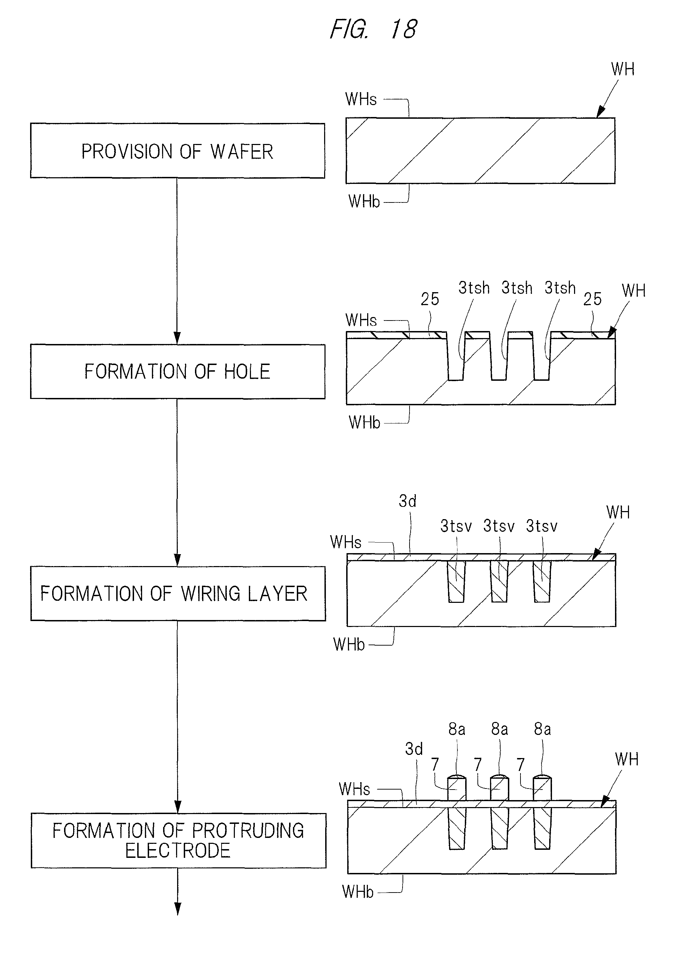

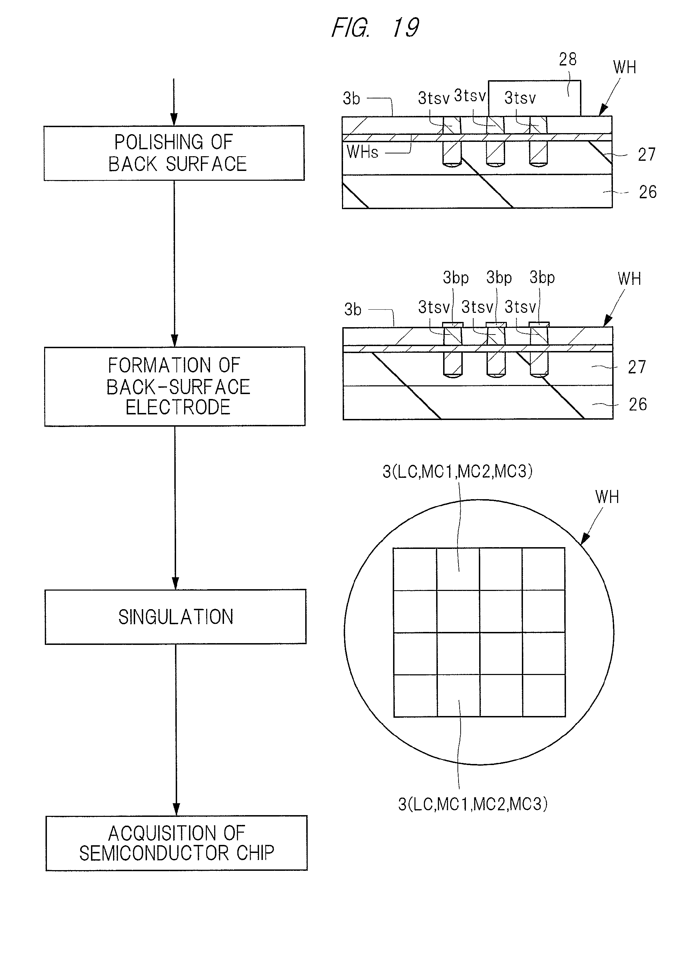

Also, in a first chip preparing process illustrated in FIG. 11, the logic chip LC illustrated in FIG. 8 and FIG. 9 is prepared. FIG. 18 is an explanatory diagram schematically illustrating general outlines of a process of manufacturing a semiconductor chip including the through electrodes illustrated in FIG. 7. Also, FIG. 19 is an explanatory diagram schematically illustrating the general outlines of the process of manufacturing the semiconductor chip continued from FIG. 18. Note that a method of manufacturing the through electrodes 3tsv and the back-surface electrodes 3p electrically connected with the through electrodes 3tsv is mainly described in FIG. 18 and FIG. 19, and illustration and description of a process of forming various circuits except for the through electrodes 3tsv are omitted. Also, method of manufacturing the semiconductor chip illustrated in FIG. 18 and FIG. 19 can also be applied to methods of manufacturing not only the logic chip LC illustrated in FIG. 4 but also the memory chips MC1, MC2, and MC3.

First, as a wafer preparing process, a wafer (semiconductor substrate) WH illustrated in FIG. 18 is prepared. The wafer WH is a semiconductor substrate made of, for example, silicon (Si), and has a circular shape when seen in a plan view. The wafer WH has a front surface (a main surface or an upper surface) WHs which is a semiconductor element formation surface and a back surface (a main surface or a lower surface) WHb opposite to the front surface WHs. Also, the wafer WH has a thickness thicker than the thicknesses of the logic chip LC and the memory chips MC1, MC2, MC3, and MC4 illustrated in FIG. 4, and is, for example, about several hundreds of µm.

Next, as a hole forming process, holes (holes or openings) 3tsh for forming the through electrodes 3tsv illustrated in FIG. 5 are formed. In the example illustrated in FIG. 18, a mask 25 is arranged on the front surface WHs of the wafer WH and is subjected to etching process so as to form the holes 3tsh. Note that semiconductor elements of the logic chip LC and the memory chips MC1, MC2, and MC3 illustrated in FIG. 4 can be formed, for example, after the present process and before a next wiring layer forming process.

Next, a metal material such as, for example, copper (Cu), is buried in the holes 3tsh to form the through electrodes 3tsv. Next, as the wiring layer forming process, a wiring layer (chip wiring layer) 3d is formed on the front surface WHs of the wafer WH. In the present process, the plurality of front-surface electrodes 3ap illustrated in FIG. 5 and FIG. 10 are formed, and the plurality of through electrodes 3tsv and the plurality of front-surface electrodes 3ap are electrically connected with each other. Also in the present process, the semiconductor elements of the logic chip LC and the memory chips MC1, MC2, and MC3 illustrated in FIG. 4 and the plurality of front-surface electrodes 3ap illustrated in FIG. 5 and FIG. 10 are electrically connected with each other via the wiring layer 3d. In this manner, the semiconductor elements of the logic chip LC and the memory chips MC1, MC2, and MC3 are electrically connected with each other via the wiring layer 3d.

Next, as a protruding electrode forming process, the protruding electrodes 7 are formed on the front-surface electrodes 3ap (see FIG. 5 and FIG. 10). Also, a solder layer 8a is formed at the tip of each protruding electrode 7. This solder layer 8a functions as a bonding material used when the semiconductor chip 3 illustrated in FIG. 5 is mounted on the wiring board 2 or the semiconductor chip 3 of a lower layer.

Next, as a back surface polishing process illustrated in FIG. 19, a back surface WHb (see FIG. 18) side of the wafer WH is polished so as to thin the wafer WH. In this manner, the back surface 3b of the semiconductor chip 3 illustrated in FIG. 5 is exposed. In other words, the through electrodes 3tsv penetrate through the wafer WH in a thickness direction. Also, the plurality of through electrodes 3tsv are exposed from the wafer WH on the back surface 3b of the wafer WH. In the example illustrated in FIG. 19, in the back surface polishing process, the wafer is polished by using a polishing jig 28 in a state in which the wafer WH is supported by a support base material 26 such as a glass plate and a protective layer 27 for protecting the protruding electrodes 7 for protecting the front surface WHs side.

Next, in a back-surface electrode forming process, the plurality of back-surface electrodes 3bp are formed on the back surface 3b, and are electrically connected with the plurality of through electrodes 3tsv.

Next, as a singulation process, the wafer WH is separated along a dicing line to obtain the plurality of semiconductor chips 3. Then, an inspection is performed as required, and the semiconductor chip 3 (the logic chip LC and the memory chips MC1, MC2, and MC3) illustrated in FIG. 4 is obtained.

### <First Chip Mounting process>

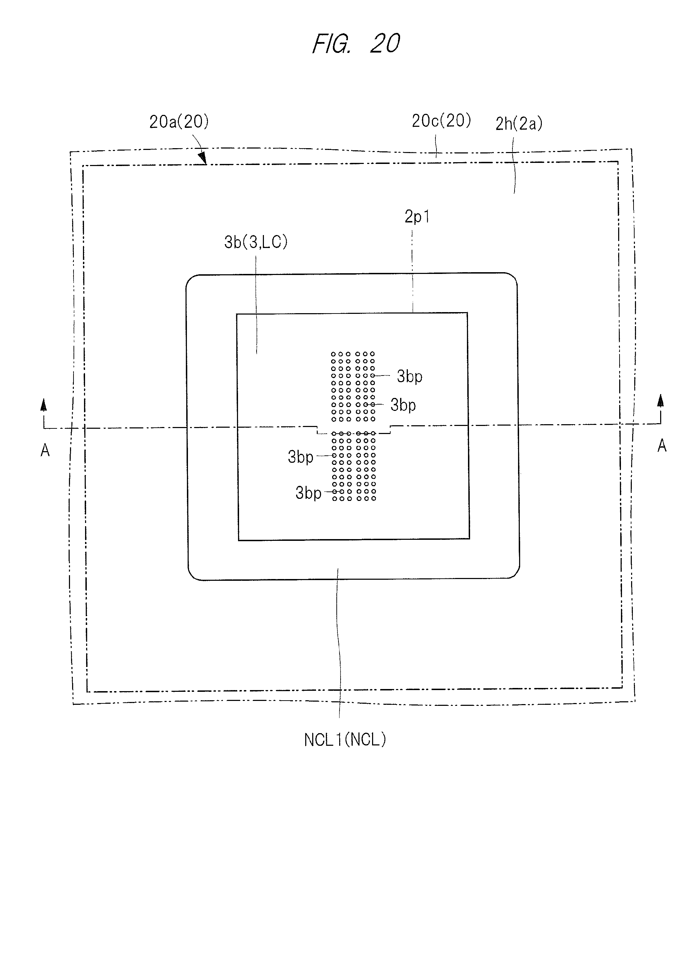

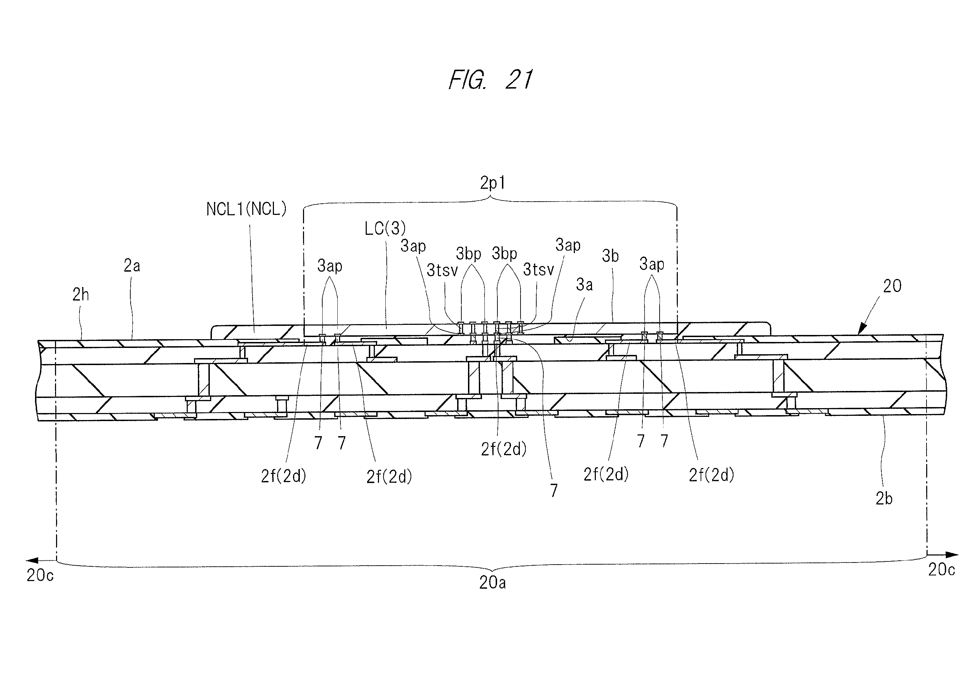

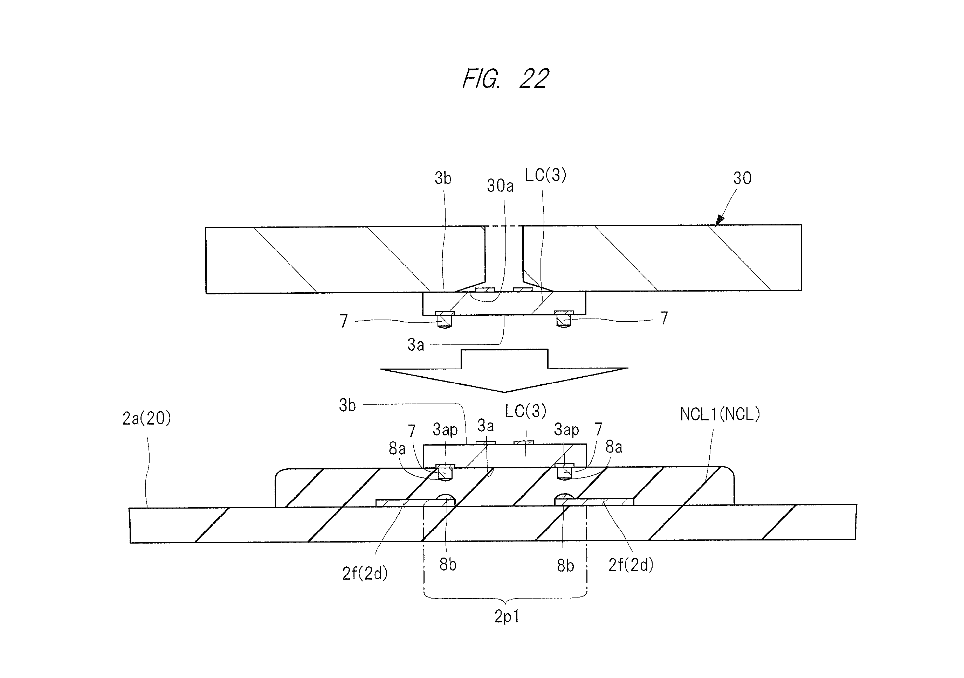

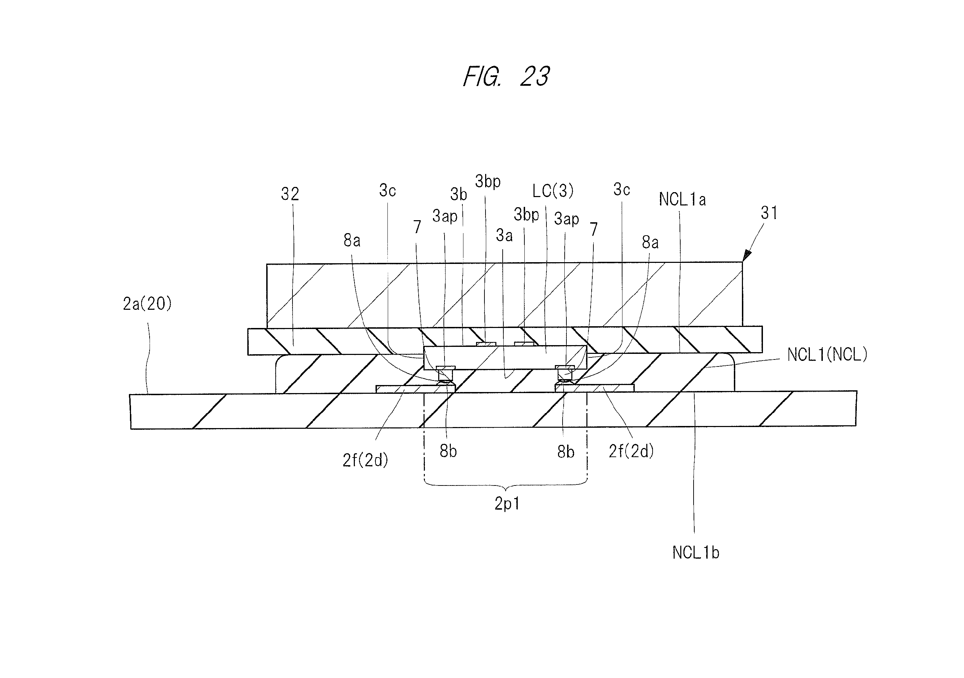

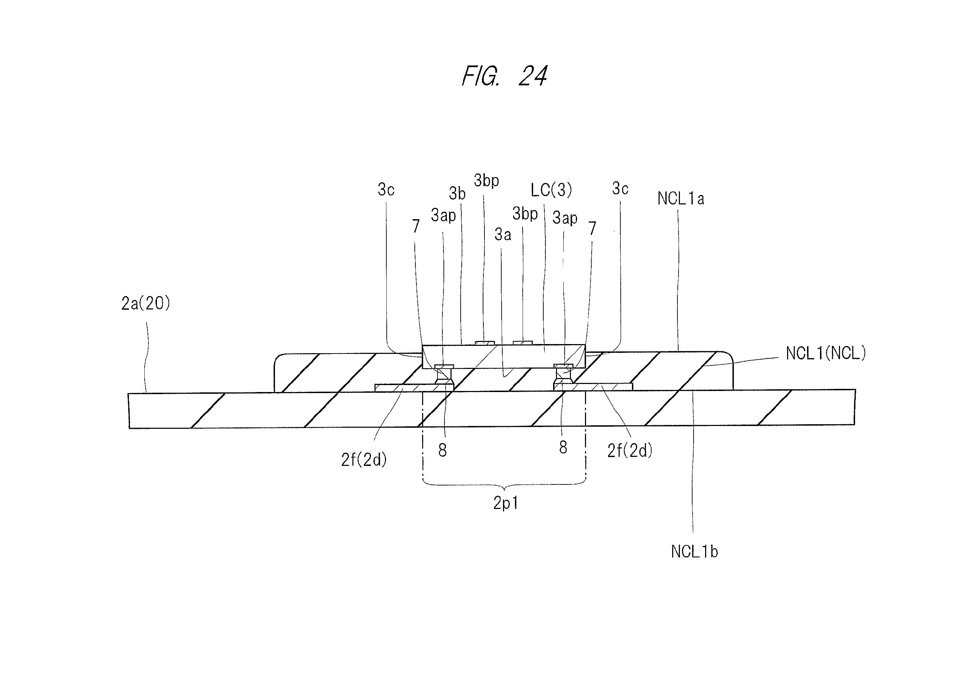

Next, in the first chip mounting process illustrated in FIG. 11, the logic chip LC is mounted on the wiring board 2 as illustrated in FIG. 20 and FIG. 21. FIG. 20 is an enlarged plan view illustrating the state in which the logic chip LC is mounted on the chip mount region of the wiring board illustrated in FIG. 16. Also, FIG. 21 is an enlarged cross-sectional view taken along a line A-A of FIG. 20. Furthermore, FIG. 22 to FIG. 24 are explanatory diagrams illustrating a detailed flow of the first chip mounting process illustrated in FIG. 11. FIG. 22 is an explanatory diagram schematically illustrating the state in which the semiconductor chip is mounted on the chip mount region. FIG. 23 is an explanatory diagram illustrating the state in which a transportation jig illustrated in FIG. 22 is removed and a heating jig is pressed onto a back surface side of the semiconductor chip. Still further, FIG. 24 is an explanatory diagram illustrating the state in which the semiconductor chip is heated and electrically connected with the wiring board.

In the present process, as illustrated in FIG. 21, the logic hip LC is mounted by a so-called facedown mounting method (flip-chip connection method) such that the front surface 3a of the logic chip LC faces the upper surface 2a of the wiring board 2. Also, by the present process, the logic chip LC and the wiring board 2 are electrically connected with each other. More specifically, the plurality of front-surface electrodes 3ap formed on the front surface of the logic chip LC and the plurality of bonding leads 2f formed on the upper surface 2a of the wiring board 2 are electrically connected with each other via the protruding electrodes 7 and the bonding material 8 (see FIG. 5 and FIG. 10). A detailed flow of the present process will be described below by using FIG. 22 to FIG. 24.

In the present process, first, as illustrated in FIG. 22, the logic chip LC (semiconductor chip 3) is arranged on the chip mount region 2p1 of the wiring board 20. The logic chip LC is transported onto the chip mount region 2p 1 in a state in which the back surface 3b side being held by a holding jig 30, and is arranged on the bonding material NCL1 such that the front surface 3a faces the upper surface 2a of the wiring board 20. The holding jig 30 has a holding surface 30a for holding the back surface 3b of the logic chip LC as absorbing it, and transports the logic chip LC as being held on the holding surface 30a.

Also, the protruding electrodes 7 are formed on the front surface 3a side of the logic chip LC, and the solder layer 8a is formed at the tip of each protruding electrode 7. On the other hand, a solder layer 8b, which is a bonding material for electrical connection with the protruding electrodes 7, is formed at the bonding parts of the boding leads 2f formed on the upper surface 2a of the wiring board 20. Furthermore, before a heat treatment is performed, the adhesive material NCL1 before the curing is soft. Therefore, when the holding jig 30 is brought closer to the wiring board 20, the protruding electrodes 7 are pushed into the adhesive material NCL 1.

Next, as illustrated in FIG. 23, a heating jig 31 is pressed onto the back surface 3b side of the logic chip LC to push the logic chip LC toward the wiring board 20. As described above, the adhesive material NCL1 before the curing is soft before the heat treatment is performed. Therefore, when the logic chip LC is pushed in by the heating jig 31, the logic chip LC is brought closer to the wiring board 20. When the logic chip LC is brought closer to the wiring board 20, the tips (more specifically, the solder layer 8a) of the plurality of protruding electrodes 7 formed on the front surface 3a of the logic chip LC are brought into contact with the bonding region (more specifically, the solder layer 8b) of the bonding leads 2f.

Also, the thickness of the adhesive material NCL1 (a distance between an upper surface NCL1a and a lower surface NCL1b) is thicker than a total of at least the height of the protruding electrode 7 (protruding height), the thickness of the bonding lead 2f, and the thickness of the bonding material (solder layers 8a and 8b). Therefore, when the logic chip is pushed by the heating jig 31, a part of the front surface 3a side of the logic chip LC is buried in the adhesive material NCL1. In other words, at least a part of the side surfaces 3c on the front surface 3a side of the logic chip LC is buried in the adhesive material NCL1. It is only required that the adhesive material NCL1 is buried between the logic chip LC and the wiring board 20 in view of protecting the bonding part between the logic chip LC and the wiring board 20. By burying a part of the front surface 3a side of the logic chip LC in the adhesive material NCL1, the semiconductor chip can be stably mounted in the second chip mounting process described later. Details will be described in the second chip mounting process.

Furthermore, since the back-surface electrodes 3bp are formed on the logic chip LC, it is required to prevent the soft adhesive material NCL1 from going around the back surface 3b side to cover the back-surface electrodes 3bp. Thus, as illustrated in FIG. 23, a softer member (lower elastic member) such as a resin film (film) 32 than the heating jig 31 and the logic chip LC is preferably interposed between the heading jig 31 and the logic chip LC to cover the back surface 3b of the logic chip LC with the resin film 32. When the logic chip LC is pressed via the resin film 32, the resin film 32 is brought into closely contact with the back surface 3b of the logic chip LC. Therefore, even if the thickness of the adhesive material NCL1 is made thicker, the going of the adhesive material NCL1 around the back surface 3b of the logic chip LC can be suppressed. Also, by covering the entire region where the adhesive material NCL1 is arranged with the resin film 32, the upper surface NCL1a of the adhesive material NCL1 can be planarized. Note that the resin film 32 of the present embodiment is made of, for example, fluorine resin.

Note that the pressing of the heating jig 31 so as to interpose the resin film 32 causes a state in which the resin film 32 digs into the logic chip LC. FIG. 23 understandably illustrates the digging state of the resin film 32 into the logic chip LC. As long as the height of the upper surface NCL1a of the adhesive material NCL1 is equal to or lower than the back surface 3b of the logic chip, the going of the adhesive material NCL1 around the back surface 3b of the logic chip LC can be suppressed.

Next, as illustrated in FIG. 23, the logic chip LC and the adhesive material NCL1 are heated by the heating jig (heating source) 31 as pressing the logic chip LC against the heating jig 31. Each of the solder layers 8a and 8b illustrated in FIG. 23 is melted and combined together at the bonding part between the logic chip LC and the wiring board 20 so as to become the bonding material (solder material) 8 illustrated in FIG. 24. That is, by heating the logic chip LC by the heating jig (heating source) 31, the protruding electrodes 7 and the bonding leads 2f are electrically connected with each other via the bonding material 8.

On the other hand, by heating the adhesive material NCL1 by using the heating jig (heating source) 31 illustrated in FIG. 23, the adhesive material NCL1 is cured In this manner, the cured adhesive material NCL1 into which a part of the logic chip LC is buried is obtained. Also, the back-surface electrodes 3bp of the logic chip LC are covered with the resin film 32, and therefore, are exposed from the cured adhesive material NCL1. Note that it is not required to completely cure the adhesive material NCL1 by the heat from the heating jig (heating source) 31, and an aspect can be employed, the aspect of partially curing (temporarily curing) the thermosetting resin contained in the adhesive material NCL1 as hard as the logic chip LC can be fixed, and then, transporting the wiring board 20 to a heating furnace not illustrated, and curing (completely curing) the remaining thermosetting resin. Although it requires time until the complete curing process which cures the entire thermosetting resin components contained in the adhesive material NCL1, manufacturing efficiency can be improved by performing the complete curing process in the heating furnace.

### <Second Adhesive-Material Arranging Process>

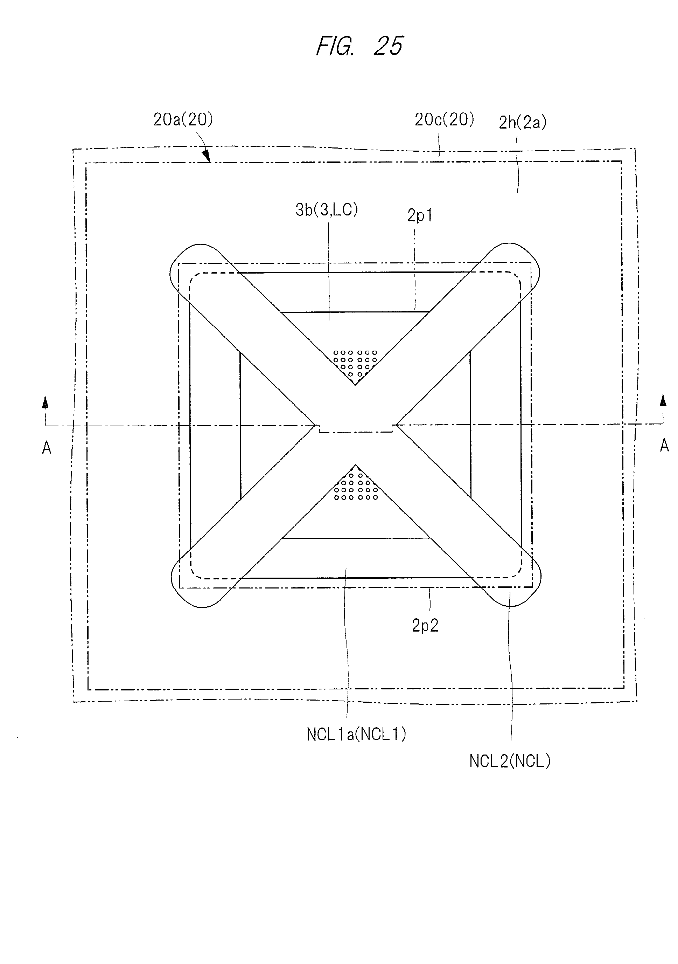

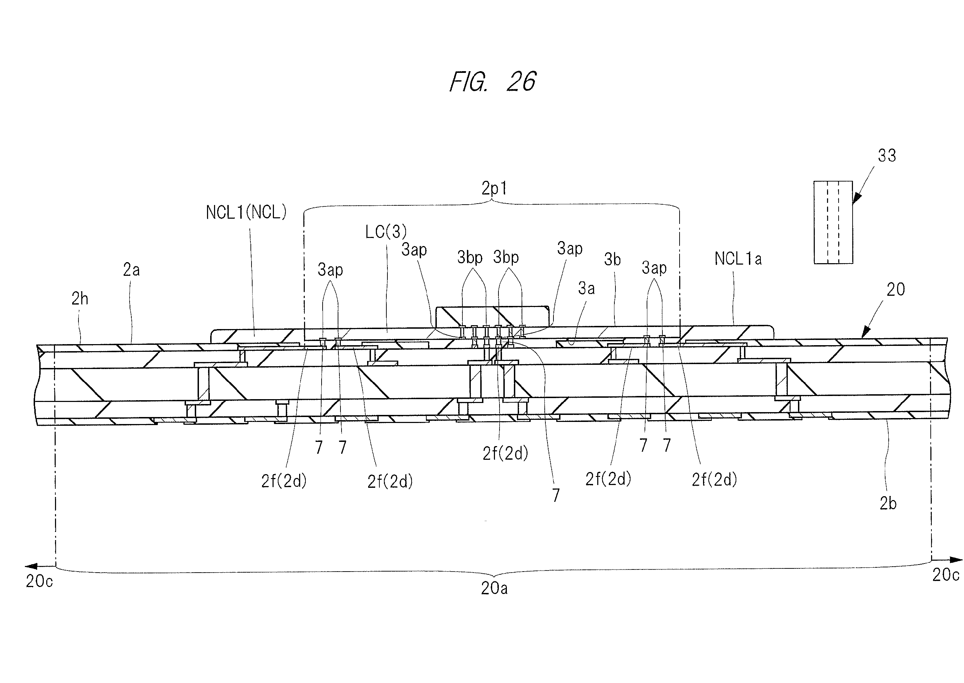

Next, in a second adhesive-material arranging process illustrated in FIG. 11, as illustrated in FIG. 25, the adhesive material NCL2 is arranged on the back surface 3b of the logic chip LC (semiconductor chip 3) and on the upper surface (front surface) NCL1a of the adhesive material NCL1 exposed from the logic chip LC. FIG. 25 is an enlarged plan view illustrating the state in which the adhesive material is arranged on the back surface of the semiconductor chip illustrated in FIG. 20 and its periphery of the back surface, and FIG. 26 is an enlarged cross-sectional view taken along a line A-A of FIG. 25.

As illustrated in FIG. 5 described above, in the semiconductor device 1 of the present embodiment, both of the logic chip LC mounted on the lowermost stage (for example, the first stage) and the memory chip MC1 mounted on the second stage from the lower stage among the plurality of laminated semiconductor chips 3 are mounted by the facedown mounting method (flip-chip connection method). Therefore, as described in the first adhesive-material arranging process described above, the pre-coating method described above is preferably applied in such a viewpoint that the manufacturing efficiency can be improved because the processing time for one device region 20a (see FIG. 25 and FIG. 26) is reduced.

Also, as described above, the adhesive material NCL2 used in the pre-coating method is made of an insulating (non-conductive) material (for example, resin material).

Furthermore, the adhesive material NCL2 is made of resin material whose rigidity (hardness) is hardened (increased) by application of energy, and contains, for example, a thermosetting resin in the present embodiment. Still further, the adhesive material NCL2 before the curing is softer than the protruding electrodes 7 illustrated in FIG. 5, and is deformed by the pressing of the logic chip LC.

Still further, based on a difference in a handling method, the adhesive material NCL2 before the curing is roughly categorized into a paste-like resin (insulator paste) called a NCP and resin previously molded in a film shape (insulator film) called a NCF. As the adhesive material NCL2 for use in the present process, either one of the NCP and the NCF can be used. In the example illustrated in FIG. 25 and FIG. 26, the NCP is discharged from the nozzle 33 (see FIG. 26), and the adhesive material NCL2 is arranged on the back surface 3b of the logic chip LC and on the upper surface (exposed surface or front surface) NCL1a of the adhesive material NCL1 exposed from the logic chip LC.

Note that this method is in common with the post injection method described in the above-described first adhesive-material arranging process in the point of the discharging of the paste-like adhesive material NCL2 from the nozzle 33. However, in the present embodiment, the adhesive material NCL2 is previously mounted before the memory chip MC1 illustrated in FIG. 4 is mounted. Therefore, compared with the post injection method of injecting the resin by using the capillary action, the coating speed of the adhesive material NCL2 can be significantly improved.

The insulator paste (NCP) can be brought into closely contact with a coating target (the logic chip LC in the present process) with a lower load than that of the insulator film (NCF). Also, it is not required to extend the adhesive material NCL2 widely toward the periphery of the side surfaces 3c of the memory chip MC4 as illustrated in FIG. 3. Therefore, it is easier to control the thickness and the arrangement range than those of the NCP1 described in the above-described first adhesive-material arranging process. Therefore, in view of reducing stress on the logic chip LC already mounted at the time of this process, the insulator paste (NCP) is more preferable. However, although not illustrated, the insulator film (NCF) can be also used as the adhesive material NCL2.

The adhesive material NCL2 has a fixing material function of bonding and fixing the memory chip MC1 (see FIG. 4) and the logic chip LC (see FIG. 4) together in a second chip bonding process illustrated in FIG. 11. The adhesive material NCL2 also has a sealer function of protecting the bonding part between the memory chip MC1 and the logic chip LC by sealing the bonding part. Note that the above-described sealing function includes a stress relaxing function of protecting the bonding part between the memory chip MC1 and the logic chip LC by dispersing the stress transmitted to the bonding part so as to relax the stress.

In view of satisfying the above-described sealer function, it is only required to arrange the adhesive material NCL2 so as to surround the periphery of the bonding part between the memory chip MC1 and the logic chip LC. Therefore, it is only required to arrange the adhesive material NCL2 only on the back surface 3b of the logic chip. However, in the present embodiment, as illustrated in FIG. 25, the adhesive material NCL2 is arranged on not only the back surface 3b of the logic chip but also the upper surface NCL1a of the adhesive material NCL1. As described above, by arranging the adhesive material NCL2 also on the upper surface NCL1a of the adhesive material NCL1, the laminated body MCS is difficult to be tilted when the laminated body MCS (see FIG. 4) formed of the memory chips MC1, MC2, MC3, and MC4 (see FIG. 4) is mounted in the second chip mounting process illustrated in FIG. 11.

Also, the chip mount region 2p2 illustrated in FIG. 25 is a region where the laminated body MCS (see FIG. 4) formed of the memory chips MC1, MC2, MC3, and MC4 (see FIG. 4) is scheduled to be mounted in the second chip mounting process illustrated in FIG. 11. Also, in the example illustrated in FIG. 25, the chip mount region 2p2 is coated with the adhesive material NCL2 in a band shape along diagonal lines of the chip mount region 2p2 forming a quadrangle when seen in a plan view. As described above, a method (referred to as a cross coating method) of coating the coating region of the adhesive material NCL2 with the paste-like adhesive material NCL2 formed in two band shapes crossing each other is preferable in that the adhesive material NCL2 is easily uniformly extended in the second chip mounting process described later. However, a coating method different from that of FIG. 25 can be also used as long as the method can extend the adhesive material NCL2 so as not to cause a gap in the second chip mounting process described later.

Furthermore, the tip of the adhesive material NCL2 is arranged outside of the chip mount region 2p2. In other words, in the second adhesive-material arranging process, the range of the arrangement of the adhesive material NCL2 is wider than the chip mount region 2p2. As described above, by the coating with the adhesive material NCL2 in the range wider than the chip mount region 2p2, the gap between the front surface 3a of the memory chip MC1 and the upper surface 2a of the wiring board 2 as illustrated in FIG. 4 can be filled in the second chip mounting process illustrated in FIG. 11.

### <Second Chip Preparing Process>

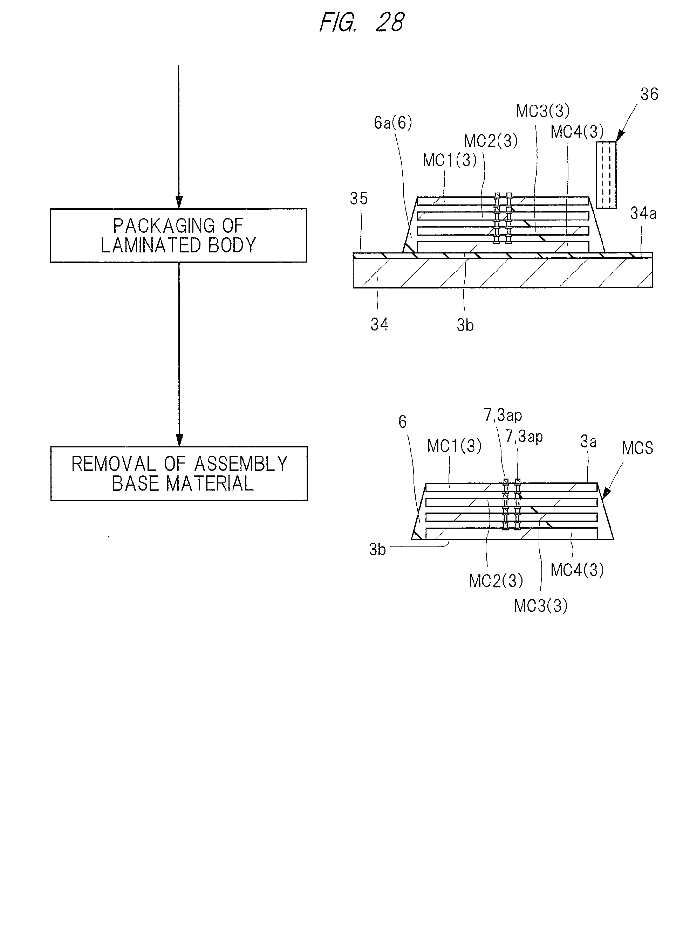

Also, in a second chip preparing process illustrated in FIG. 11, the memory chips MC1, MC2, MC3, and MC4 illustrated in FIG. 4 are prepared. As a modification example of the present embodiment, the memory chips MC1, MC2, MC3, and MC4 can be sequentially laminated on the logic chip LC. However, an aspect will be described in the present embodiment, the aspect forming the laminated body (memory chip laminated body or semiconductor chip laminated body) MCS illustrated in FIG. 28 by previously laminating the memory chips MC1, MC2, MC3, and MC4. As described below, the laminated body MCS of the memory chips MC1, MC2, MC3, and MC4 is formed, this formation can be performed, for example, independently from other processes at a location different from those of the processes except for the second chip preparing process illustrated in FIG. 11. For example, the laminated body MCS can be prepared as a purchased component. Therefore, this is advantageous in that an assembling process illustrated in FIG. 11 can be simplified so as to totally improve the manufacturing efficiency.

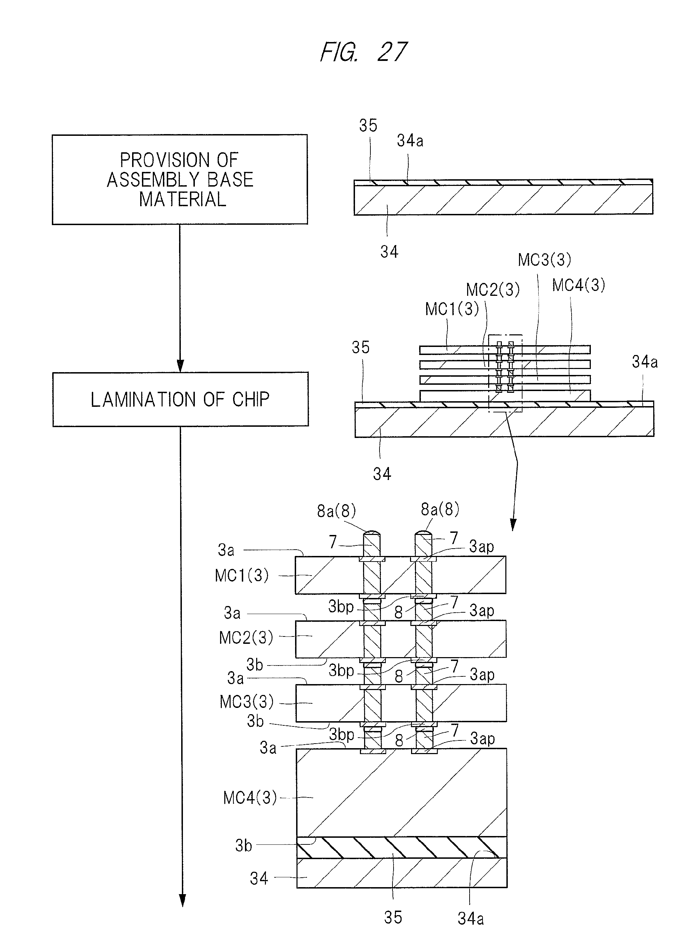

FIG. 27 is an explanatory diagram schematically illustrating general outlines of a process of assembling the laminated body of the memory chips illustrated in FIG. 4. Also, FIG. 28 is an explanatory diagram schematically illustrating the general outlines of the process of assembling the laminated body of the memory chips continued from FIG. 27. Note that the method of manufacturing each of the plurality of memory chips MC1, MC2, MC3, and MC4 illustrated in FIG. 27 and FIG. 28 is omitted since these memory chips can be manufactured by applying the method of manufacturing the semiconductor chip described by using FIG. 18 and FIG. 19.

First, as an assembling-base-material preparing process, a base material (assembly base material) 34 for assembling the laminated body MCS illustrated in FIG. 28 is prepared. The base material 34 has an assembly surface 34a where the plurality of memory chips MC1, MC2, MC3, and MC4 are laminated, and the assembly surface 34a is provided with an adhesive layer 35.

Next, as a chip laminating process, the memory chips MC1, MC2, MC3, and MC4 are laminated on the assembly surface 34a of the base material 34. In the example illustrated in FIG. 27, the memory chips MC4, MC3, MC2, and MC1 are sequentially laminated in this order such that the back surface 3b of each semiconductor chip to be laminated faces the assembly surface 34a of the base material 34. The protruding electrode 7 and the back-surface electrodes3bp of each semiconductor chip are bonded to each other by, for example, the bonding material 8. Also, at the tip of the protruding electrode 7 of the memory chip MC1 arranged at the uppermost stage, the bonding material 8 (for example, the solder layer 8a) for electrically connecting the back-surface electrodes 3bp of the logic chip LC illustrated in FIG. 26 with the protruding electrode 7 of the memory chip MC1 illustrated in FIG. 27 is formed in the second chip mounting process illustrated in FIG. 11.

Next, in a laminated body sealing process illustrated in FIG. 28, the sealing body (chip-laminated-body sealing body or chip-laminated-body resin body) 6 is formed by supplying resin (underfill resin) between the plurality of laminated semiconductor chips. This sealing body 6 is formed by the post injection method described in the first adhesive-material arranging process described above. That is, after the plurality of semiconductor chips 3 are previously laminated, the underfill resin 6a is supplied from the nozzle 36 and is buried between the plurality of laminated semiconductor chips 3. The underfill resin 6a has a viscosity lower than that of the resin for sealing used in a sealing process illustrated in FIG. 11, and can be buried between the plurality of semiconductor chips 3 by using the capillary action. Then, the underfill resin 6a buried between the semiconductor chips 3 is cured to obtain the sealing body 6.

The method of forming the sealing body 6 by this post injection method is excellent in a gap burying property more than that of a so-called transfer mold method (details will be described later), and therefore, is effectively applied to a case in which the gap between the laminated semiconductor chips 3 is narrow. Also, when the gap in which the underfill resin 6a is buried is formed in a plurality of stages as illustrated in FIG. 28, the underfill resin 6a can be collectively buried in a plurality of gaps. Therefore, the processing time can be totally reduced.

Next, in an assembly-base-material removing process, the base material 34 and the adhesive layer 35 are peeled off and removed from the back surface 3b of the memory chip MC4. As a method of removing the base material 34 and the adhesive layer 35, for example, a method of curing a resin component (for example, ultraviolet curable resin) contained in the adhesive layer 35 can be applied. In these processes above, the plurality of memory chips MC1, MC2, MC3, and MC4 are laminated so as to obtain the laminated body MCS with the connecting parts of each of the memory chips MC1, MC2, MC3, and MC4 sealed with the sealing body 6. This laminated body MCS can be regarded as one memory chip having the front surface 3a where the plurality of front-surface electrodes 3ap are formed (the front surface 3a of the memory chip MC1) and the back surface 3b positioned opposite to the front surface 3a (the back surface 3b of the memory chip MC4).

### <Second Chip Mounting Process>

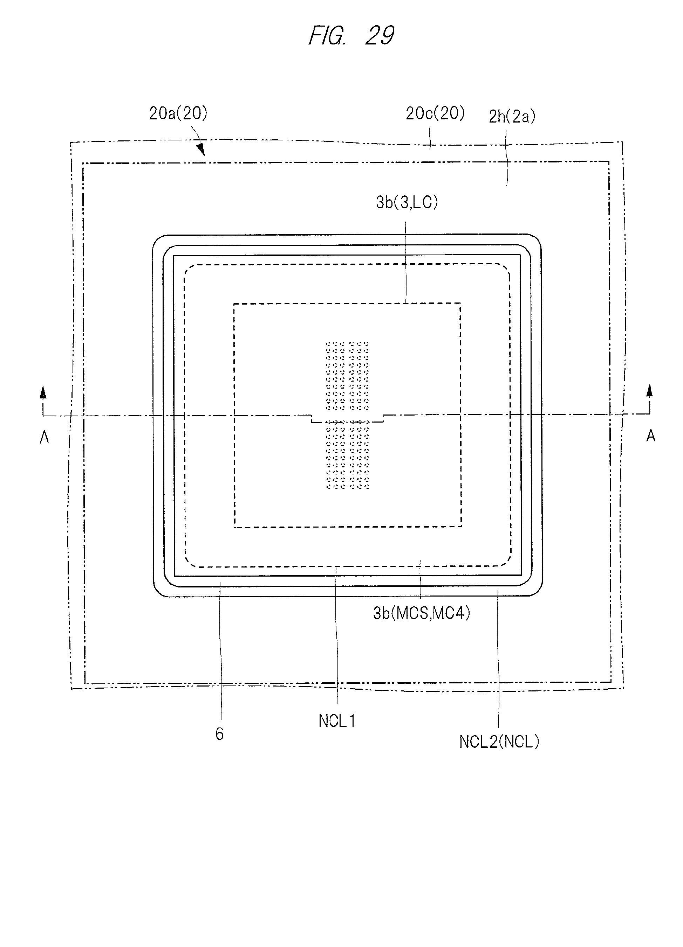

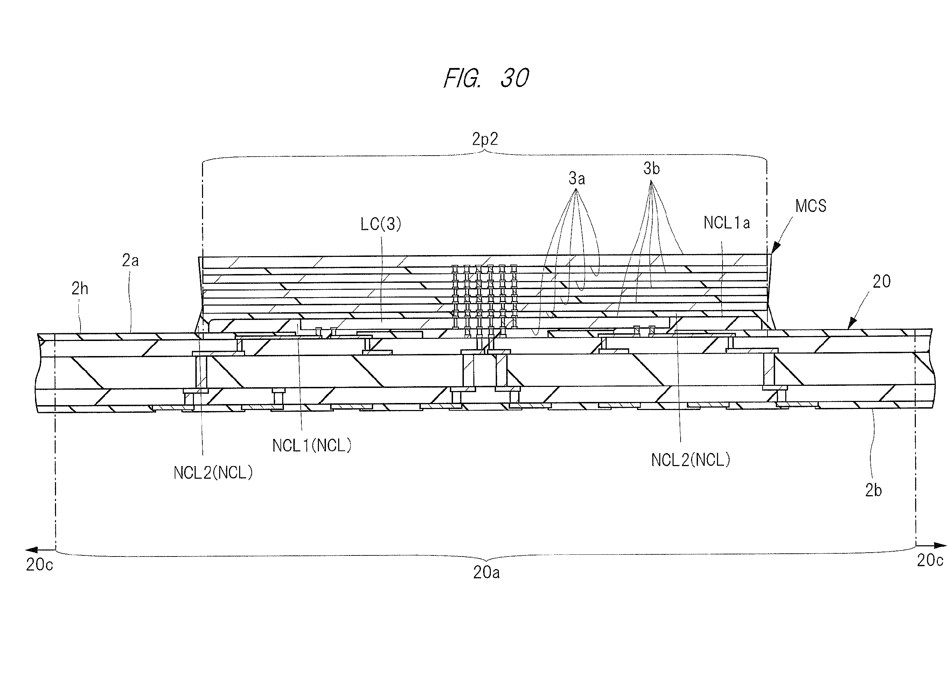

Next, in a second chip mounting process illustrated in FIG. 11, as illustrated in FIG. 29 and FIG. 30, the laminated body MCS formed of the plurality of memory chips MC1, MC2, MC3, and MC4 is mounted on the logic chip LC. FIG. 29 is an enlarged plan view illustrating the state in which the laminated body of the memory chips is mounted on the back surface of the logic chip illustrated in FIG. 25. Also, FIG. 30 is an enlarged cross-sectional view taken along a line A-A of FIG. 29.

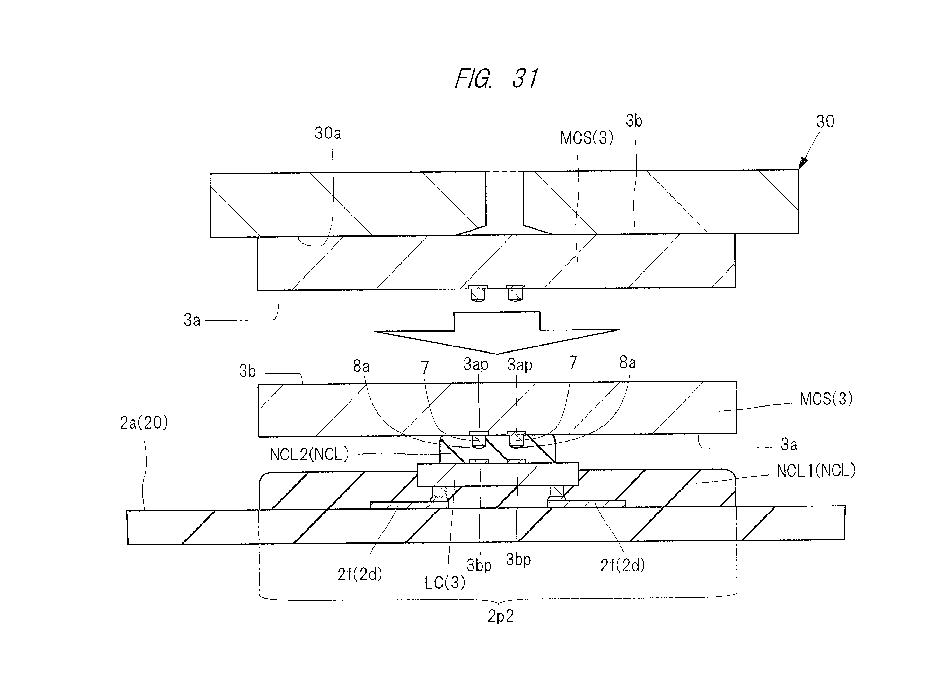

In the present process, as illustrated in FIG. 30, the laminated body MCS is mounted by a so-called facedown mounting method (flip-chip connecting method) such that the front surface 3a of the laminated body MCS faces the back surface 3b of the logic chip LC (in other words, the upper surface 2a of the wiring board 20). Also, by this process, the plurality of memory chips MC1, MC2, MC3, and MC4 and the logic chip LC are electrically connected with each other. More specifically, as illustrated in FIG. 5, the plurality of front-surface electrodes 3ap formed on the front surface 3a of the memory chip MC1 (or the laminated body MCS) and the plurality of back-surface electrodes 3bp formed on the back surface 3b of the logic chip LC are electrically connected with each other via the protruding electrodes 7 (and the bonding material not illustrated). In FIG. 5, note that illustration of the bonding material 8 formed at the tips of the protruding electrodes 7 on the uppermost stage illustrated in FIG. 27 is omitted for ease of viewing. Hereinafter, a detailed flow of the present process will be described by using FIG. 31 to FIG. 33.

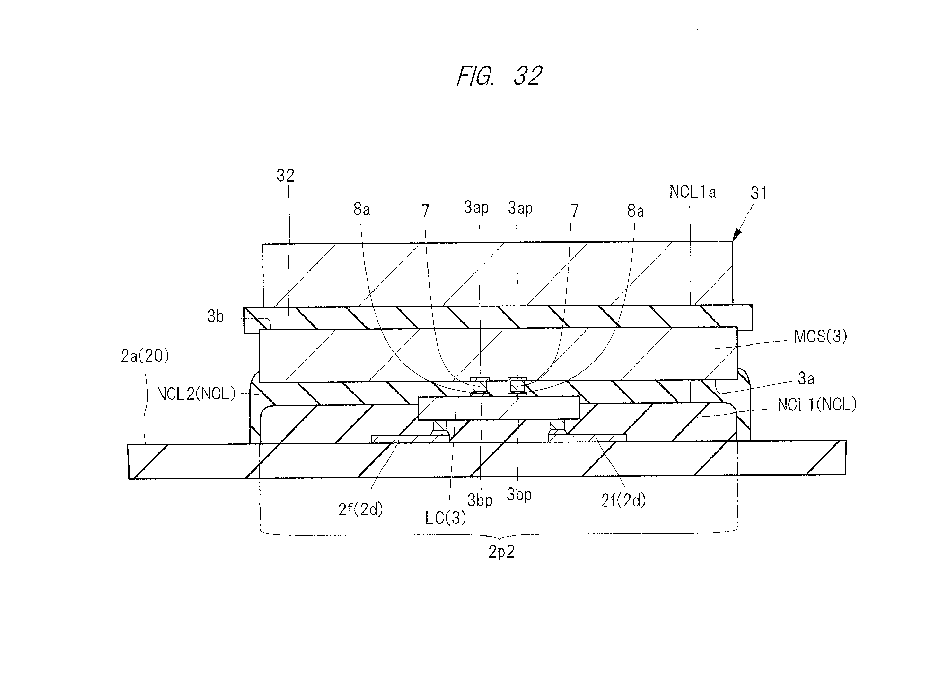

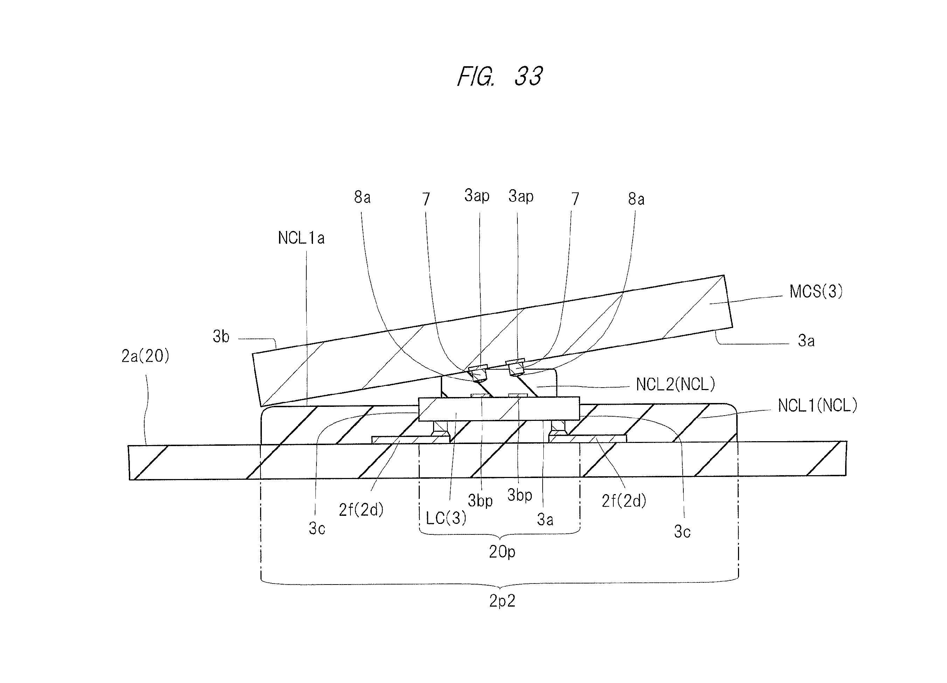

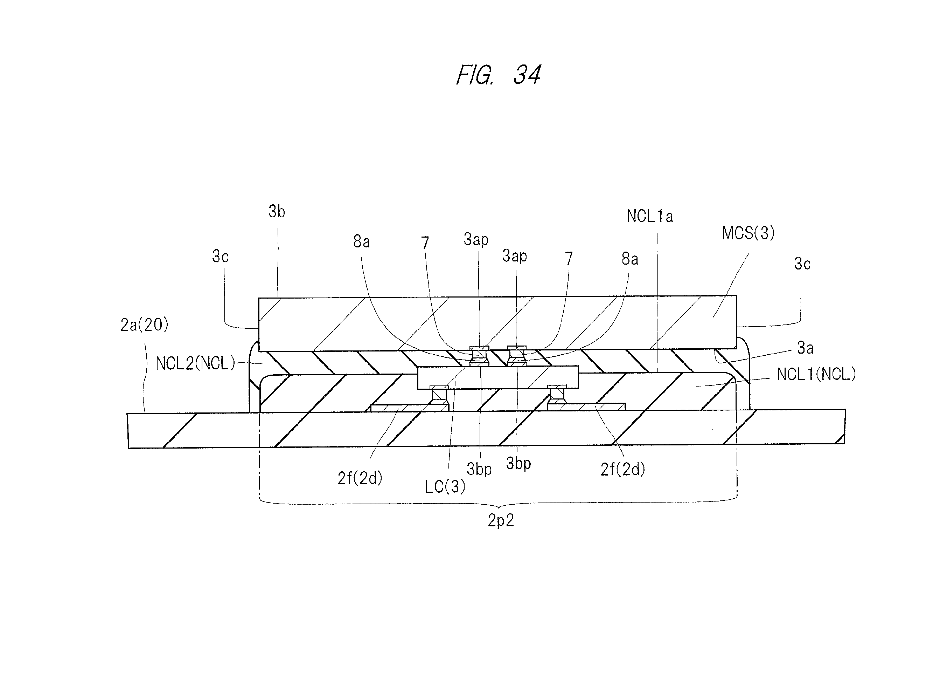

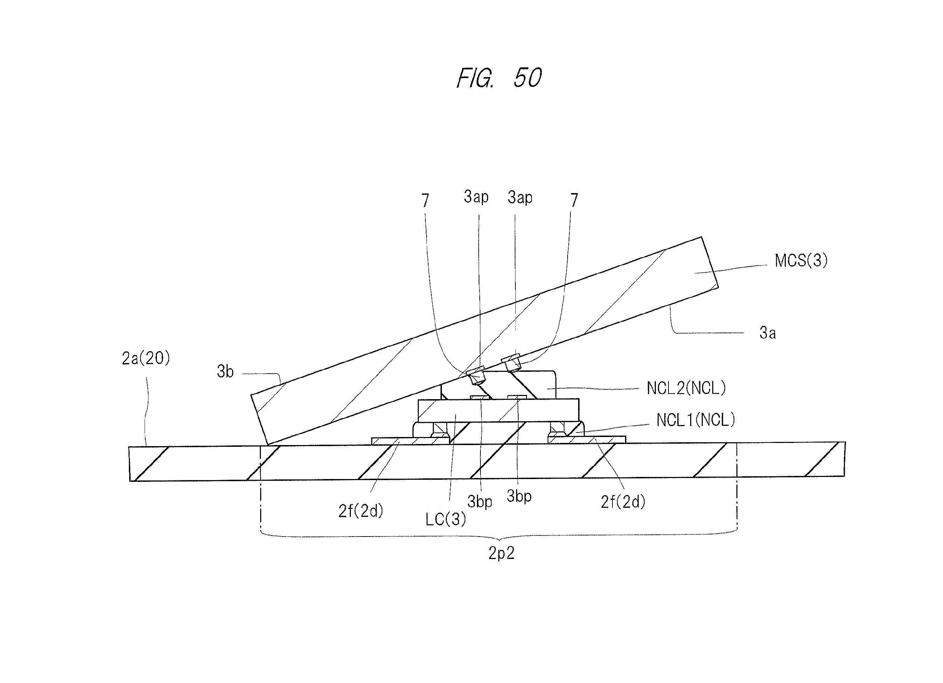

FIG. 31 to FIG. 34 are explanatory diagrams each illustrating a detailed flow of the second chip mounting process illustrated in FIG. 11. FIG. 31 is an explanatory diagram schematically illustrating the state in which the laminated body of the memory chips is mounted on the logic chip. FIG. 32 is an explanatory diagram illustrating the state in which a transportation jig illustrated in FIG. 31 is removed and a heating jig is pressed onto a back surface side of the laminated body. Also, FIG. 33 is an explanatory diagram illustrating the state in which the laminated body is tilted when the holding jig illustrated in FIG. 31 is removed. Furthermore, FIG. 34 is an explanatory diagram illustrating the state in which the laminated body is heated and electrically connected with the logic chip. Still further, FIG. 50 is an explanatory diagram illustrating the state in which the laminated body is tilted in another study example different from those in FIG. 31 to FIG. 34. FIG. 31 to FIG. 34 and FIG. 50 illustrate the laminated body MCS so as to be regarded as one semiconductor chip 3 for ease of viewing.

In the present process, first, as illustrated in FIG. 31, the laminated body MCS (semiconductor chip 3) is arranged on the back surface 3b of the logic circuit LC mounted on the wiring board 20. The laminated body MCS is transported onto the chip mount region 2p2 in a state in which the back surface 3b side is held by the holding jig 30, and is arranged on the bonding material NCL2 such that the front surface 3a of the laminated body MCS faces the back surface 3b of the logic chip LC. As the holding jig 30, the same as that in the first chip mounting process described by using FIG. 22 can be used. That is, the holding jig 30 has the holding surface 30a for absorbing and holding the back surface 3b of the laminated body MCS, and transports the laminated body MCS as being held on the holding surface 30a.

Also, the protruding electrodes 7 are formed on the front surface 3a side of the laminated body MCS, and the solder layer 8a (bonding material 8) is formed at the tips of the protruding electrodes 7 as described by using FIG. 27. Note that FIG. 31 exemplifies an aspect in which a bonding material is not arranged on the exposed surface of the back-surface electrodes 3bp. However, as a modified example, a bonding material (for example, a solder layer) not illustrated may be formed on the exposed surface of the back-surface electrode 3bp.

Furthermore, the adhesive material NCL2 at this stage is soft because this stage is before a heat treatment is performed. Therefore, the protruding electrodes 7 of the laminated body MCS arranged on the logic chip LC are buried (pushed) into the adhesive material NCL2 as illustrated in FIG. 31.

Next, as illustrated in FIG. 32, the heating jig 31 is pressed onto the back surface 3b side of the laminated body MCS to push the laminated body MCS toward the logic chip LC and the adhesive material NCL1. As similar to the adhesive material NCL1, the adhesive material NCL2 before the curing is soft before the heat treatment is performed. Therefore, when the laminated body MCS is pushed in by the heating jig 31, the laminated body MCS is brought closer to the logic chip LC. When the laminated body MCS is brought closer to the logic chip LC, the tips (more specifically, the solder layer 8a) of the plurality of protruding electrodes 7 formed on the front surface 3a of the laminated body MCS are brought into contact with the plurality of back-surface electrodes 3bp (or a bonding material not illustrated on the back-surface electrodes 3bp). Also, the adhesive material NCL2 with which the laminated body MCS and the logic chip LC are coated expands along the back surface 3b of the logic chip LC and the upper surface NCL1a a of the adhesive material NCL1, and the gap between the laminated body MCS and the wiring board 2 is closed by the adhesive material NCL1 and the adhesive material NCL2.

Here, according to studies by the inventors of the present application, it has been found that a case of mounting the laminated body MCS (semiconductor chip 3) with a large planar size on the logic chip with a small planar size has the following problems. That is, it has been found that, when the transportation jig illustrated in FIG. 31 is replaced to the heating jig 31 illustrated in FIG. 32, the laminated body MCS with a large planar size is tilted with the protruding electrode 7 as a base point in some cases.

For example, when the adhesive material NCL1 is arranged only between the logic chip LC and the wiring board 20 so as not to extend to the outer edge part of the chip mount region 2p2 as a modification example illustrated in FIG. 50, the laminated body MCS is tilted with the position of the protruding electrode 7 as a base point in some cases. A degree of such a tilt of the semiconductor chip 3 tends to increase when the plurality of protruding electrodes 7 are collectively arranged at a center part of the front surface 3a. This is because the balance of the laminated body MCS (semiconductor chip 3) tends to become more unstable in the case of the collective arrangement of the protruding electrodes 7 at the center part of the front surface 3a than the case of the arrangement of the protruding electrodes 7 at the outer edge part of the front surface 3a.

Also, when the laminated body MCS starts to be tilted, the degree of the tilt tends to increase until the laminated body MCS is in contact with another member. For example, in the example illustrated in FIG. 50, the outer edge part of the front surface 3a of the laminated body MCS is in contact with the upper surface 2a of the wiring board 20. When the laminated body MCS is tilted as illustrated in FIG. 50, the positions of the protruding electrodes 7 and the back-surface electrodes 3bp are shifted in some cases even if the laminated body MCS is held by the heating jig 31 illustrated in FIG. 32 in this tilted state.

Therefore, in the present embodiment, as illustrated in FIG. 33, the adhesive material NCL1 is arranged such that the adhesive material NCL1 covers a wider area than the chip mount region 2p1. In the example illustrated in FIG. 33, the adhesive material NCL1 is arranged so as to cover a portion in vicinity of the outer edge part of the chip mount region 2p2. Also, the adhesive material NCL1 has already been subjected to curing process before the second chip mounting process, and therefore, is harder than the adhesive material NCL2. Therefore, as illustrated in FIG. 33, the increase in the degree of the tilt can be stopped at the moment when the outer edge part of the front surface 3a of the laminated body MCS is in contact with the adhesive material NCL1. In other words, in the present embodiment, by arranging the adhesive material NCL1 so as to cover the portion in the vicinity of the outer edge part of the chip mount region 2p2, the degree of the tilt can be reduced even if the laminated body MCS is tilted.

As a result, as illustrated in FIG. 32, by pushing the heating jig 31 (and the resin film 32) onto the laminated body MCS, the tilt of the laminated body MCS can be recovered. At this time, if the degree of the tilt is small, the positional shift between the protruding electrodes 7 and the back-surface electrodes 3bp can be suppressed. As described above, by covering most of the chip mount region 2p2 where the laminated body MCS is scheduled to be mounted, the positional shift between the protruding electrodes 7 and the back-surface electrodes 3bp due to the tilt of the laminated body MCS is suppressed.

As described above, in view of suppressing the positional shift between the protruding electrodes 7 and the back-surface electrodes 3bp, the adhesive material NCL1 is preferably formed with a planar size and a thickness as much as the laminated body MCS and the adhesive material NCL1 are contact with each other first when the laminated body MCS (semiconductor chip 3) is tilted with the protruding electrode 7 as the base point. More specifically, the outer edge part of the adhesive material NCL1 is preferably arranged at a position closer to the outer edge part of the chip mount region 2p2 than the outer edge part of the chip mount part 2p1. Also, the adhesive material NCL1 is preferably arranged so as to cover the entire chip mount region 2p2. On the other hand, when the arrangement range of the adhesive material NCL1 (planar size of the adhesive material NCL1) is significantly larger than the chip mount region 2p1, a use amount of the adhesive material NCL1 increases. Also, control for the expansion range of the adhesive material NCL2 is rather difficult. Therefore, it is particularly preferred that the arrangement range of the adhesive material NCL1 (planar size of the adhesive material NCL1) is almost equal to the chip mount region 2p2 in a size.

Also, the thickness of the adhesive material NCL1 is preferably as large as more than half of the side surface 3c of the logic chip LC on the front surface 3a side of the logic chip LC is covered with the adhesive material NCL1. In other words, when seen in a cross-sectional view, the adhesive material NCL1 is preferably formed such that the upper surface NCL1a of the adhesive material NCL1 is positioned so as to be closer to the back surface 3b side of the logic chip LC than the center part (half in height) of the side surface 3c of the logic chip LC. However, when the back surface 3b side of the logic chip LC is covered with the adhesive material NCL1, this covering becomes interruption when the back-surface electrodes 3bp and the protruding electrodes 7 are electrically connected with each other. Therefore, the height of the upper surface NCL1a a of the adhesive material NCL1 is preferably as high as possible within a range equal to or lower than the back surface 3b of the logic chip LC.

From this point of view, as described above, an insulator film (NCF) which is advantageous in that the arrangement range and the thickness can be easily controlled is preferably used as the adhesive material NCL1.

Also, as illustrated in FIG. 32, when the heating jig 31 is pushed onto the laminated body MCS to expand the adhesive material NCL2, stress applied to the logic chip LC is preferably reduced. By widening the arrangement range of the cured adhesive material NCL1, load on the logic chip LC can be dispersed to the adhesive material NCL1 side. Therefore, the arrangement range of the cured adhesive material NCL1 is preferably widened in view of reducing stress on the logic chip in the second chip mounting process.

In the example illustrated in FIG. 32, note that the back-surface electrodes 3bp are not formed in the laminated body MCS. Therefore, an aspect without interposing the resin film 32 between the heating jig 31 illustrated in FIG. 32 and the laminated body MCS can be applied as a modification example. However, by using the same mount devices (the holding jig 30, the heating jig 31, and the resin film 32) between the first chip mounting process and the second chip mounting process illustrated in FIG. 11, complication of the manufacturing device can be suppressed. Therefore, as similar to the first chip mounting process, the laminated body MCS is preferably pushed by the heating jig 31 through the resin film 32.

Also, as illustrated in FIG. 50, the gap between the laminated body MCS and the wiring board 20 can be filled even when the arrangement range of the adhesive material NCL1 is small. That is, as described above, as long as the positions of the protruding electrodes 7 and the back-surface electrodes 3bp are not shifted, the aspect illustrated in FIG. 50 can be applied as a modification example. Even in this case, by increasing the coating amount (arrangement degree) of the adhesive material NCL2, the gap between the laminated body MCS and the wiring board 20 can be filled with the adhesive material NCL2 outside the region where the adhesive material NCL1 is arranged. However, more particularly, when the insulator paste (NCP) is used as the adhesive material NCL2, it is difficult to control the expansion range due to the increase in the coating amount. Therefore, in view of controlling the arrangement range of the adhesive material NCL2 to reliably fill the gap between the laminated body MCS and the wiring board 20, the outer edge part of the adhesive material NCL1 is preferably arranged at a position closer to the outer edge part of the chip mount region 2p2 than the outer edge part of the chip mount region 2p1 as illustrated in FIG. 33.

Next, in the state in which the laminated body MCS is pushed onto the heating jig 31 as illustrated in FIG. 33, the logic chip LC and the adhesive material NCL2 are heated by the heating jig (heating source) 31. The solder layer 8a illustrated in FIG. 33 is melted at the bonding part between the laminated body MCS and the logic chip LC, and wets the back-surface electrodes 3bp so as to be the bonding material (solder material) 8 illustrated in FIG. 34. That is, by heating the laminated body MCS by the heating jig (heating source) 31, the protruding electrodes 7 of the laminated body MCS and the back-surface electrodes 3bp of the logic chip LC are electrically connected with each other via the bonding material 8.

On the other hand, by heating the adhesive material NCL1 by the heating jig (heating source) 31 illustrated in FIG. 32, the adhesive material NCL1 is cured (temporarily cured). In this manner, as illustrated in FIG. 34, the gap between the laminated body MCS and the wiring board 20 is filled with the cured adhesive material NCL1 and adhesive material NCL2. A part of the side surfaces 3c of the laminated body MCS on the front surface 3a side is covered with the adhesive material NCL2. Therefore, adhesive strength between the laminated body MCS and the logic chip LC can be improved. Note that it is not required to completely cure the adhesive material NCL2 by heat from the heating jig (heating source) 31 illustrated in FIG. 32, and an aspect can be employed, the aspect of partially curing (temporarily curing) a thermosetting resin contained in the adhesive material NCL2 as hard as the logic chip LC can be fixed, and then, transporting the wiring board 20 to a heating furnace not illustrated, and curing (completely curing) the remaining thermosetting resin. Although it takes time until the complete curing process which cures the entire thermosetting resin components contained in the adhesive material NCL2 is completed, manufacturing efficiency can be improved by performing the complete curing process in the heating furnace.

### <Sealing Process>

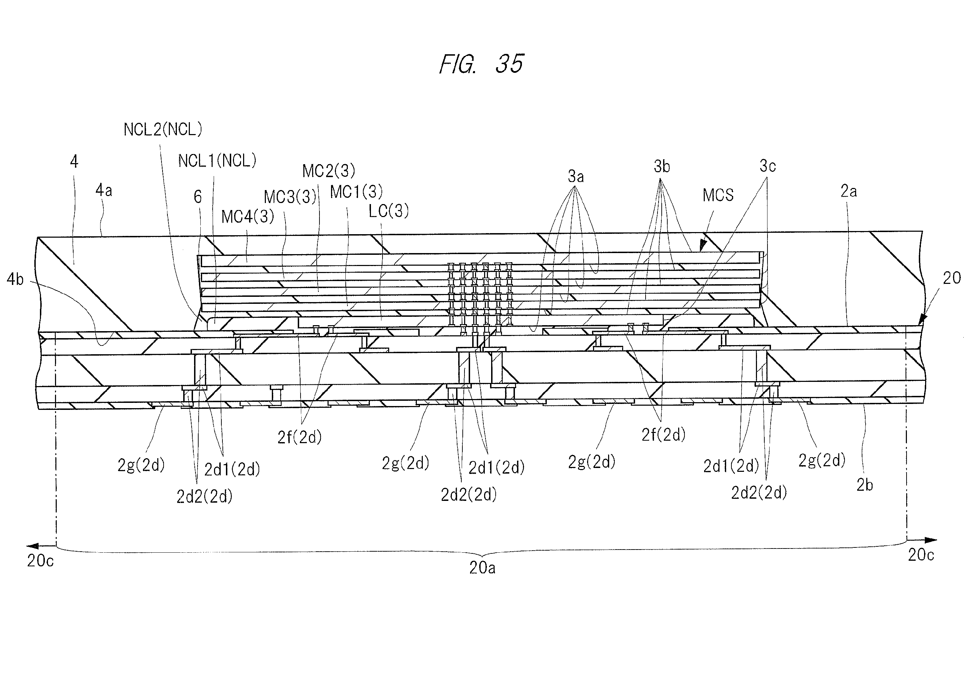

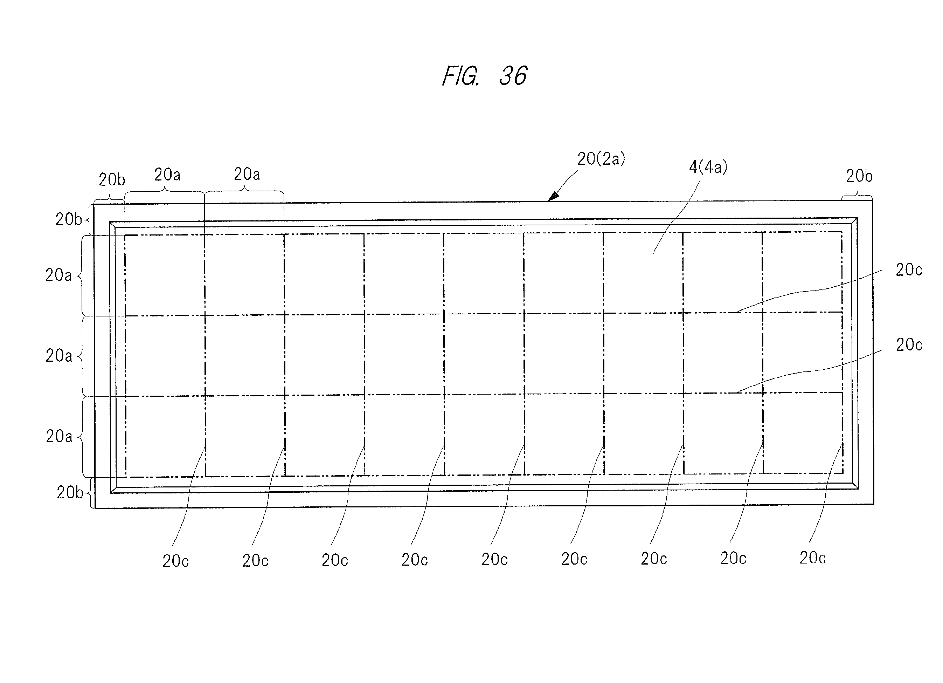

Next, in the sealing process illustrated in FIG. 11, as illustrated in FIG. 35, the upper surface 2a of the wiring board 20, the logic chip LC and the laminated body MCS formed of the plurality of memory chips MC1, MC2, MC3, and MC4 are sealed with the resin to form the sealed body 4. FIG. 35 is an enlarged cross-sectional view illustrating the state in which a sealing body is formed on the wiring board illustrated in FIG. 30 to seal the plurality of laminated semiconductor chips. Also, FIG. 36 is a plan view illustrating an entire structure of the sealing body illustrated in FIG. 35.

In the present embodiment, as illustrated in FIG. 36, the sealing body 4 which collectively seals the plurality of device regions 20a is formed. A method of forming such a sealing body 4 is referred to as a block molding method, and a semiconductor package manufactured by this block molding method is referred to as a MAP (Multi Array Package)-type semiconductor device. In the block molding method, the gap between the device regions 20a can be decreased, and therefore, an effective area in one wiring board 20 is increased. That is, the number of products that can be obtained from one wiring board 20 is increased. In this manner, by increasing the effective area in one wiring board 20, efficiency of the manufacturing process can be enhanced.

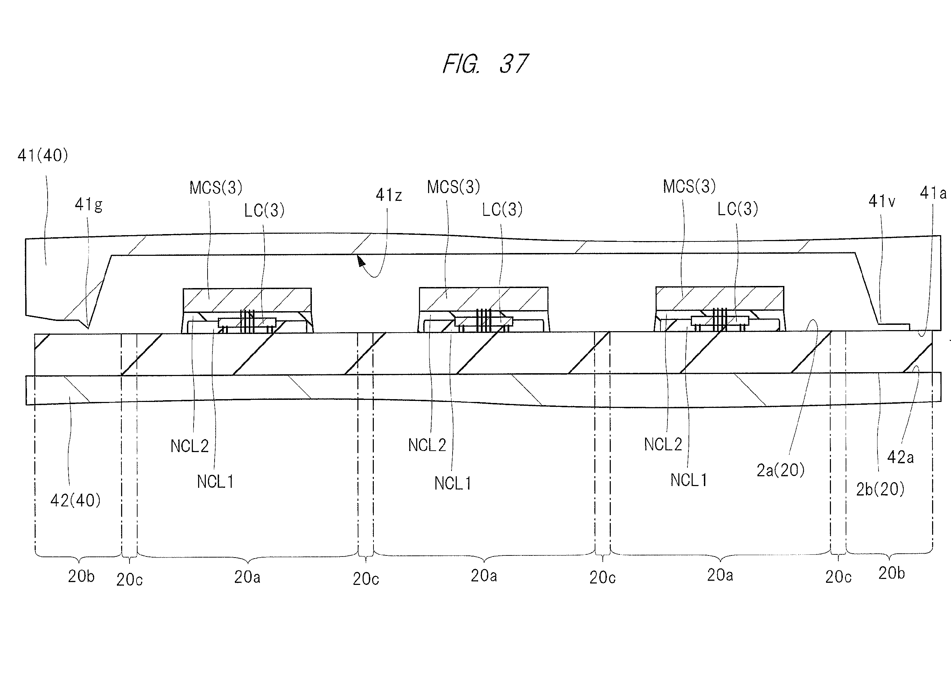

Also, in the present embodiment, the sealing body is formed by a so-called transfer mold method of pressing and fitting the heated and softened resin to be molded, and then, thermally curing the resin. The sealing body 4 formed by the transfer mold method has higher durability than that of the sealing body obtained by curing a liquid resin such as the sealing body 6 for sealing the laminated body MCS illustrated in FIG. 35, and therefore, is suitable as a protective member. Furthermore, for example, by mixing filler particles such as silica (silicon dioxide; SiO₂) particles into the thermosetting resin, the function (for example, resistance against warpage deformation) of the sealing body 4 can be improved. Hereinafter, a detailed flow of this process will be described by using FIG. 37 to FIG. 40.

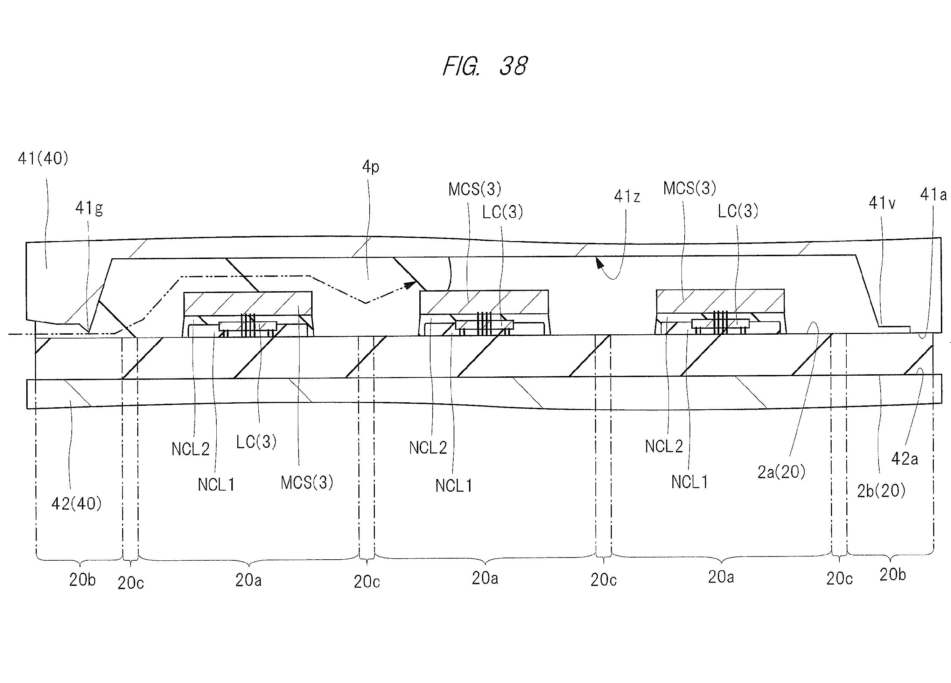

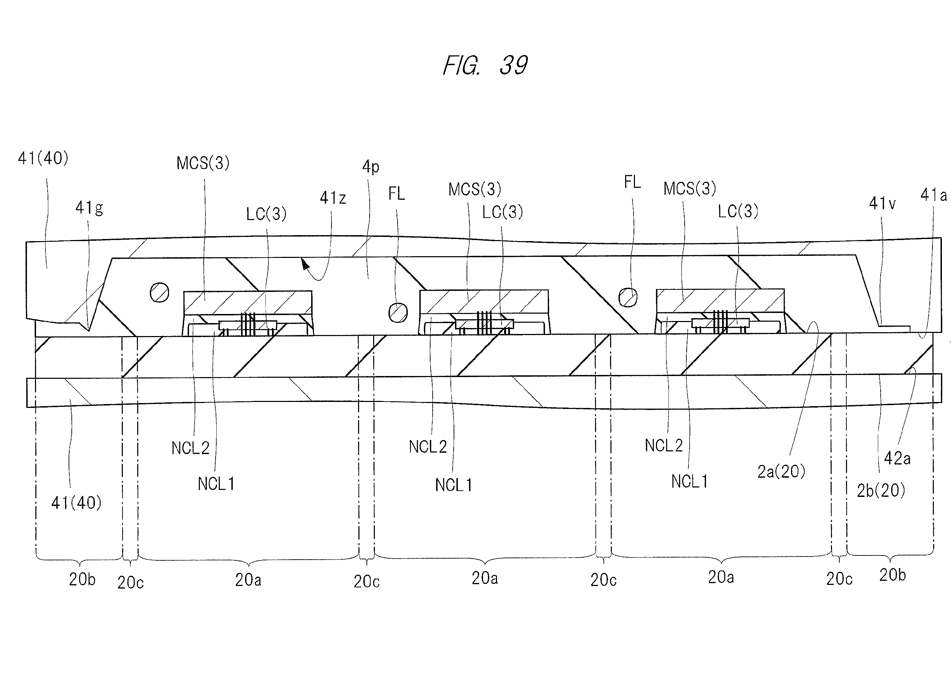

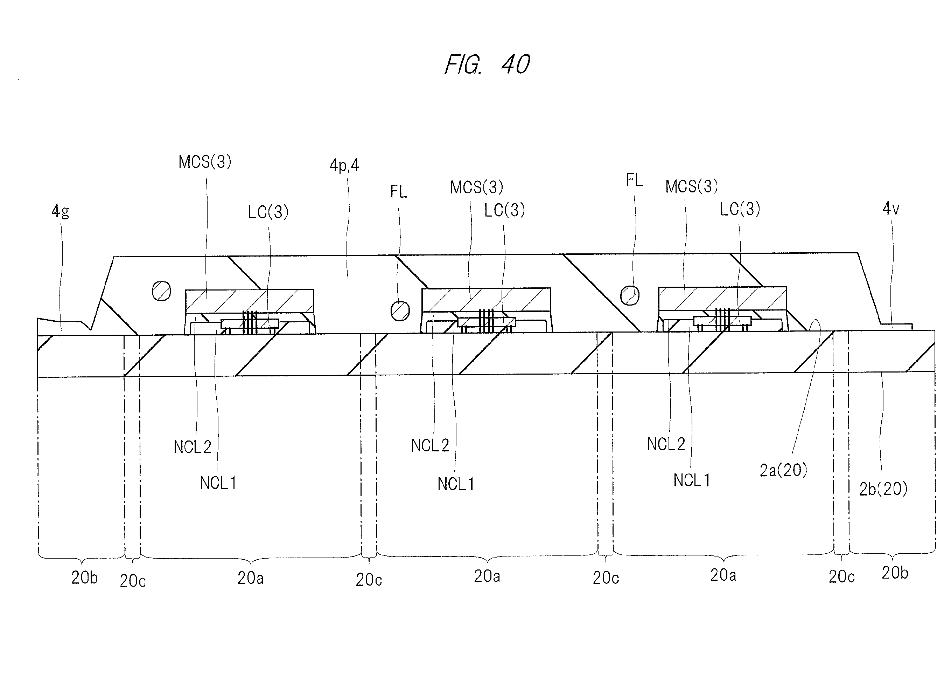

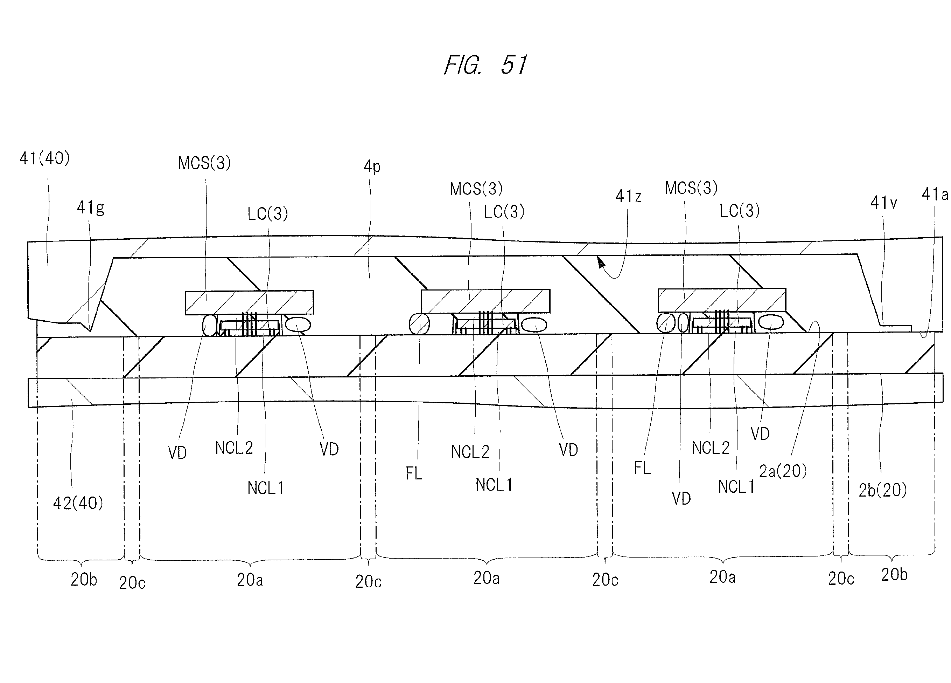

FIG. 37 to FIG. 40 are explanatory diagrams each illustrating a detailed flow of the sealing process illustrated in FIG. 11. FIG. 37 is a cross-sectional view of a principal part illustrating the state in which the wiring board illustrated in FIG. 30 is arranged inside a forming mold (die) for molding the sealing body. Also, FIG. 38 is a cross-sectional view of a principal part illustrating the state in which the resin is supplied into the forming mold illustrated in FIG. 37, and FIG. 39 is a cross-sectional view of a principal part illustrating the state in which the forming mold illustrated in FIG. 37 is filled with the resin. Furthermore, FIG. 40 is a cross-sectional view of a principal part illustrating the state in which the wiring board illustrated in FIG. 39 is removed from the forming mold. Still further, FIG. 51 is a cross-sectional view of a principal part illustrating a study example of FIG. 39. FIG. 37 to FIG. 40 and FIG. 51 illustrate the laminated body MCS so as to be regarded as one semiconductor chip 3 for ease of viewing.

In the present process, a forming mold 40 illustrated in FIG. 37 is prepared (in the mold preparing process). The forming mold 40 is a mold for molding the sealing body 4 illustrated in FIG. 35, and is provided with an upper mold (mold) 41 having a lower surface (mold surface) 41a and a cavity (a concave part or a dent part) 41z formed in the lower surface 41a. Also, the forming mold 40 also is provided with a lower mold (mold) 42 having an upper surface (mold surface) 42a facing the lower surface (mold surface) 41a of the upper mold 41.

The cavity 41z is a trench (dent part) having a truncated quadrangular pyramid shape when seen in a plan view, which includes a bottom surface and four side surfaces. Also, in the upper mold 41, each of a gate part 41g which is a supply port of resin 4p (see FIG. 38) to the cavity 41z and a vent part 41v arranged at a position different from that of the gate part 41g (for example, a position facing thereto) is formed. The gate part 41g is formed on, for example, one side surface of the cavity 41z. Also, the vent part 41v is formed on a side surface of the cavity 41z different from that of the gate part 41g. As described above, a method of arranging a gate part on a side surface of the cavity 41z is referred to as a side gate method.

Next, the wiring board 20 is arranged on the lower mold 42 of the forming mold 40 (in the base material arranging process). Here, the cavity 41z formed in the upper mold 41 to be combined with the lower mold 42 has an area larger than that of each device region 20a of the wiring board 20, and one cavity 41z is arranged so as to cover the plurality of device regions 20a. In other words, an outer edge part of the cavity 41z is arranged on the frame part 20b of the wiring board 20.

Next, the distance between the upper mold 41 and the lower mold 42 is shortened such that the wiring board 20 is clamped by the upper mold 41 and the lower mold 42 the upper mold 41 (in the clamping process). In this manner, the upper mold 41 (the lower surface 41a of the upper mold 41) and the upper surface 2a of the wiring board 20 are brought into closely contact with each other in regions except for the inside of the cavity 41z, the gate part 41g, and the vent 41v. Also, the lower mold 42 (the upper surface 42a of the lower mold 42) and the lower surface 2b of the wiring board 20 are brought into closely contact with each other.

Next, as illustrated in FIG. 38, the resin 4p is supplied into the cavity 41z and is cured so as to form the sealing body 4 (in the sealing body forming process). In this process, a resin tablet arranged in a pot part not illustrated is heated and softened so as to supply the resin 4p from the gate part 41g into the cavity 41z. The resin tablet contains, for example, an epoxy-based resin which is a thermosetting resin as a main component, and has characteristics of improving fluidity because of being softened by heat at a temperature lower than a curing temperature. Therefore, for example, when the softened resin tablet is pushed by a plunger not illustrated, the softened resin 4p is pressed and fitted from the gate part 41g formed in the forming mold 40 into the cavity 41z (more specifically, onto the upper surface 2a of the wiring board 20) as indicated with a two-dot-chain arrow in FIG. 38. The gas in the cavity 41z is discharged from the vent part 41b by a pressure caused by the inflow of the resin 4p, such that the inside of the cavity 41z is filled with the resin 4p. As a result, the plurality of semiconductor chips 3 (the logic chip LC and the laminated body MCS) mounted on the upper surface 2a side of the wiring board 20 are collectively sealed with the resin 4p as illustrated in FIG. 39. Then, by heating the inside of the cavity 41z, at least a part of the resin 4p is heated and cured (temporarily cured).

Here, according to studies by the inventors of the present application, it has been found that a case with a gap not sealed with the adhesive material NCL1 or NCL2 between the laminated body MCS and the wiring board 20 as illustrated in FIG. 51 has the following problems in view of reliability of the semiconductor device. That is, as illustrated in FIG. 51, it has been found that air bubble (void) VD in which a gap between the laminated body MCS and the wiring board 20 is not filled with the resin 4p tends to occur. If the air bubble VD is left between the laminated body MCS and the logic chip LC in the semiconductor device as a completed product, the sealing body tends to be broken when heat is applied to the semiconductor device. That is, this causes degradation in reliability.

The inventors of the present application have further studied the reason why the air bubble VD as described above tends to occur. As a result, when the logic chip LC illustrated in FIG. 51 is replaced by a semiconductor chip without the through electrodes 3tsv as illustrated in FIG. 5, the occurrence of such air bubble VD as causing the degradation in the reliability has not been observed. That is, it has been found that the above-described phenomenon of the tendency of the occurrence of the air bubble VD is a problem which particularly becomes obvious when the logic chip LC having the through electrodes 3tsv formed therein is mounted on a lower stage side.

It is considered that the cause of the tendency of the occurrence of the air bubble VD relates to a separated distance between the laminated body MCS mounted on an upper stage side and the wiring board 20. In the case of the semiconductor chip having no through electrode 3tsv formed therein, the semiconductor chip has a thickness of about 100 µm even if the semiconductor chip is thin because a relativity between the thickness of the semiconductor chip and electrical characteristics is low. On the other hand, in the case of the logic chip LC having the through electrode 3tsv formed therein as illustrated in FIG. 5, the height of the through electrode 3tsv (a length of the logic chip LC in the thickness direction) is smaller as the thickness of the logic chip LC is thinner, and therefore, impedance of a conductive path connecting the front-surface electrode 3ap with the back-surface electrode 3bp, respectively, can be decreased. By decreasing the height of the through electrode 3tsv, processing accuracy is improved, and therefore, circuit integration can be enhanced. Therefore, the thickness of the logic chip LC is thinner than the semiconductor chip without the through electrode 3tsv. Furthermore, a gap G2 which is a separated distance between the laminated body MCS mounted on the logic chip LC and the wiring board 2 (wiring board 20 illustrated in FIG. 51) is decreased in accordance with the thickness T1 of the logic chip LC, and therefore, the gap 2 is also decreased. For example, the thickness T1 of the logic chip LC and the gap G2 which have been studied by the inventors of the present application are 50 µm and about 70 µm to 100 µm, respectively.

Also, in order to bury the resin 4p into the gap between the laminated body MCS and the wiring board 20, it is required to bring the resin 4p to go around so as to surround the logic chip LC on the lower stage side and the adhesive material NCL1 and NCL2 in the periphery of the logic chip. However, if the gap between the laminated body MCS and the wiring board 20 is narrow, static pressure resistance (conductance) is increased. More particularly, the resin 4p (see FIG. 38) for use in the transfer mold method has a higher viscosity than that of the liquid underfill resin 6a described by using FIG. 28, and therefore, is difficult to be supplied into a narrow space. Also, increase in a supply pressure of the resin 4p causes a damage to the semiconductor chip 3.

Still further, when a gap in which the adhesive material NCL1 or NCL2 is not filled exists between the laminated body MCS and the wiring board 20 as illustrated in FIG. 51, filler particles having a larger particle diameter among the plurality of filler particles FL mixed into the resin 4p get stuck in the gap in some cases. When the filler particles FL get stuck between the laminated body MCS and the wiring board 20, this blocks the passage of the resin 4p to cause the occurrence of the air bubble VD. Moreover, the filler particle FL are pressed onto the front surface 3a (see FIG. 5) of the laminated body MCS to cause damage to the laminated body MCS in some cases.

By dispersing the plurality of filler particles FL into the resin 4p, the functionality of the sealing body 4 (see FIG. 35) can be improved. However, there are various particle diameters of the filler particles FL, and there is the filler particle FL having a large particle diameter of, for example, about 100 µm as the large particle diameter. Therefore, if the gap G2 (see FIG. 5) between the wiring board 20 and the laminated body MCS is as small as about 70 µm to 100 µm, the filler particles FL get stuck in the gap between the wiring board 20 and the laminated body MCS in some cases. As a method of preventing the phenomenon in which the filler particles FL get stuck, a method of previously sorting the filler particles FL to be mixed into the resin 4p so as to remove the filler particle FL having a large particle diameter is considered. However, in this case, it takes time for an operation of sorting the filler particles FL. Moreover, if the filler particle FL having a large particle diameter cannot be contained in the resin 4p, flexibility of material selection is reduced. Therefore, for example, even if the filler particles FL having a particle diameter exceeding 80 µm are contained in the resin 4p, it is preferable to prevent the filler particles FL from getting stuck between the wiring board 20 and the laminated body MCS.

Therefore, the present embodiment employs a structure that the space between a portion of the laminated body MCS not overlapping the logic chip LC and the upper surface 2a of the wiring board 20 is previously filled with the adhesive material NCL1 and the adhesive material NCL2 before the sealing process. That is, a region (gap) where the air bubble VD illustrated in FIG. 51 occurs or a region (gap) where the filler particles FL tend to get stuck is previously removed before the sealing process. As a result, as illustrated in FIG. 39, the occurrence of the air bubble VD (see FIG. 51) can be prevented or suppressed. Also, for example, even if the filler particles FL having a particle diameter exceeding 80 µm are contained in the resin 4p, the getting stuck of the filler particles FL between the wiring board 20 and the laminated body MCS can be prevented.

Note that the member between the wiring board 20 and the laminated body MCS may be either one of the adhesive material NCL1 and the adhesive material NCL2 in view of the suppression of the occurrence of the air bubbles VD illustrated in FIG. 51 and the damage to the laminated body MCS by the filler particles FL. However, as described above, in view of controlling the arrangement positions of the adhesive materials NCL1 and NCL2 and reliably filling the gap between the wiring board 20 and the laminated body MCS, it is particularly preferable to fill the gap with both of the adhesive materials NCL1 and NCL2. That is, as described above by using FIG. 16 and FIG. 17, in the first adhesive-material arranging process, the outer edge part of the adhesive material NCL1 is preferably arranged at a position closer to the outer edge part of the chip mount region 2p2 than the outer edge part of the chip mount region 2p1. Also, in the second adhesive-material arranging process, the thickness of the adhesive material NCL1 is preferably as large as more than half of the side surface 3c of the logic chip LC on the front surface 3a side of the logic chip LC is covered with the adhesive material NCL1 in view of reducing the coating amount of the adhesive material NCL2 to easily control the arrangement range of the adhesive material NCL2.

Next, as illustrated in FIG. 40, the wiring board 20 having the sealing body 4 formed therein is removed from the forming mold 40 used in the sealing body forming process described above (in the board removing process). In this process, the upper mold 41 and the lower mold 42 illustrated in FIG. 39 are separated from each other to remove the wiring board 20.

Next, the wiring board 20 removed from the forming mold 40 is transported to the heating furnace (baking furnace) not illustrated, and the wiring board 20 is subjected to a heat treatment again (in the baking process or the complete curing process). The resin 4p heated in the forming mold 40 becomes in a state which is so-called temporary curing in which more than half (for example, about 70% or higher) of the curable components in the resin are cured. In this temporary curing state, not all of the curable components in the resin 4p are cured but more than half of the curable components are cured. At this moment, the semiconductor chip 3 is sealed. However, in view of stability in strength of the sealing body 4 or others, it is preferable to completely cure all of the curable components, and therefore, the so-called complete curing which heats the temporarily-cured sealing body 4 again is performed in the baking process. In this manner, by dividing the process of curing the resin 4p so as to be performed twice, the wiring board 20 transported to the forming mold 40 next can be subjected to the sealing process as soon as possible. Therefore, the manufacturing efficiency can be improved.

Also, as illustrated in FIG. 40, a gate part resin 4g and a vent part resin 4v are left at the outer edge part of the sealing body 4 (on the frame part 20b). By removing the gate part resin 4g and the vent part resin 4v as required, the sealing body (resin body) 4 for collectively sealing the plurality of semiconductor chips 3 (see FIG. 35) mounted on the plurality of respective device regions 20a is formed as illustrated in FIG. 36. However, since the gate part resin 4g and the vent part resin 4v are formed on the frame part 20b to be removed in a singulation process described later, a process of removing these resins can be omitted.

### <Ball Mounting Process>

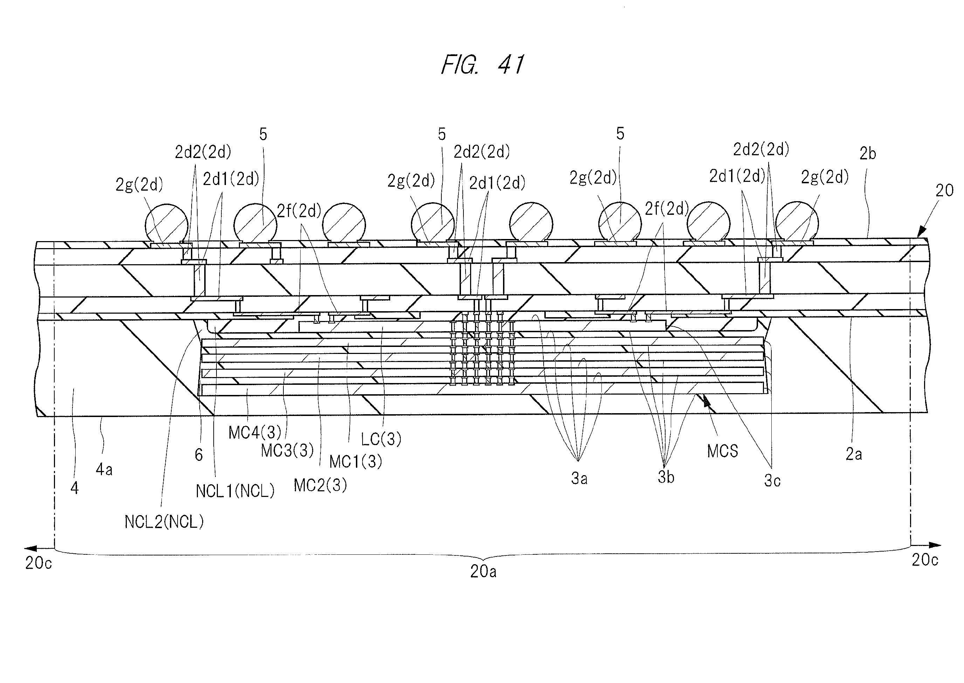

Next, in a ball mounting process illustrated in FIG. 11, as illustrated in FIG. 41, the plurality of solder balls 5 to be external terminals are bonded to the plurality of lands 2g formed on the lower surface 2b of the wiring board 20. FIG. 41 is an enlarged cross-sectional view illustrating the state in which the solder balls are bonded to the plurality of lands of the wiring board illustrated in FIG. 35.

In the present process, after the wiring board 20 is reversed upside down as illustrated in FIG. 41, the solder balls 5 are arranged on the plurality of lands 2g exposed from the lower surface 2b of the wiring board 20, and then, the plurality of solder balls 5 and lands 2g are bonded together by heating. In the present process, the plurality of solder balls 5 are electrically connected with the plurality of semiconductor chips 3 (the logic chip LC and the memory chips MC1, MC2, MC3, and MC4) via the wiring board 20. However, the technique described in the present embodiment is not exclusively applied to a so-called BGA (Ball Grid Array)-type semiconductor device in which the solder balls 5 are bonded in an array form. For example, as a modification example of the present embodiment, the technique can be applied to a so-called LGA (Land Grid Array)-type semiconductor device shipped in a state in which the lands 2g are exposed without forming the solder balls 5 or a state in which the lands 2g are coated with a solder paste thinner than the solder balls 5. In the case of the LGA-type semiconductor device, the ball mounting process can be eliminated.

### <Singulation Process>

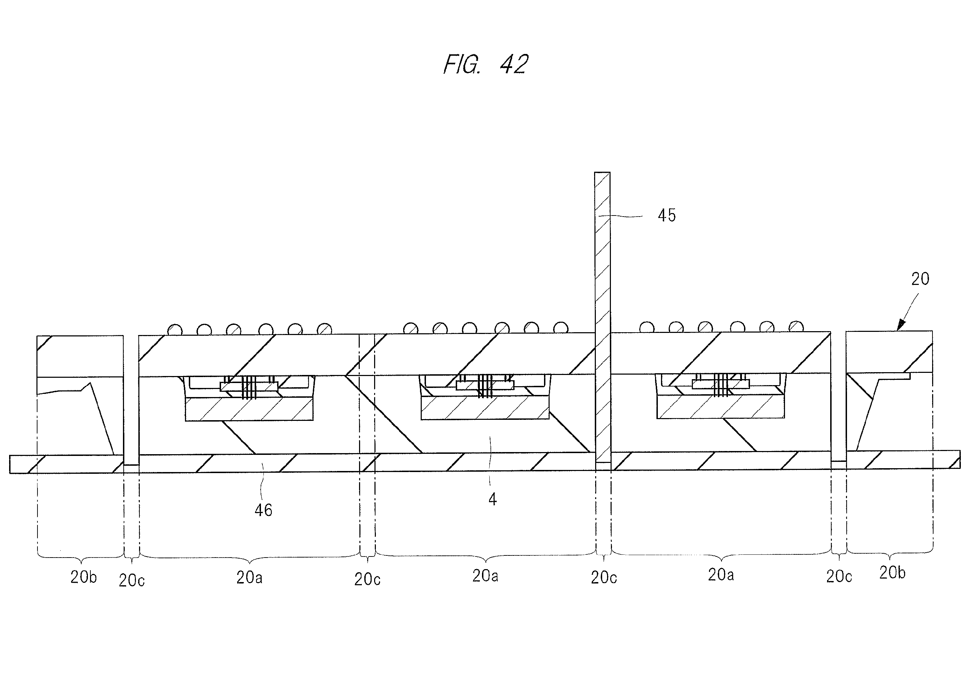

Next, in the singulation process illustrated in FIG. 11, the wiring board 20 is separated into the device regions 20a as illustrated in FIG. 42. FIG. 42 is a cross-sectional view illustrating the state in which a multiple-piece-taking wiring board illustrated in FIG. 41 is singulated. In this process, as illustrated in FIG. 31, the wiring board 20 and the sealing body 4 are cut out along a dicing line (dicing region) 20c to obtain a plurality of singulated semiconductor devices 1 (see FIG. 4). While a cutting method is not particularly limited, the example illustrated in FIG. 42 shows an aspect in which the wiring board 20 and the sealing body 4 bonded and fixed to a taping material (dicing tape) 46 are cut by a cutting process from the lower surface 2b side of the wiring board 20 by using a dicing blade (rotating blade) 45. However, the technique described in the present embodiment is not exclusively applied to the case of usage of the wiring board 20 which is a multiple-piece-taking board including the plurality of device regions 20a. For example, the technique can be applied to a semiconductor device obtained by laminating the plurality of semiconductor chips 3 on the wiring board 2 (see FIG. 4) corresponding to one semiconductor device. In this case, the singulation process can be eliminated.

By the processes described above, the semiconductor device 1 described by using FIG. 1 to FIG. 10 is obtained. Then, the semiconductor device is subjected to any necessary inspection and test such as a visual inspection and an electrical test, and then, is shipped or is mounted on a mounting board not illustrated.

### (Modification Example)

In the foregoing, the invention made by the present inventors has been concretely described based on the embodiments. However, it is needless to say that the present invention is not limited to the foregoing embodiments and various modifications and alterations can be made within the scope of the present invention.

### <First Modification Example>

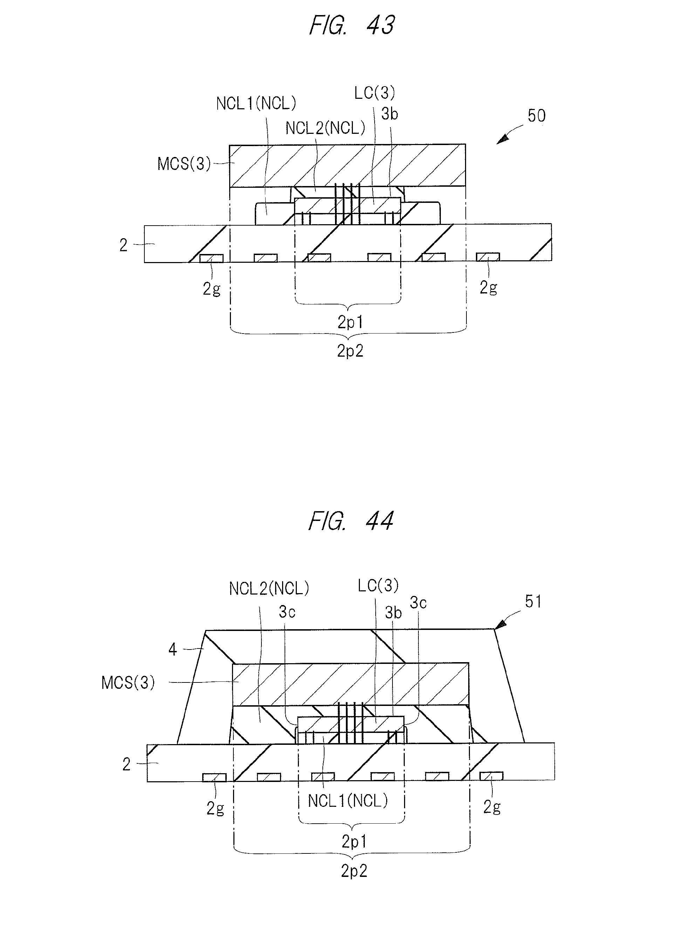

For example, in the above-described embodiment, as problems in view of reliability of the semiconductor device, the explanation has been made for the concern in the second chip mounting process about the positional shift between the protruding electrodes 7 and the back-surface electrodes 3bp caused by the tilt of the laminated body MCS having a large planar size with the protruding electrode 7 as the base point. Also, the explanation has been made for another concern in the sealing process about the formation of the air bubble VD in the gap between the laminated body MCS and the wiring board 20. Further, the explanation has been made for still another concern in the sealing process about the damage to the laminated body MCS caused when the filler particles FL having a large particle diameter (for example, larger than the separated distance between the laminated body MCS and the wiring board 20) gets stuck in the gap between the laminated body MCS and the wiring board 20. A point having the relativity to the reliability of the semiconductor device is common in these problems, and a main countermeasure which arranges the adhesive material NCL in a range wider than the chip mount region 2p1 for the logic chip LC is common in these problems. Strictly speaking, however, the minimum structures for solving of these problems are different from each other. FIG. 43 and FIG. 44 are cross-sectional views of principal parts each illustrating general outlines of a modification example of the semiconductor device 1 described in the above-described embodiment.

First, a semiconductor device 50 illustrated in FIG. 43 can be considered as a structure for solving the concern about the positional shift between the protruding electrodes 7 and the back-surface electrodes 3bp due to the tilt of the laminated body MCS with the protruding electrode 7 as the base point described in the second chip mounting process. The semiconductor device 50 is different from the semiconductor device 1 illustrated in FIG. 4 in a point with a gap between the laminated body MCS and the wiring board 20. Also, the semiconductor device 50 is also different from the semiconductor device 1 illustrated in FIG. 4 in that the sealing body 4 illustrated in FIG. 4 is not formed. In other words, in a method of manufacturing the semiconductor device 50, the sealing process described in the above-described embodiment is eliminated.

That is, since the sealing process is eliminated in the case of the method of manufacturing the semiconductor device 50, the problems described in the sealing process does not occur. Therefore, it is only required to perform at least a countermeasure which suppresses the degree of the tilt of the laminated body MCS with the protruding electrodes7 (see FIG. 33) as the base point. Therefore, when the laminated body MCS (semiconductor chip 3) is tilted with the protruding electrode 7 as the base point, it is only required to form the adhesive material NCL1 so as to have a planar size and a thickness as large as the laminated body MCS and the adhesive material NCL1 are brought in contact with each other first. More specifically, the outer edge part of the adhesive material NCL1 is arranged at a position closer to the outer edge part of the chip mount region 2p2 than the outer edge part of the chip mount region 2p1. Also, the thickness of the adhesive material NCL1 is preferably as large as more than half of the side surface 3c of the logic chip LC on the front surface 3a side of the logic chip LC is covered with the adhesive material NCL1 as illustrated in FIG. 43. In other words, the adhesive material NCL1 is preferably formed such that the upper surface NCL1a of the adhesive material NCL1 is positioned to be closer to the back surface 3b side of the logic chip LC than the center part (half in height) of the side surface 3c of the logic chip LC. Alternatively, the adhesive material NCL1 is preferably formed such that the upper surface NCL1a of the adhesive material NCL1 is positioned at a height equal to the back surface 3b of the logic chip LC. However, in view of more reliably suppressing the degree of the tilt of the laminated body MCS with the protruding electrode 7 (see FIG. 33) as the base point, the adhesive material NCL1 is preferably arranged so as to cover the entire chip mount region 2p2. Still further, in the second chip mounting process described above, in view of more reliably suppressing the tilt of the semiconductor chip 2, the adhesive material NCL1 is preferably arranged so as to cover most of the chip mount region 2p2 as described by using FIG. 33.

On the other hand, for example, the adhesive material NCL2 can be arranged on the back surface 3b of the logic chip LC as illustrated in FIG. 43 since the arrangement range of the adhesive material NCL2 has a smaller influence on the tilt of the laminated body MCS than the arrangement range of the adhesive material NCL1. However, in view of improving adhesive strength by the adhesive material NCL2, the adhesive material NCL2 is preferably arranged also on the back surface 3b of the logic chip LC and the exposed surface (the exposed surface of the portion exposed from the logic chip LC) of the adhesive material NCL1 as illustrated in FIG. 32 described in the above-described embodiment.

### <Second Modification Example>

Next, a semiconductor device 51 illustrated in FIG. 44 can be considered as a structure for solving the concern about the formation of the air bubble VD in the gap between the laminated body MCS and the wiring board 20 or the concern about the getting stuck of the filler particles FL having a large particle diameter in the gap between the laminated body MCS and the wiring board 20 described in the sealing process. The semiconductor device 51 is different from the semiconductor device 1 illustrated in FIG. 4 in that the arrangement range of the adhesive material NCL1 has a planar size almost equal to that of the chip mount region 2p1.

When the tilt of the laminated body MCS in the second chip mounting process described in the above-described embodiment is not considered, it is only required that the gap between the laminated body MCS and the wiring board 20 is filled before the sealing process, and therefore, the planar size of the adhesive material NCL1 can be decreased. For example, in the example illustrated in FIG. 44, the outer edge part of the adhesive material NCL1 is arranged at a position closer to the outer edge part of the chip mount region 2p1 than the outer edge part of the chip mount region 2p2. Also, more than half of the region of the side surface 3c of the logic chip LC on the back surface 3b side is exposed from the adhesive material NCL1. Even in the structure as similar to the semiconductor device 51, as long as the gap between the laminated body MCS and the wiring board 20 is filled with the adhesive material NCL2 before the sealing process, the concern about the formation of the air bubble VD in the gap between the laminated body MCS and the wiring board 20 or the concern about the getting stuck of the filler particles FL having a large diameter in the gap between the laminated body MCS and the wiring board 20 can be solved.

However, as described in the above-described embodiment, particularly when the insulator paste (NCP) is used as the adhesive material NCL2, the adhesive material NCL2 expands so as to follow the adhesive material NCL1. Therefore, in view of reliably filling the gap between the laminated body MCS and the wiring board 20 by controlling the arrangement range of the adhesive material NCL2, the outer edge part of the adhesive material NCL1 is preferably arranged at a position closer to the outer edge part of the chip mount region 2p2 than the outer edge part of the chip mount region 2p1 as illustrated in FIG. 4.

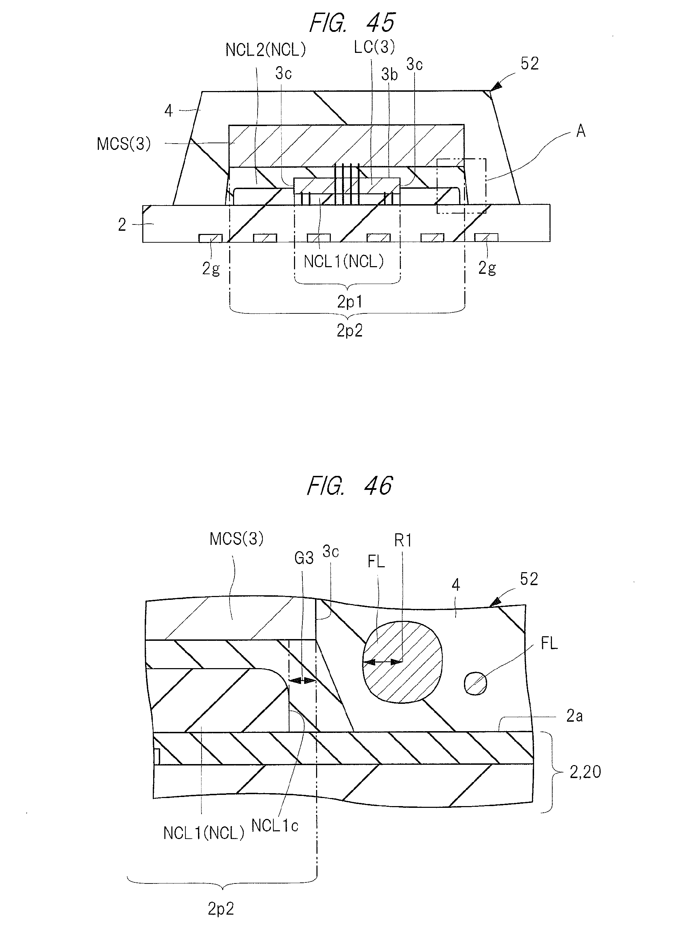

Also, as a structure for solving the concern about the getting stuck of the filler particles FL having a large particle diameter due to the adhesive material NCL1, the adhesive paste NCL1 is preferably arranged so as to cover most of the chip mount region 2p2 as seen in a semiconductor device 52 illustrated in FIG. 45 and FIG. 46. FIG. 45 is a cross-sectional view of a principal part illustrating general outlines of a modification example of the semiconductor device illustrated in FIG. 44. Also, FIG. 46 is an enlarged cross-sectional view of an A part of FIG. 45.

In the semiconductor device 52 illustrated in FIG. 45 and FIG. 46, most of the chip mount region 2p2 is covered with the adhesive material NCL1. More specifically, as illustrated in FIG. 46, a width (a gap G3 illustrated in FIG. 46) of a portion of the chip mount region 2p2 not covered with the adhesive material NCL1 is smaller than a radius R1 of a filler particle FL having the largest volume (for example, filler particle having a diameter larger than the gap G2 between the wiring board 20 and the laminated body MCS) of the plurality of filler particles FL. In other words, the gap (a separated distance in a planar view or a space) G3 between the side surfaces 3c of the laminated body MCS and the outer edge part NCL1c of the adhesive material NCL1 is smaller than the radius R1 of the filler particle FL having the largest volume of the plurality of filler particles FL.

The semiconductor device 52 is preferable in that the getting stuck of the filler particles FL due to the adhesive material NCL1 can be prevented or suppressed even if the outer edge part NCL1c of the adhesive material NCL1 is not covered with the adhesive material NCL2 in the second chip mounting process. Also, when the outer edge part NCL1c of the adhesive material NCL1 is covered with the adhesive material NCL2 in the above-described second chip mounting process, the gap between the laminated body MCS and the wiring board 20 can be reliably filled.

Also, the semiconductor device 52 is preferable in easy control of the expansion of the adhesive material NCL2 since a part of the chip mount region 2p2 is not covered with the adhesive material NCL1.

### <Third Modification Example>

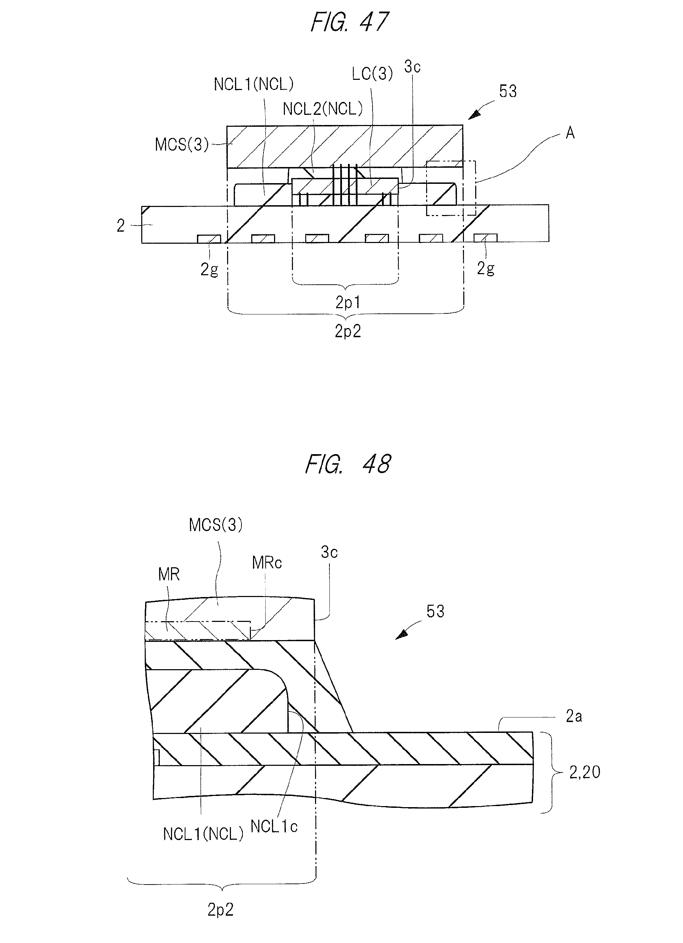

Also, such a structure as a semiconductor device 53 illustrated in FIG. 47 and FIG. 48 is preferable in view of suppressing the application of the stress on the memory circuit formed on the laminated body MCS due to the contact between the outer edge part of the adhesive material NCL1 and the front surface 3a of the laminated body MCS caused by the tilt of the laminated body MCS in the second chip mounting process described above. FIG. 47 is a cross-sectional view of a principal part illustrating general outlines of another modification example of the semiconductor device illustrated in FIG. 4. Also, FIG. 48 is an enlarged cross-sectional view of an A part of FIG. 47.

In the semiconductor device 53 illustrated in FIG. 47 and FIG. 48, each side surface NCL1c of the adhesive material NCL1 is arranged between an outer edge part (side closest to the side surface 3c) MRc of the memory region MR provided in the laminated body MCS and the side surface 3c of the laminated body MCS.

The laminated body MCS has, for example, the plurality of memory chips MC1, MC2, MC3, and MC4 as illustrated in FIG. 4, and the memory region MR is formed in each of the memory chips MC1, MC2, MC3, and MC4. Note that the planar layout of the memory region MR is as described above by using FIG. 6, and therefore, the repetitive explanation is omitted.

In the semiconductor device 53 illustrated in FIG. 47 and FIG. 48, the outer edge part MRc of the memory region MR provided in the laminated body MCS is arranged inside the outer edge part NCL1c of the adhesive material NCL1 when seen in a plan view. Therefore, even if the laminated body MCS is tilted in the second chip mounting process described above, the memory region MR and the adhesive material NCL1 are difficult to be in contact with each other. Therefore, the semiconductor device 53 is preferable in that application of the stress on the memory region MR in the second chip mounting process can be prevented or suppressed.

### <Fourth Modification Example>

Also, the semiconductor devices 50, 51, and 52 and the semiconductor device 53 are the so-called LGA-type semiconductor devices in which the solder balls 5 illustrated in FIG. 4 are not bonded thereto and the plurality of lands 2g are exposed as external terminals. In this case, the ball bonding process described in the above-described embodiment can be eliminated.

### <Fifth Modification Example>

Furthermore, the semiconductor devices 50, 51, and 52 and the semiconductor device 53 can be manufactured by, for example, laminating the plurality of semiconductor chips 3 on the wiring board 2 corresponding to one semiconductor device. In this case, the singulation process described in the above-described embodiment can be eliminated.

### <Sixth Modification Example>

Still further, for example, in the above-described embodiment, the aspect of the mounting of the laminated body MCS having the lamination of the plurality of memory chips MC1, MC2, MC3, and MC4 on the back surface 3b of the logic chip LC has been described. However, the number of semiconductor chips 3 to be laminated on the upper stage is not limited, and, for example, may be one. Also, even if the plurality of semiconductor chips 3 are laminated on the back surface 3b of the logic chip LC, the plurality of semiconductor chips 3 can be sequentially laminated through the adhesive materials NCL1, NCL2, NCL3, NCL4, and NCL5 as seen in, for example, a semiconductor device 55 illustrated in FIG. 59 by repeating the procedures from the second adhesive-material arranging process to the second chip mounting process illustrated in FIG. 11. In the case of the semiconductor device 55, it takes time for the assembling process since the semiconductor chips 3 are sequentially laminated. However, the plurality of semiconductor chips 3 can be laminated by the flip-chip connection method without using the sealing body 6 illustrated in FIG. 4.

### <Seventh Modification Example>

Still further, for example, in the above-described embodiment and modification examples, the aspect of the arrangement of the adhesive material NCL1 in a region equal to the chip mount region 2p2 or a region narrower than the chip mount region 2p2 has been described. However, as a modification example, the adhesive material NCL1 can be arranged in a region wider than the chip mount region 2p2. In other words, the planar size of the adhesive material NCL1 can be larger than the planar size of the laminated body MCS. In this case, since the adhesive material NCL2 can be bonded to the side surfaces 3c of the laminated body MCS in the second chip mounting process, a fillet is easy to be formed. As a result, the adhesive strength between the laminated body MCS and the adhesive material NCL2 can be improved.

### <Eighth Modification Example>

Still further, combination of the modification examples can be applied within a scope of the concept of the technical idea described in the above-described embodiments.

In addition, a part of the contents described in the embodiments is described below.
(1) A semiconductor device including: a wiring board; a first semiconductor chip; and a second semiconductor chip. The wiring board has: a first surface; a plurality of bonding leads formed on the first surface; a second surface opposite to the first surface; and a plurality of lands formed on the second surface and electrically connected with the plurality of bonding leads, respectively. The first semiconductor chip has: a first front surface; a plurality of first front-surface electrodes formed on the first front surface; a first back surface opposite to the first front surface; a plurality of first back-surface electrodes formed on the first back surface; and a plurality of through electrodes each formed so as to penetrate from either one of the first front surface and the first back surface toward the other and electrically connecting the plurality of first front-surface electrodes with the plurality of first back-surface electrodes, and the first semiconductor chip is mounted on the first surface of the wiring board via a first adhesive material such that the first front surface faces the first surface of the wiring board. The second semiconductor chip has: a second front surface; a plurality of second front-surface electrodes formed on the second front surface; a plurality of protruding electrodes electrically connected with the plurality of second front-surface electrodes, respectively; and a second back surface opposite to the second front surface, and the second semiconductor chip is mounted on the first semiconductor chip via a second adhesive material such that the second front surface of the second semiconductor chip faces the first back surface of the first semiconductor chip. The plurality of first front-surface electrodes and the plurality of bonding leads are electrically connected with each other, the plurality of second front-surface electrodes and the plurality of first back-surface electrodes are electrically connected with each other via the plurality of protruding electrodes, the second semiconductor chip has a planar size larger than a planar size of the first semiconductor chip, the second semiconductor chip includes the first chip mount part, and is mounted on a second chip mount part larger in a planar size than the first chip mount part, and an outer edge part of the first adhesive material is arranged at a position closer to an outer edge part of the second chip mount part than an outer edge part of the first chip mount part.

## Claims

1. A method of manufacturing a semiconductor device comprising the steps of:
(a) providing a wiring board having a first surface, a plurality of bonding leads formed on the first surface, a second surface opposite to the first surface, and a plurality of lands formed on the second surface and electrically connected with the plurality of bonding leads, respectively;
(b) arranging a first adhesive material on the first surface of the wiring board;
(c) after the step of (b), mounting a first semiconductor chip on the first surface of the wiring board via the first adhesive material such that a first front surface of the first semiconductor chip faces the first surface of the wiring board, and electrically connecting the plurality of bonding leads with a plurality of first front-surface electrodes, respectively, the first semiconductor chip having the first front surface, the plurality of first front-surface electrodes formed on the first front surface, a first back surface opposite to the first front surface, a plurality of first back-surface electrodes formed on the first back surface, and a plurality of through electrodes each formed so as to penetrate from either one of the first front surface and the first back surface toward the other and electrically connecting the plurality of first front-surface electrodes with the plurality of first back-surface electrodes, respectively;
(d) after the step of (c), arranging a second adhesive material on the first back surface of the first semiconductor chip and on a surface of the first adhesive material exposed from the first semiconductor chip;
(e) after the step of (d), mounting a second semiconductor chip on the first semiconductor chip via the second adhesive material such that a second front surface of the second semiconductor chip faces the first back surface of the first semiconductor chip, and electrically connecting the plurality of first back-surface electrodes with the plurality of second front-surface electrodes, respectively, the second semiconductor chip having the second front surface, the plurality of second front-surface electrodes formed on the second front surface, and a second back surface opposite to the second front surface; and
(f) after the step of (e), sealing the first surface of the wiring board, the first semiconductor chip, and the second semiconductor chip with resin,
wherein the second semiconductor chip has a planar size larger than a planar size of the first semiconductor chip, and,
wherein, after the step of (e) and before the step of (f), a space between the first surface of the wiring board and a portion of the second semiconductor chip not overlapping the first semiconductor chip is filled with the first and second adhesive materials.

2. The method of manufacturing the semiconductor device according to claim 1,
wherein, in the step of (f), the first surface of the wiring board, the first semiconductor chip, and the second semiconductor chip are sealed by arranging the wiring board in a forming mold and supplying the resin into the forming mold, and the resin is molded by the forming mold.

3. The method of manufacturing the semiconductor device according to claim 2,
wherein the first semiconductor chip mounted in the step of (c) has a thickness thinner than a thickness of the second semiconductor chip mounted in the step of (e).

4. The method of manufacturing the semiconductor device according to claim 1,
wherein, in the step of (e), the second semiconductor chip is mounted on a second chip mount part larger in a planar size than a first chip mount part where the first semiconductor chip is mounted, and,
wherein, in the step of (b), an outer edge part of the first adhesive material is arranged at a position closer to an outer edge part of the second chip mount part than an outer edge part of the first chip mount part.

5. The method of manufacturing the semiconductor device according to claim 1,
wherein, in the step of (f), a plurality of filler particles are contained in the resin for sealing the first surface of the wiring board, the first semiconductor chip, and the second semiconductor chip.

6. The method of manufacturing the semiconductor device according to claim 5,
wherein filler particles having a particle diameter larger than a separated distance between the second semiconductor chip and the first surface of the wiring board are contained in the plurality of filler particles.

7. The method of manufacturing the semiconductor device according to claim 1,
wherein, in the step of (e), a plurality of the second semiconductor chips are laminated on the first semiconductor chip, and
wherein, a space between the plurality of second semiconductor chips is sealed with a sealing body different from the sealing body.

8. The method of manufacturing the semiconductor device according to claim 7,
wherein, in the step of (f), the resin for sealing the first surface of the wiring board and the first semiconductor chip has a viscosity higher than a viscosity of the sealing body for sealing the space between the plurality of second semiconductor chips.

9. The method of manufacturing the semiconductor device according to claim 1,
wherein the first adhesive material arranged on the first chip mount part of the first surface of the wiring board is a film-shaped adhesive material.

10. The method of manufacturing the semiconductor device according to claim 1,
wherein, in the step of (d), the second adhesive material is arranged by coating the first back surface of the first semiconductor chip and the surface of the first adhesive material exposed from the first semiconductor chip with the second adhesive material of a paste type.

11. The method of manufacturing the semiconductor device according to claim 1,
wherein, in the step of (c), more than half of a side surface of the first semiconductor chip on the front surface side of the first semiconductor chip is covered with the first adhesive material.

12. A method of manufacturing a semiconductor device comprising the steps of:
(a) providing a wiring board having a first surface, a plurality of bonding leads formed on the first surface, a second surface opposite to the first surface, and a plurality of lands formed on the second surface and electrically connected with the plurality of bonding leads, respectively;
(b) arranging a first adhesive material on the first surface of the wiring board;
(c) after the step of (b), mounting a first semiconductor chip on the first surface of the wiring board via the first adhesive material such that a first front surface of the first semiconductor chip faces the first surface of the wiring board, and electrically connecting the plurality of bonding leads with a plurality of first front-surface electrodes, the first semiconductor chip having the first front surface, the plurality of first front-surface electrodes formed on the first front surface, a plurality of first circuits formed on the first front surface side and electrically connected with the plurality of first front-surface electrodes, respectively, a first back surface opposite to the first front surface, a plurality of first back-surface electrodes formed on the first back surface, and a plurality of through electrodes each formed so as to penetrate from either one of the first front surface and the first back surface toward the other and electrically connecting the plurality of first front-surface electrodes with the plurality of first back-surface electrodes, respectively;
(d) after the step of (c), arranging a second adhesive material on the first back surface of the first semiconductor chip and on a surface of the first adhesive material exposed from the first semiconductor chip;
(e) after the step of (d), mounting a second semiconductor chip on the first semiconductor chip via the second adhesive material such that a second front surface of the second semiconductor chip faces the first back surface of the first semiconductor chip, and electrically connecting the plurality of first back-surface electrodes with a plurality of second front-surface electrodes, respectively, the second semiconductor chip having the second front surface, the plurality of second front-surface electrodes formed on the second front surface, a plurality of second circuits formed on the second front surface side and electrically connected with the plurality of second front-surface electrodes, respectively, and a second back surface opposite to the second front surface; and
(f) after the step of (e), sealing the first surface of the wiring board, the first semiconductor chip, and the second semiconductor chip with resin,
wherein the plurality of second circuits include a storage circuit which stores data communicated with the first semiconductor chip via a plurality of first protruding electrodes provided between the first semiconductor chip and the second semiconductor chip,
wherein the plurality of first circuits include a control circuit which controls operation of the storage circuit of the second semiconductor chip via a plurality of second protruding electrodes provided between the first semiconductor chip and the second semiconductor chip,
wherein the second semiconductor chip has a planar size larger than a planar size of the first semiconductor chip, and,
wherein, after the step of (e) and before the step of (f), a space between the first surface of the wiring board and a portion of the second semiconductor chip not overlapping the first semiconductor chip is filled with the first and second adhesive materials.

13. A method of manufacturing a semiconductor device comprising the steps of:
(a) providing a wiring board having a first surface, a plurality of bonding leads formed on the first surface, a second surface opposite to the first surface, and a plurality of lands formed on the second surface and electrically connected with the plurality of bonding leads, respectively;
(b) arranging a first adhesive material on a first chip mount part of the first surface of the wiring board;
(c) after the step of (b), mounting a first semiconductor chip on the first chip mount part of the wiring board such that a first front surface of the first semiconductor chip faces the first surface of the wiring board, and electrically connecting the plurality of bonding leads with a plurality of first front-surface electrodes, respectively, the first semiconductor chip having the first front surface, the plurality of first front-surface electrodes formed on the first front surface, a first back surface opposite to the first front surface, a plurality of first back-surface electrodes formed on the first back surface, and a plurality of through electrodes each formed so as to penetrate from either one of the first front surface and the first back surface toward the other and electrically connecting the plurality of first front-surface electrodes with the plurality of first back-surface electrodes, respectively;
(d) after the step of (c), arranging a second adhesive material on the first back surface of the first semiconductor chip; and
(e) after the step of (d), mounting a second semiconductor chip on the first semiconductor chip via the second adhesive material such that a second front surface of the second semiconductor chip faces the first back surface of the first semiconductor chip, and electrically connecting the plurality of first back-surface electrodes with the plurality of second front-surface electrodes, respectively, the second semiconductor chip having the second front surface, the plurality of second front-surface electrodes formed on the second front surface, a plurality of protruding electrodes electrically connected with the plurality of second front-surface electrodes, respectively, and a second back surface opposite to the second front surface,
wherein the second semiconductor chip has a planar size larger than a planar size of the first semiconductor chip,
wherein, in the step of (e), the second semiconductor chip is mounted on a second chip mount part including the first chip mount part and being larger in a planar size than the first chip mount part, and,
wherein, in the step of (b), an outer edge part of the first adhesive material is arranged at a position closer to an outer edge part of the second chip mount part than an outer edge part of the first chip mount part.

14. The method of manufacturing the semiconductor device according to claim 13,
wherein, in the step of (c), more than half of a side surface of the first semiconductor chip on the front surface side of the first semiconductor chip is covered with the first adhesive material.

15. The method of manufacturing the semiconductor device according to claim 13,
wherein, in the step of (b), the outer edge part of the first adhesive material is arranged between the outer edge part of the first chip mount part and the outer edge part of the second chip mount part.

16. The method of manufacturing the semiconductor device according to claim 13, comprising the step of:
after the step of (c) and before the step of (d), curing the first adhesive material.

17. The method of manufacturing the semiconductor device according to claim 13,
wherein, in the step of (b), the first adhesive material is arranged so as to entirely cover the second chip mount part.
